# EUROPEAN PATENT APPLICATION

(11) **EP 4 286 944 A1**
(43) Date of publication of application: **06.12.2023**
(21) Application number: 23176401.0
(22) Date of filing: 31.05.2023
(51) Int. Cl.: G03F 7/004, G03F 7/039

(54) **CHEMICALLY AMPLIFIED POSITIVE RESIST COMPOSITION AND RESIST PATTERN FORMING PROCESS**

(30) Priority: 01.06.2022 JP 2022089770
(71) Applicant: Shin-Etsu Chemical Co., Ltd., Tokyo (JP)
(72) Inventor: MASUNAGA, Keiichi, Joetsu-shi (JP); FUKUSHIMA, Masahiro, Joetsu-shi (JP); KOTAKE, Masaaki, Joetsu-shi (JP); WATANABE, Satoshi, Joetsu-shi (JP)
(74) Representative: Ter Meer Steinmeister & Partner

(57) **Abstract**

A chemically amplified positive resist composition is provided comprising (A) a quencher in the form of a sulfonium salt of carboxylic acid having a nitrogen-bearing heterocycle and (B) a base polymer containing a specific polymer which is decomposed under the action of acid to increase its solubility in alkaline developer. The resist composition exhibits a high resolution during pattern formation and forms a pattern with improved LER, fidelity and dose margin.

## Description

### TECHNICAL FIELD

This invention relates to a chemically amplified positive resist composition and a resist pattern forming process using the same.

### BACKGROUND ART

To meet the demand for higher integration density and operating speed of LSIs, the effort to reduce the pattern rule is in rapid progress. Acid-catalyzed chemically amplified resist compositions are most often used in forming resist patterns with a feature size of 0.2 µm or less. High-energy radiation such as UV, deep-UV or EB is used as the light source for exposure of these resist compositions. In particular, while EB lithography is utilized as the ultra-fine microfabrication technique, it is also indispensable in processing photomask blanks to form photomasks for use in semiconductor device fabrication.

Polymers comprising a major proportion of aromatic structure having an acidic side chain, for example, polyhydroxystyrene are useful in resist materials for the KrF excimer laser lithography. These polymers are not used in resist materials for the ArF excimer laser lithography because they exhibit strong absorption at a wavelength of around 200 nm. These polymers, however, are expected to form useful resist materials for the EB and EUV lithography for forming patterns of smaller size than the processing limit of ArF excimer laser because they offer high etching resistance.

Often used as the base polymer in positive resist compositions for EB and EUV lithography is a polymer having an acidic functional group on phenol side chain masked with an acid-decomposable protective group (acid labile group). Upon exposure to high-energy radiation, the acid-decomposable protective group is deprotected by the catalysis of an acid generated from a photoacid generator so that the polymer may turn soluble in alkaline developer.

Typical of the acid-decomposable protective group are tertiary alkyl, tert-butoxycarbonyl, and acetal groups. The use of protective groups requiring a relatively low level of activation energy for deprotection such as acetal groups offers the advantage that a resist film having a high sensitivity is obtainable. However, if the diffusion of generated acid is not fully controlled, deprotection reaction can occur even in the unexposed region of the resist film, giving rise to problems like a lowering of line edge roughness (LER) and degradation of critical dimension uniformity (CDU) of pattern line width.

One of the important applications of chemically amplified resist material resides in processing of photomask blanks. Some photomask blanks have a surface material that can have an impact on the pattern profile of the overlying chemically amplified resist film, for example, a layer of a chromium compound, typically chromium oxide deposited on a photomask substrate. For high resolution and profile retention after etching, it is one important performance factor to maintain the profile of a resist film pattern rectangular independent of the type of substrate. In recent years, the multibeam mask writing (MBMW) process is used in the processing of mask blanks to achieve further miniaturization. The resist used in the MBMW process is a low-sensitivity resist (or high-dose region) which is advantageous in roughness while a spotlight is brought to the optimization of the resist composition in the high-dose region.

Attempts were made to ameliorate resist sensitivity and pattern profile in a controlled way by properly selecting and combining components used in resist compositions and adjusting processing conditions. One outstanding problem is the diffusion of acid. Since acid diffusion has a significant impact on the sensitivity and resolution of a chemically amplified resist composition, many studies are made on the acid diffusion problem.

Patent Documents 1 and 2 describe photoacid generators capable of generating bulky acids like benzenesulfonic acid upon exposure, for thereby controlling acid diffusion and reducing roughness. Since these acid generators are still insufficient to control acid diffusion, it is desired to have an acid generator with more controlled diffusion.

Patent Document 3 proposes to control acid diffusion in a resist composition by binding an acid generator capable of generating a sulfonic acid upon light exposure to a base polymer. This approach of controlling acid diffusion by binding repeat units capable of generating acid upon exposure to a base polymer is effective in forming a pattern with reduced LER. However, a problem arises with respect to the solubility in organic solvent of the base polymer having bound therein repeat units capable of generating acid upon exposure, depending on the structure and proportion of the repeat units.

Patent Document 4 describes a resist composition comprising a polymer comprising repeat units having an acetal group and a sulfonium salt capable of generating an acid having a high acid strength such as fluoroalkanesulfonic acid. The composition forms a pattern with noticeable LER. This is because the acid strength of fluoroalkanesulfonic acid is too high for the deprotection of the acetal group requiring a relatively low level of activation energy for deprotection. Even if acid diffusion is controlled, deprotection reaction can be promoted in the unexposed region by a minor amount of acid that has diffused thereto. The same problem arises with sulfonium salts capable of generating benzenesulfonic acids as described in Patent Documents 1 and 2. It is thus desired to have an acid generator capable of generating an acid having an appropriate strength to deprotect the acetal group.

While the aforementioned methodology of generating a bulky acid is effective for suppressing acid diffusion, the methodology of tailoring a quencher (also known as acid diffusion inhibitor) is also considered effective. The quencher is, in fact, essential for controlling acid diffusion and improving resist performance. Studies have been made on the quencher while amines and weak acid onium salts have been generally used. The weak acid onium salts are exemplified in several patent documents. For example, Patent Document 5 describes that the addition of triphenylsulfonium acetate ensures to form a satisfactory resist pattern without T-top profile, a difference in line width between isolated and grouped patterns, and standing waves. Patent Document 6 describes the addition of ammonium salts of sulfonic acids or carboxylic acids for achieving improvements in sensitivity, resolution and exposure margin. Also, Patent Document 7 describes that a resist composition for KrF or EB lithography comprising a PAG capable of generating a fluorinated carboxylic acid is improved in resolution and process latitudes such as exposure margin and depth of focus. These compositions are used in the KrF, EB and F₂ lithography processes.

Patent Document 8 describes a positive photosensitive composition for ArF lithography comprising a carboxylic acid onium salt. This system is based on the mechanism that a salt exchange occurs between a weak acid onium salt and a strong acid (sulfonic acid) generated by a PAG upon exposure, to form a weak acid and a strong acid onium salt. That is, the strong acid (sulfonic acid) having high acidity is replaced by a weak acid (carboxylic acid), thereby suppressing acid-catalyzed decomposition reaction of acid labile group and reducing or controlling the distance of acid diffusion. The onium salt apparently functions as a quencher.

Patent Document 9 describes to use a sulfonium salt of carboxylic acid containing a nitrogen-bearing heterocycle as a quencher. No precise study has been made on its application to resist compositions with a low sensitivity of at least 50 µC (or high-dose region).

When patterns are formed using resist compositions comprising carboxylic acid onium salts or fluorocarboxylic acid onium salts as mentioned above, the levels of LER and resolution thus achieved are insufficient for the requirement of the recent technology where miniaturization is more advanced. It is desirable to have a quencher capable of reducing LER and improving resolution, pattern fidelity and dose margin.

### Citation List

Patent Document 1: JP-A 2009-053518
Patent Document 2: JP-A 2010-100604
Patent Document 3: JP-A 2011-022564
Patent Document 4: JP 5083528
Patent Document 5: JP 3955384 (USP 6479210)
Patent Document 6: JP-A H11-327143
Patent Document 7: JP 4231622 (USP 6485883)
Patent Document 8: JP 4226803 (USP 6492091)
Patent Document 9: JP 6512049 (US 2017075218)

### DISCLOSURE OF INVENTION

An object of the invention is to provide a chemically amplified positive resist composition which exhibits a high resolution during pattern formation and forms a pattern with improved LER, fidelity and dose margin, and a resist pattern forming process using the resist composition.

The inventors have found that when a sulfonium salt of carboxylic acid having a nitrogen-bearing heterocycle is added to a resist composition as a quencher, the resist composition exhibits a high resolution during pattern formation and forms a pattern of satisfactory profile with improved LER, fidelity and dose margin.

Accordingly, the invention provides a chemically amplified positive resist composition and resist pattern forming process, as defined below.
1. A chemically amplified positive resist composition comprising (A) a quencher containing a sulfonium salt having the formula (A1) and (B) a base polymer containing a polymer which is decomposed under the action of acid to increase its solubility in alkaline developer, the polymer comprising repeat units having the formula (B1), 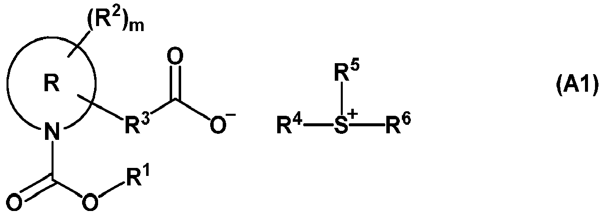 wherein m is an integer of 0 to 2,
   the circle R is a C₂-C₁₂ saturated heterocycle including the nitrogen atom in the formula which may contain an ether bond, ester bond, thioether bond or sulfonyl moiety,
   R¹ is an acid labile group,
   R² is halogen or a C₁-C₆ saturated hydrocarbyl group which may contain halogen,
   R³ is a single bond or a C₁-C₁₀ saturated hydrocarbylene group which may contain an ether bond, ester bond or thioether bond,
   R⁴, R⁵ and R⁶ are each independently halogen or a C₁-C₂₀ hydrocarbyl group which may contain a heteroatom, R⁴ and R⁵ may bond together to form a ring with the sulfur atom to which they are attached, 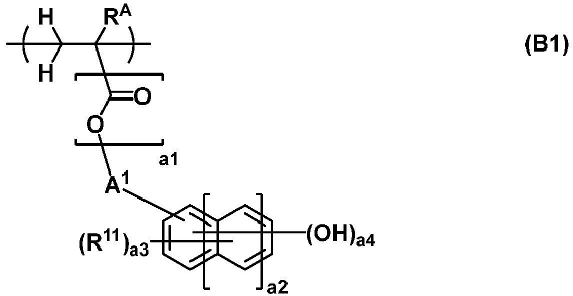 wherein a1 is 0 or 1, a2 is an integer of 0 to 2, a3 is an integer satisfying 0 ≤ a3 ≤ 5+2a2-a4, a4 is an integer of 1 to 3,
   R^{A} is hydrogen, fluorine, methyl or trifluoromethyl,
   R¹¹ is halogen, an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group, and
   A¹ is a single bond or C₁-C₁₀ saturated hydrocarbylene group in which any constituent -CH₂- may be replaced by -O-.
2. The positive resist composition of 1 wherein the polymer further comprises repeat units having the formula (B2-1): 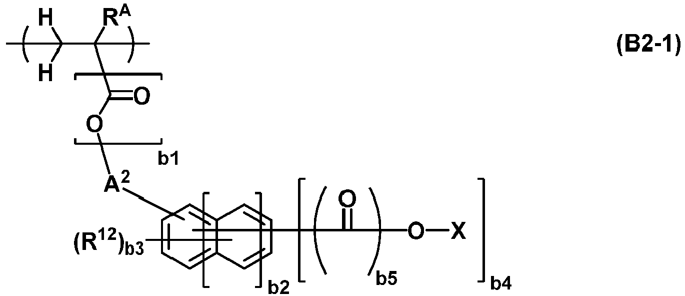 wherein R^{A} is hydrogen, fluorine, methyl or trifluoromethyl,
   b1 is 0 or 1, b2 is an integer of 0 to 2, b3 is an integer satisfying 0 ≤ b3 ≤ 5+2b2-b4, b4 is an integer of 1 to 3, b5 is 0 or 1,
   R¹² is halogen, an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group,
   A² is a single bond or C₁-C₁₀ saturated hydrocarbylene group in which any constituent -CH₂- may be replaced by -O-,
   X is an acid labile group when b4 is 1, and X is hydrogen or an acid labile group, at least one being an acid labile group, when b4 is 2 or 3.
3. The positive resist composition of 1 or 2 wherein the polymer further comprises repeat units having the formula (B2-2): 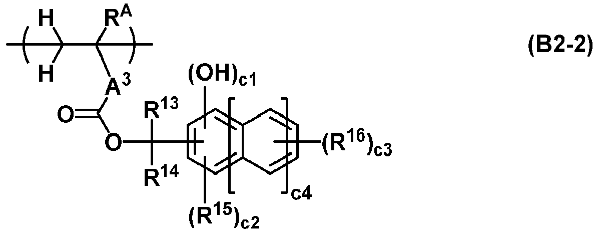 wherein c1 is an integer of 0 to 2, c2 is an integer of 0 to 2, c3 is an integer of 0 to 5, c4 is an integer of 0 to 2,
   R^{A} is hydrogen, fluorine, methyl or trifluoromethyl,
   A³ is a single bond, phenylene group, naphthylene group, or ^{∗}-C(=O)-O-A³¹-, A³¹ is a C₁-C₂₀ aliphatic hydrocarbylene group which may contain hydroxy, ether bond, ester bond or lactone ring, or phenylene or naphthylene group,
   R¹³ and R¹⁴ are each independently a C₁-C₁₀ hydrocarbyl group which may contain a heteroatom, R¹³ and R¹⁴ may bond together to form a ring with the carbon atom to which they are attached,
   R¹⁵ is each independently fluorine, C₁-C₅ fluorinated alkyl group or C₁-C₅ fluorinated alkoxy group, and
   R¹⁶ is each independently a C₁-C₁₀ hydrocarbyl group which may contain a heteroatom.
4. The positive resist composition of any one of 1 to 3 wherein the polymer further comprises repeat units of at least one type selected from repeat units having the formula (B3), repeat units having the formula (B4), and repeat units having the formula (B5): 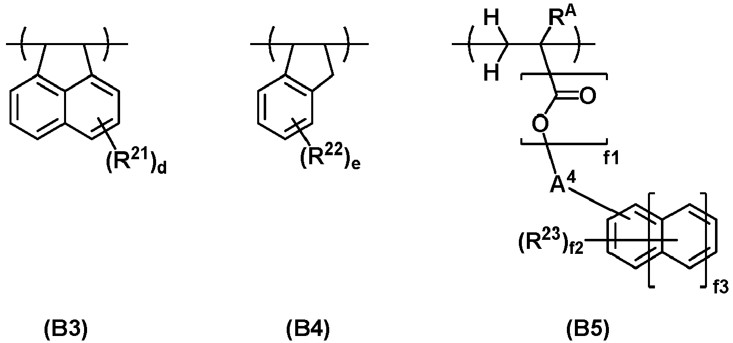 wherein d and e are each independently an integer of 0 to 4, f1 is 0 or 1, f2 is an integer of 0 to 5, and f3 is an integer of 0 to 2,
   R^{A} is hydrogen, fluorine, methyl or trifluoromethyl,
   R²¹ and R²² are each independently hydroxy, halogen, an optionally halogenated C₁-C₈ saturated hydrocarbyl group, optionally halogenated C₁-C₈ saturated hydrocarbyloxy group, or optionally halogenated C₂-C₈ saturated hydrocarbylcarbonyloxy group,
   R²³ is a C₁-C₂₀ saturated hydrocarbyl group, C₁-C₂₀ saturated hydrocarbyloxy group, C₂-C₂₀ saturated hydrocarbylcarbonyloxy group, C₂-C₂₀ saturated hydrocarbyloxyhydrocarbyl group, C₂-C₂₀ saturated hydrocarbylthiohydrocarbyl group, halogen, nitro group, cyano group, sulfinyl group, or sulfonyl group, and
   A⁴ is a single bond or C₁-C₁₀ saturated hydrocarbylene group in which any constituent -CH₂- may be replaced by -O-.
5. The positive resist composition of any one of 1 to 4 wherein the polymer further comprises repeat units of at least one type selected from repeat units having the formulae (B6) to (B13): 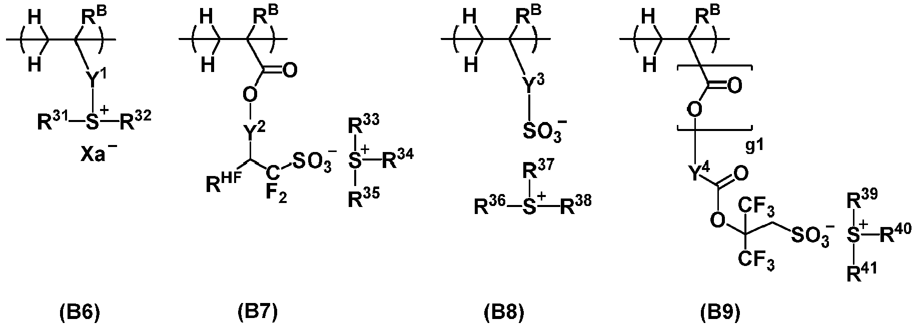 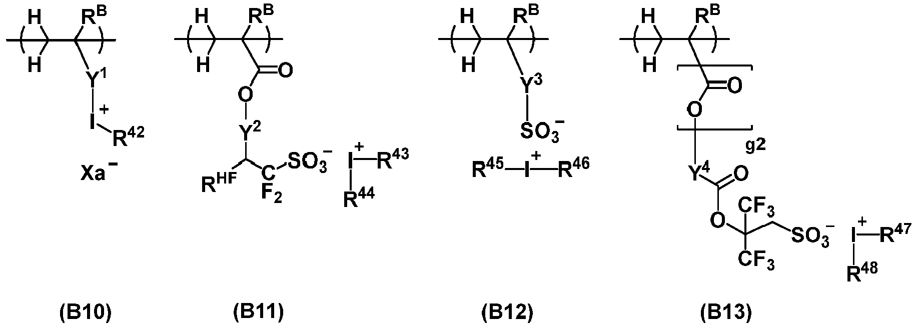 wherein R^{B} is each independently hydrogen or methyl,
   Y¹ is a single bond, a C₁-C₆ aliphatic hydrocarbylene group, phenylene group, naphthylene group or C₇-C₁₈ group obtained by combining the
      foregoing, -O-Y¹¹-, -C(=O)-O-Y¹¹-, or -C(=O)-NH-Y¹¹-, Y¹¹ is a C₁-C₆ aliphatic hydrocarbylene group, phenylene group, naphthylene group or C₇-C₁₈ group obtained by combining the foregoing, which may contain a carbonyl moiety, ester bond, ether bond or hydroxy moiety,
   Y² is a single bond or -Y²¹-C(=O)-O-, Y²¹ is a C₁-C₂₀ hydrocarbylene group which may contain a heteroatom,
   Y³ is a single bond, methylene, ethylene, phenylene, fluorinated phenylene, trifluoromethyl-substituted phenylene, -O-Y³¹-, -C(=O)-O-Y³¹-, or -C(=O)-NH-Y³¹-, Y³¹ is a C₁-C₆ aliphatic hydrocarbylene group, phenylene group, fluorinated phenylene group, trifluoromethyl-substituted phenylene group, or C₇-C₂₀ group obtained by combining the foregoing, which may contain a carbonyl moiety, ester bond, ether bond or hydroxy moiety,
   Y⁴ is a single bond or C₁-C₃₀ hydrocarbylene group which may contain a heteroatom, g1 and g2 are each independently 0 or 1, g1 and g2 are 0 when Y⁴ is a single bond,
   R³¹ to R⁴⁸ are each independently a C₁-C₂₀ hydrocarbyl group which may contain a heteroatom, R³¹ and R³² may bond together to form a ring with the sulfur atom to which they are attached, R³³ and R³⁴, R³⁶ and R³⁷, or R³⁹ and R⁴⁰ may bond together to form a ring with the sulfur atom to which they are attached,
   R^{HF} is hydrogen or trifluoromethyl, and
   Xa⁻ is a non-nucleophilic counter ion.
6. The positive resist composition of any one of 1 to 5 wherein repeat units having an aromatic ring structure account for at least 60 mol% of the overall repeat units of the polymer in the base polymer.
7. The positive resist composition of any one of 1 to 6, further comprising (C) a photoacid generator.
8. The positive resist composition of 7 wherein the photoacid generator has an anion having an acid strength (pKa) of -3.0 or larger.
9. The positive resist composition of 7 or 8 wherein the photoacid generator (C) and the quencher (A) are present in a weight ratio of less than 6/1.
10. The positive resist composition of any one of 1 to 9, further comprising (D) a fluorinated polymer comprising repeat units of at least one type selected from repeat units having the formula (D1), repeat units having the formula (D2), repeat units having the formula (D3) and repeat units having the formula (D5) and optionally repeat units of at least one type selected from repeat units having the formula (D5) and repeat units having the formula (D6): 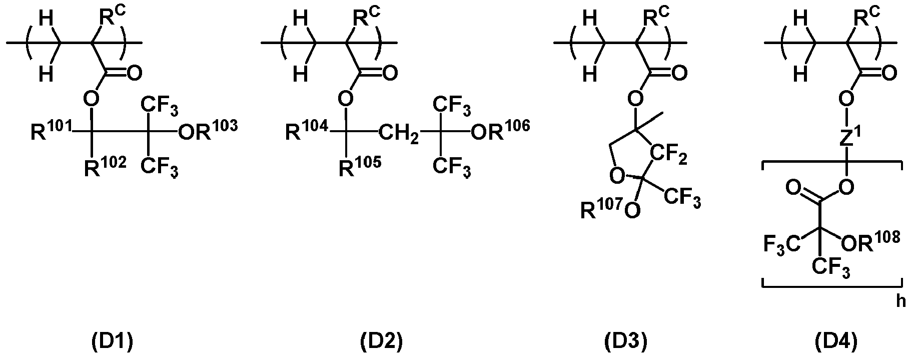 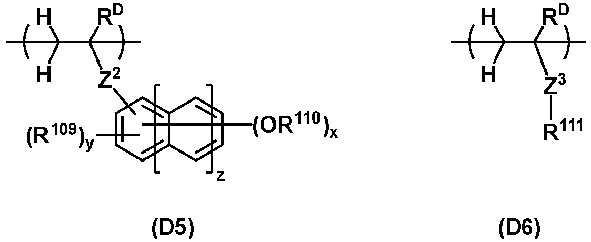 wherein R^{C} is each independently hydrogen, fluorine, methyl or trifluoromethyl,
   R^{D} is each independently hydrogen or methyl,
   R¹⁰¹, R¹⁰², R¹⁰⁴ and R¹⁰⁵ are each independently hydrogen or a C₁-C₁₀ saturated hydrocarbyl group,
   R¹⁰³, R¹⁰⁶, R¹⁰⁷ and R¹⁰⁸ are each independently hydrogen, a C₁-C₁₅ hydrocarbyl group, C₁-C₁₅ fluorinated hydrocarbyl group, or acid labile group, and when R¹⁰³, R¹⁰⁶, R¹⁰⁷ and R¹⁰⁸ each are a hydrocarbyl or fluorinated hydrocarbyl group, an ether bond or carbonyl moiety may intervene in a carbon-carbon bond,
   R¹⁰⁹ is hydrogen or a C₁-C₅ straight or branched hydrocarbyl group in which a heteroatom-containing moiety may intervene in a carbon-carbon bond,
   R¹¹⁰ is a C₁-C₅ straight or branched hydrocarbyl group in which a heteroatom-containing moiety may intervene in a carbon-carbon bond,
   R¹¹¹ is a C₁-C₂₀ saturated hydrocarbyl group in which at least one hydrogen is substituted by fluorine, and in which some constituent -CH₂- may be replaced by an ester bond or ether bond,
   x is an integer of 1 to 3, y is an integer satisfying 0 ≤ y ≤ 5+2z-x, z is 0 or 1, h is an integer of 1 to 3,
   Z¹ is a C₁-C₂₀ (h+1)-valent hydrocarbon group or C₁-C₂₀ (h+1)-valent fluorinated hydrocarbon group,
   Z² is a single bond, *-C(=O)-O- or *-C(=O)-NH-, * designates a point of attachment to the carbon atom in the backbone,
   Z³ is a single bond, -O-, ^{∗}-C(=O)=O-Z³¹-Z³²- or ^{∗}-C(=O)-NH-Z³¹-Z³²-, Z³¹ is a single bond or C₁-C₁₀ saturated hydrocarbylene group, Z³² is a single bond, ester bond, ether bond, or sulfonamide bond, and * designates a point of attachment to the carbon atom in the backbone.
11. The positive resist composition of any one of 1 to 10, further comprising (E) an organic solvent.
12. A resist pattern forming process comprising the steps of:
   applying the chemically amplified positive resist composition of any one of 1 to 11 onto a substrate to form a resist film thereon,
   exposing the resist film patternwise to high-energy radiation, and
   developing the exposed resist film in an alkaline developer.
13. The process of 12 wherein the high-energy radiation is EUV or EB.
14. The process of 12 or 13 wherein the substrate has the outermost surface of a material containing at least one element selected from chromium, silicon, tantalum, molybdenum, cobalt, nickel, tungsten, and tin.
15. The process of any one of 12 to 14 wherein the substrate is a mask blank of transmission or reflection type.
16. A mask blank of transmission or reflection type which is coated with the chemically amplified positive resist composition of any one of 1 to 11.

### ADVANTAGEOUS EFFECTS OF INVENTION

The chemically amplified positive resist composition has the advantage that the acid diffusion upon exposure for pattern formation is effectively controlled by the action of a sulfonium salt having formula (A1). When the resist composition is applied to form a resist film which is processed to form a pattern, the resist composition exhibits a very high resolution and a pattern with reduced LER, good fidelity and improved dose margin is available. By virtue of repeat units having formula (B1), when a resist film is formed on a substrate, the film has tight adhesion to the substrate as well as high solubility in alkaline developer.

The resist pattern forming process using the resist composition is successful in forming a pattern with high resolution, reduced LER, good fidelity, and improved dose margin. The process is advantageously applicable to the miniaturization technology, especially EUV and EB lithography.

### DESCRIPTION OF PREFERRED EMBODIMENTS

As used herein, the singular forms "a," "an" and "the" include plural referents unless the context clearly dictates otherwise. "Optional" or "optionally" means that the subsequently described event or circumstances may or may not occur, and that description includes instances where the event or circumstance occurs and instances where it does not. The notation (Cn-Cm) means a group containing from n to m carbon atoms per group. In chemical formulae, the broken line denotes a valence bond. The terms "group" and "moiety" are interchangeable.

The abbreviations and acronyms have the following meaning.
PAG: photoacid generator
Mw: weight average molecular weight
Mn: number average molecular weight
Mw/Mn: molecular weight distribution or dispersity
GPC: gel permeation chromatography
PEB: post-exposure baking
LER: line edge roughness
CDU: critical dimension uniformity

It is understood that for some structures represented by chemical formulae, there can exist enantiomers and diastereomers because of the presence of asymmetric carbon atoms. In such a case, a single formula collectively represents all such isomers. The isomers may be used alone or in admixture.

### Resist composition

One embodiment of the invention is a chemically amplified positive resist composition comprising (A) a quencher containing a sulfonium salt of carboxylic acid having a nitrogen-bearing heterocycle and (B) a base polymer containing a specific polymer.

### (A) Quencher

The quencher as component (A) contains a sulfonium salt having the formula (A1).

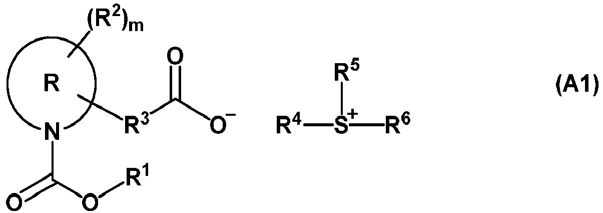

In formula (A1), m is an integer of 0 to 2.

The circle R is a C₂-C₁₂ saturated heterocycle including the nitrogen atom in the formula, which may contain at least one moiety selected from ether bond, ester bond, thioether bond, and sulfonyl moiety.

The nitrogen-bearing C₂-C₁₂ saturated heterocycle may be mono- or polycyclic. In the case of polycyclic, a fused ring or bridged ring is preferred. Examples of the heterocycle include aziridine, azetidine, pyrrolidine, piperidine, azepane, azocane, azaadamantane, nortropane, oxazolidine, thiazolidine, morpholine, thiomorpholine, octahydroindole, octahydroisoindole, decahydroquinoline, decahydroisoquinoline, 3-azatricyclo[7.3.1.0^{5,13}]tridecane, 1-azaspiro[4.4]nonane, 1-azaspiro[4.5]decane, and carbazole rings.

In formula (A1), R¹ is an acid labile group. Groups having the following formulae (AL-1) to (AL-19) are preferred as the acid labile group.

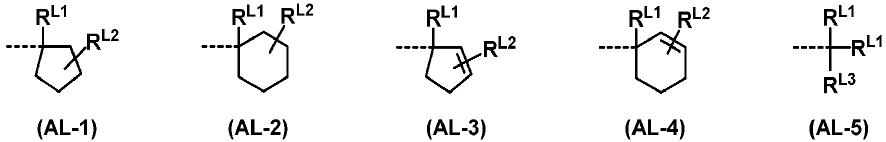

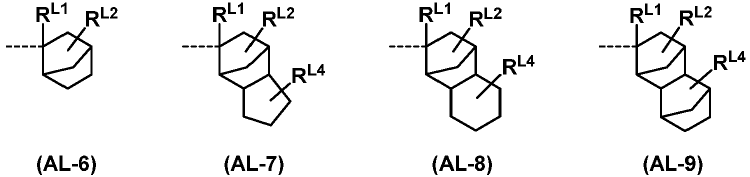

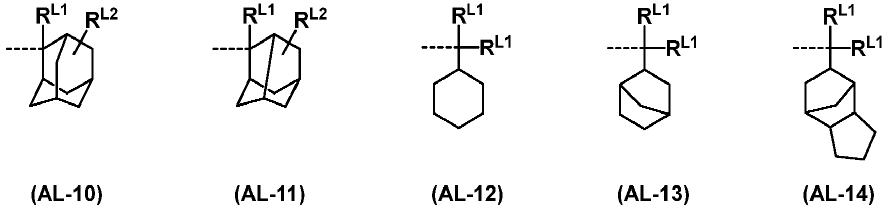

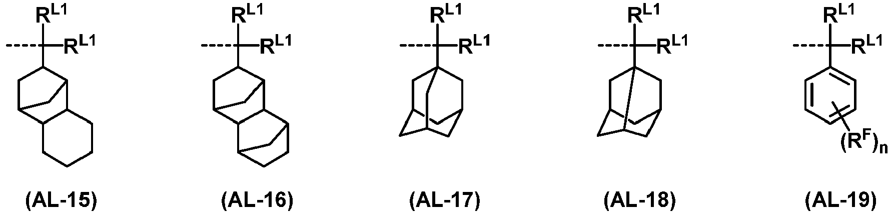

In formulae (AL-1) to (AL-19), R^{L1} is each independently a saturated hydrocarbyl group or C₆-C₂₀ aryl group. R^{L2} and R^{L4} are each independently hydrogen or a C₁-C₂₀ saturated hydrocarbyl group. R^{L3} is a C₆-C₂₀ aryl group. The saturated hydrocarbyl group may be straight, branched or cyclic. Typical of the aryl group is phenyl. R^{F} is fluorine or trifluoromethyl. The subscript n is an integer of 1 to 5.

It is preferred to select a tertiary hydrocarbyl group as the acid labile group because a pattern with reduced LER is obtained even when a resist film is formed to a thickness of 10 to 100 nm and exposed to a small size pattern of light so as to provide a line width of 45 nm or less. The tertiary hydrocarbyl group is preferably of 4 to 18 carbon atoms because a monomer for polymerization is collectable through distillation. The group attached to the tertiary carbon atom in the tertiary hydrocarbyl group is typically a C₁-C₁₅ saturated hydrocarbyl group which may contain an oxygen-containing functional group such as an ether bond or carbonyl group while the groups attached to the tertiary carbon atom may bond together to form a ring.

Examples of the group attached to the tertiary carbon atom include methyl, ethyl, propyl, adamantyl, norbornyl, tetrahydrofuran-2-yl, 7-oxanorbornan-2-yl, cyclopentyl, 2-tetrahydrofuryl, tricyclo[5.2.1.0^{2,6}]decyl, tetracyclo[4.4.0.1^{2,5}.1^{7,10}]dodecyl, and 3-oxo-1-cyclohexyl.

Examples of the tertiary hydrocarbyl group include tert-butyl, tert-pentyl, 1-ethyl-1-methylpropyl, 1,1-diethylpropyl, 1,1,2-trimethylpropyl, 1-adamantyl-1-methylethyl, 1-methyl-1-(2-norbornyl)ethyl, 1-methyl-1-(tetrahydrofuran-2-yl)ethyl, 1-methyl-1-(7-oxanorbornan-2-yl)ethyl, 1-methylcyclopentyl, 1-ethylcyclopentyl, 1-propylcyclopentyl, 1-isopropylcyclopentyl, 1-cyclopentylcyclopentyl, 1-cyclohexylcyclopentyl, 1-(2-tetrahydrofuryl)cyclopentyl, 1-(7-oxanorbornan-2-yl)cyclopentyl, 1-methylcyclohexyl, 1-ethylcyclohexyl, 1-isopropylcyclohexyl, 1-cyclopentylcyclohexyl, 1-cyclohexylcyclohexyl, 2-methyl-2-norbornyl, 2-ethyl-2-norbornyl, 8-methyl-8-tricyclo[5.2.1.0^{2,6}]decyl, 8-ethyl-8-tricyclo[5.2.1.0^{2,6}]decyl,3-methyl-3-tetracyclo[4.4.0.1^{2,5}.1^{7,10}]dodecyl, 3-ethyl-3-tetracyclo[4.4.0.1^{2,5}.1^{7,10}]dodecyl,3-isopropyl-3-tetracyclo[4.4.0.1^{2,5}.1^{7,10}]dodecyl, 2-methyl-2-adamantyl, 2-ethyl-2-adamantyl, 2-isopropyl-2-adamantyl, 1-methyl-3-oxo-1-cyclohexyl, 1-methyl-1-(tetrahydrofuran-2-yl)ethyl, 5-hydroxy-2-methyl-2-adamantyl, 5-hydroxy-2-ethyl-2-adamantyl, and 2-(4-fluorophenyl)-2-propyl.

Also, an acetal group having the formula (AL-20) is often used as the acid labile group. It is a good choice of acid labile group that ensures to form a pattern having a relatively rectangular interface between pattern features and the substrate.

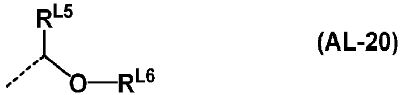

In formula (AL-20), R^{L5} is hydrogen or a C₁-C₁₀ saturated hydrocarbyl group. R^{L6} is a C₁-C₃₀ saturated hydrocarbyl group. The saturated hydrocarbyl group may be straight, branched or cyclic.

R^{L5} is selected in accordance with how to design the sensitivity of the labile group to acid. For example, hydrogen is selected for the design that the group having a relatively high stability is decomposed with a strong acid. A straight alkyl group is selected for the design that utilizes a relatively high reactivity to provide a high sensitivity relative to pH changes. Depending on a combination with an acid generator and a basic compound blended in a resist composition, a hydrocarbyl group in which the carbon attached to the acetal carbon is a secondary carbon atom is preferably selected as R^{L5} for the design that is substituted at an end with a relatively higher alkyl group as R^{L6} and experiences a large solubility change upon decomposition. Examples of the group R^{L5} attached to the acetal carbon via a secondary carbon atom include isopropyl, sec-butyl, cyclopentyl and cyclohexyl.

Of the acetal groups, those groups wherein R^{L6} is a C₇-C₃₀ polycyclic alkyl group are preferred in order to gain a higher resolution. When R^{L6} is a polycyclic alkyl group, it is preferred that the secondary carbon in the polycyclic structure form a bond with the acetal oxygen. A polymer relying on an attachment on the secondary carbon atom in the cyclic structure is stable as compared with an attachment on the tertiary carbon atom, ensuring that the resist composition is improved in shelf stability and not degraded in resolution. The polymer has a high glass transition temperature (Tg) as compared with the case wherein R^{L6} is attached on the primary carbon atom via a straight alkyl group of at least one carbon atom, so that the resist pattern after development may not undergo geometrical failure during bake.

Preferred examples of the group having formula (AL-20) are shown below, but not limited thereto. Herein R^{L5} is as defined above.

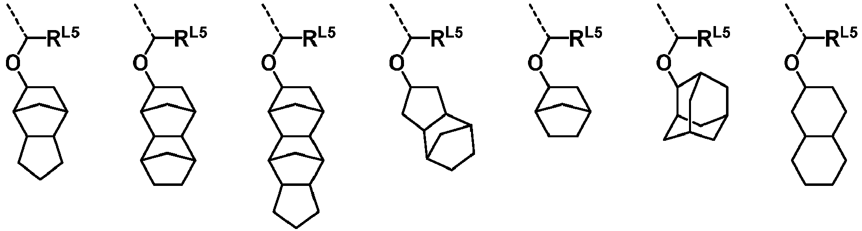

In formula (A1), R² is halogen or a C₁-C₆ saturated hydrocarbyl group which may contain halogen. Suitable halogen atoms include fluorine, chlorine, bromine and iodine. The C₁-C₆ saturated hydrocarbyl group may be straight, branched or cyclic. Examples thereof include C₁-C₆ alkyl groups such as methyl, ethyl, n-propyl, isopropyl, n-butyl, isobutyl, sec-butyl, tert-butyl, n-pentyl, and n-hexyl, C₃-C₆ cyclic saturated hydrocarbyl groups such as cyclopropyl, cyclobutyl, cyclopentyl, and cyclohexyl, and combinations thereof.

In formula (A1), R³ is a single bond or a C₁-C₁₀ saturated hydrocarbylene group which may contain an ether bond, ester bond or thioether bond. The C₁-C₁₀ saturated hydrocarbylene group may be straight, branched or cyclic and examples thereof include alkanediyl groups such as methylene, ethane-1,2-diyl, propane-1,3-diyl, butane-1,4-diyl, pentane-1,5-diyl, hexane-1,6-diyl, and structural isomers thereof; cyclic saturated hydrocarbylene groups such as cyclopropanediyl, cyclobutanediyl, cyclopentanediyl, and cyclohexanediyl; and combinations thereof.

Examples of the anion in the sulfonium salt having formula (A1) are shown below, but not limited thereto.

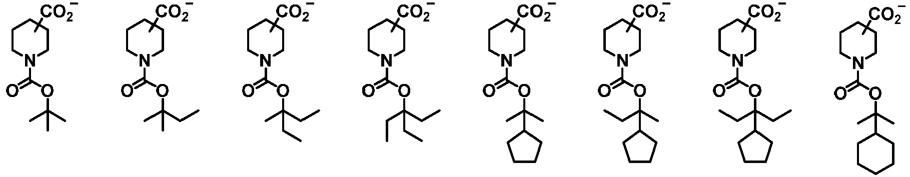

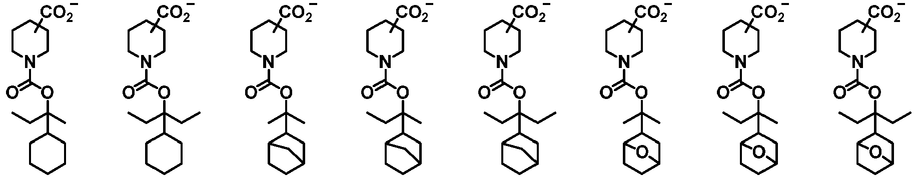

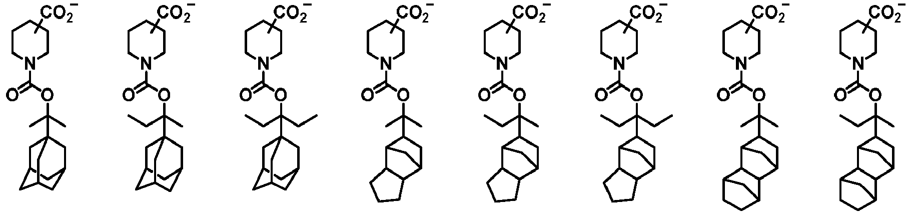

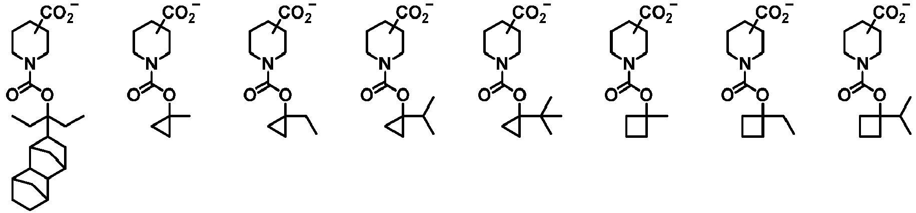

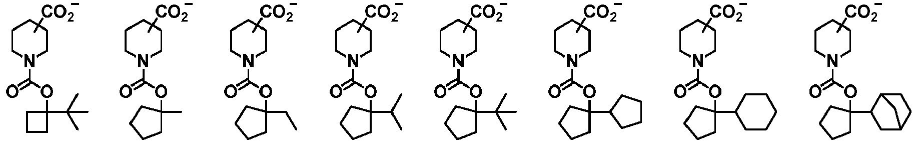

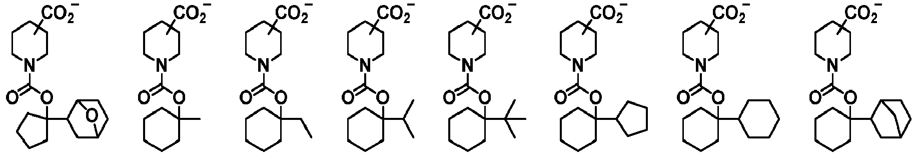

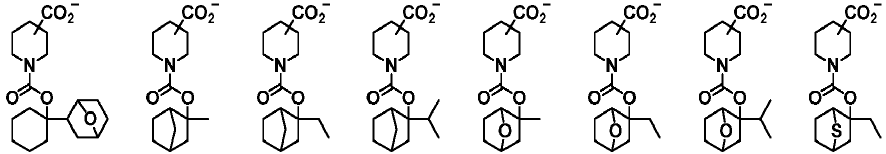

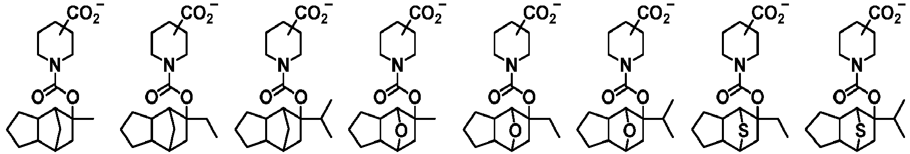

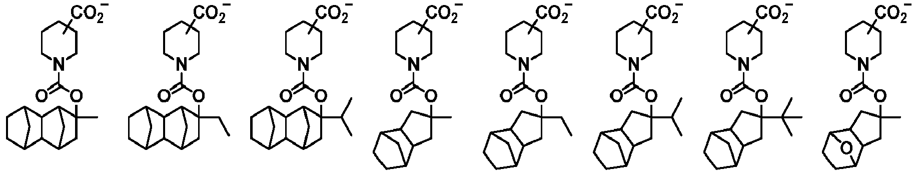

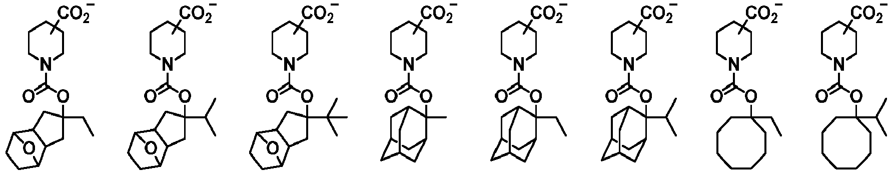

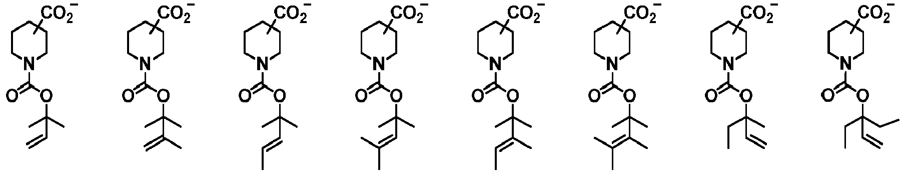

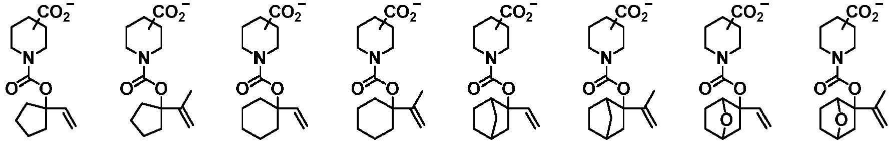

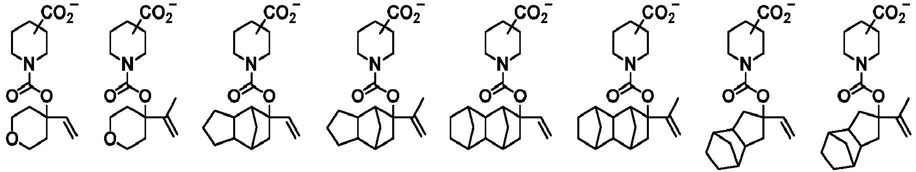

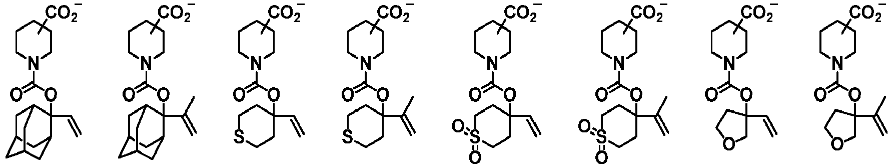

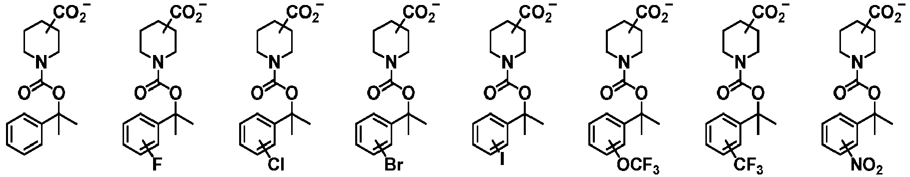

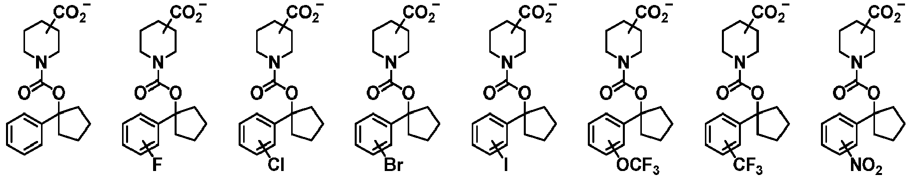

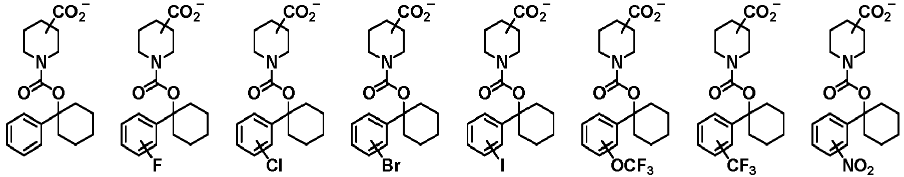

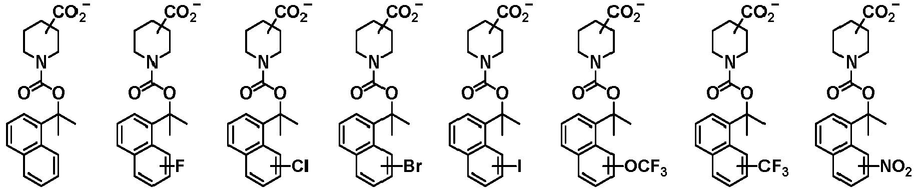

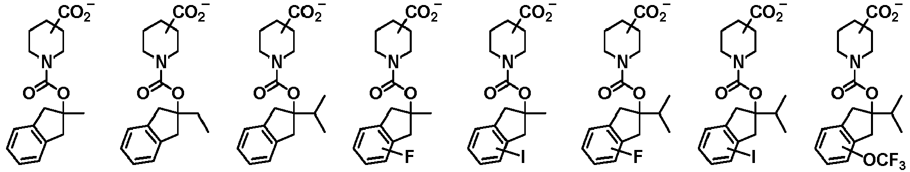

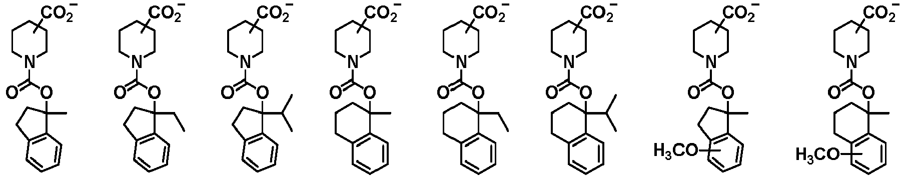

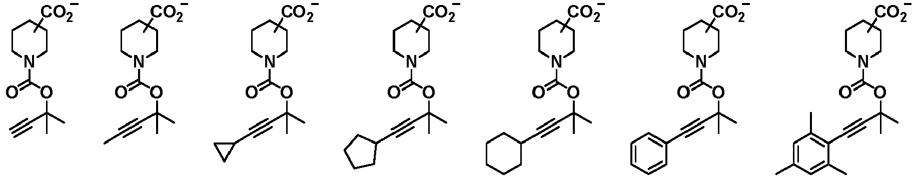

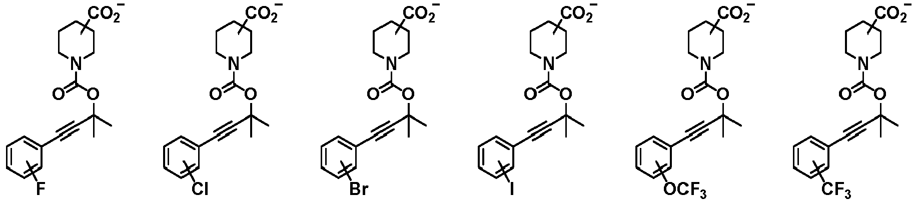

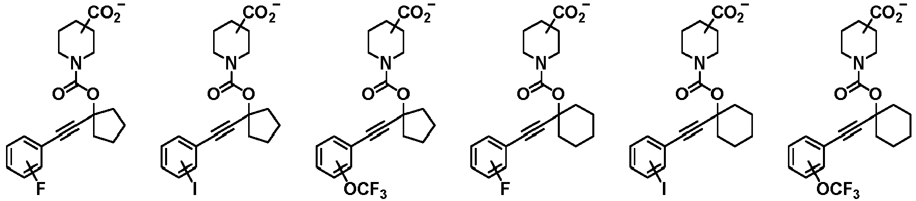

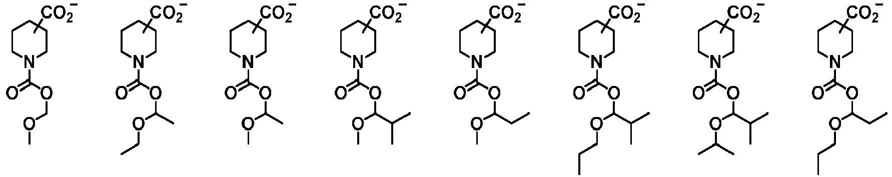

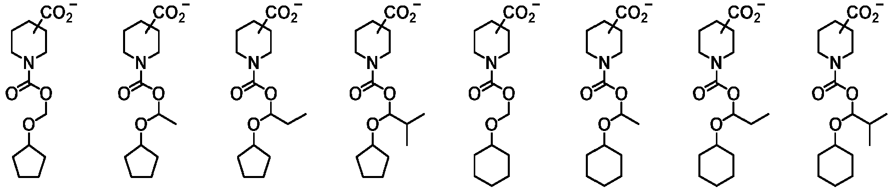

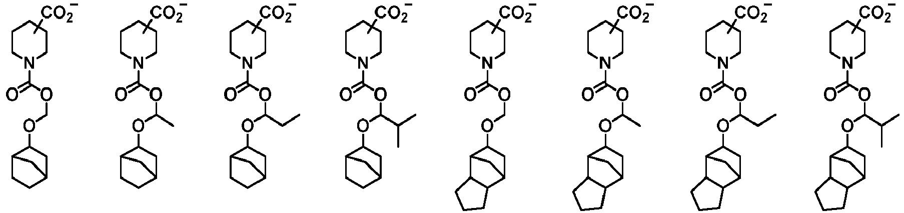

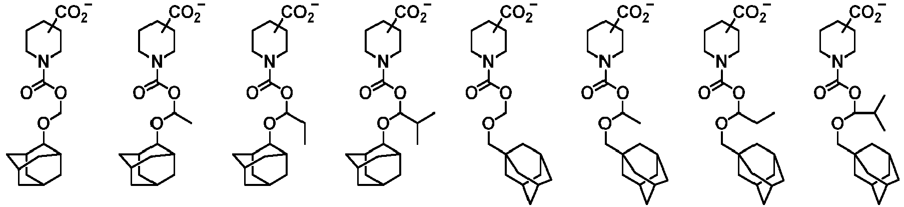

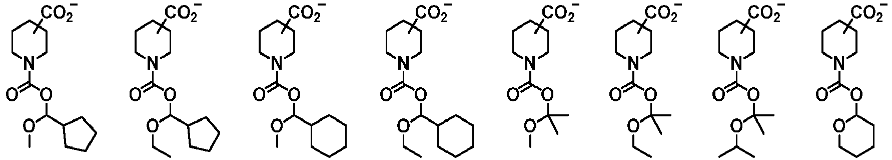

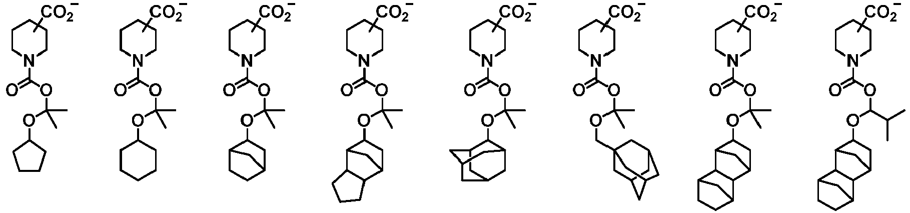

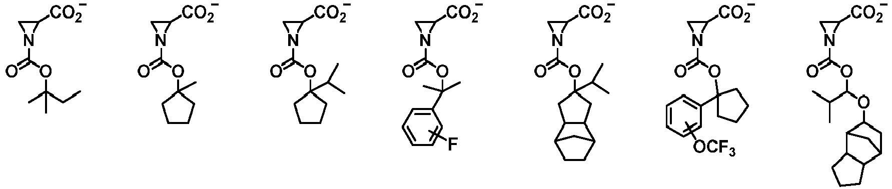

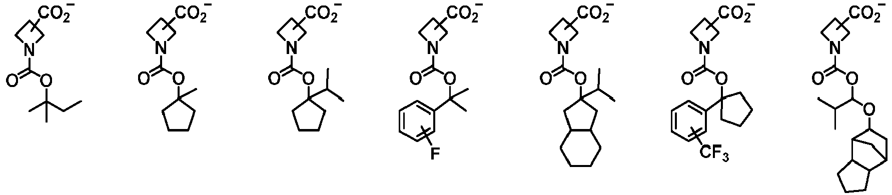

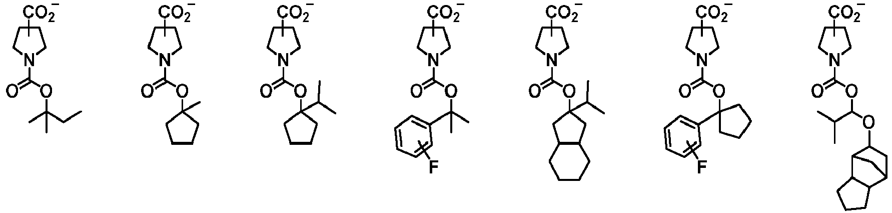

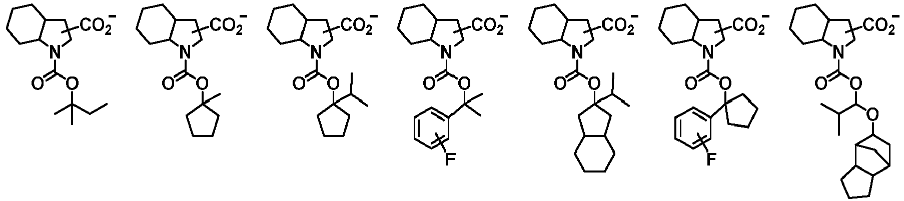

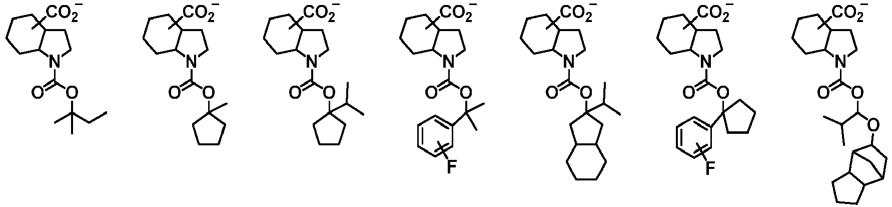

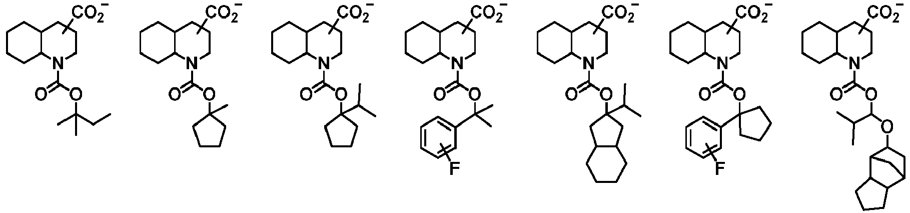

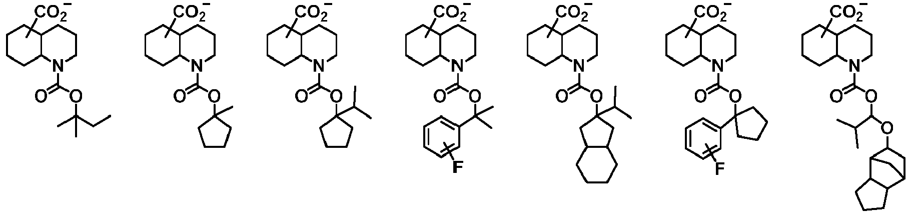

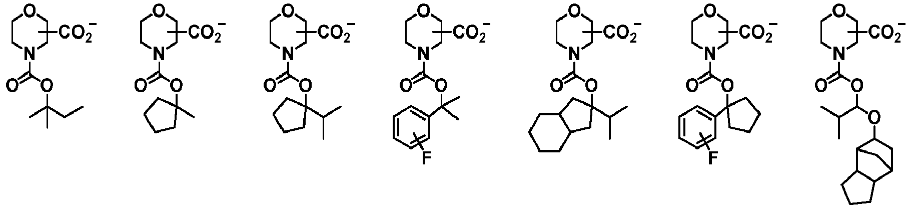

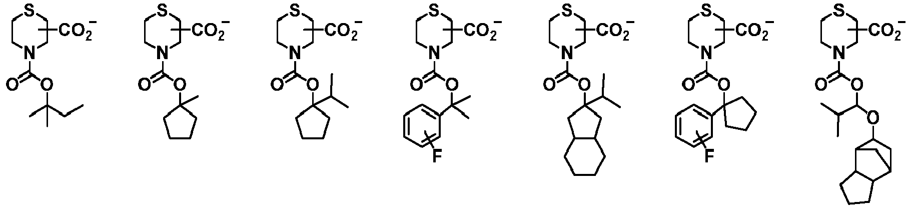

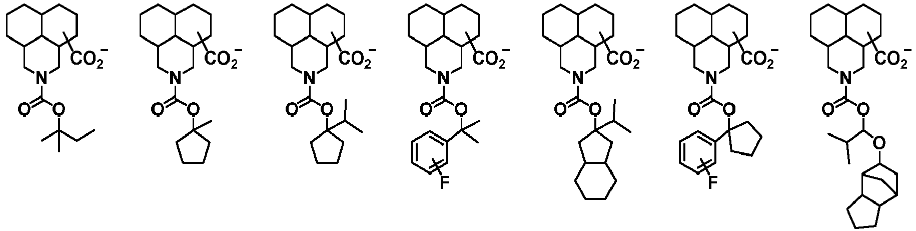

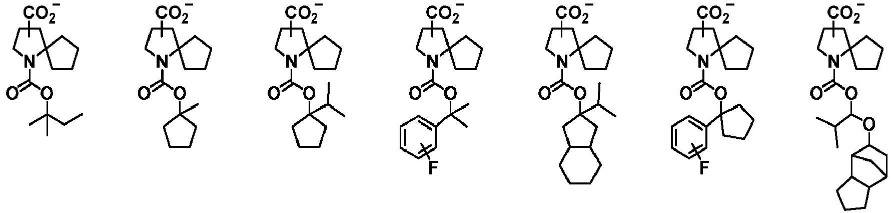

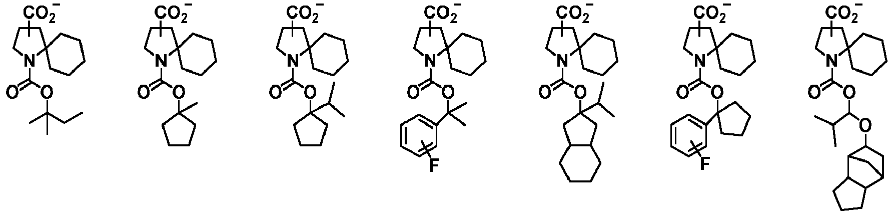

In formula (A1), R⁴, R⁵ and R⁶ are each independently halogen or a C₁-C₂₀ hydrocarbyl group which may contain a heteroatom. Suitable halogen atoms include fluorine, chlorine, bromine, and iodine. The C₁-C₂₀ hydrocarbyl group may be saturated or unsaturated and straight, branched or cyclic. Examples thereof include C₁-C₂₀ alkyl groups such as methyl, ethyl, n-propyl, isopropyl, n-butyl, isobutyl, sec-butyl, tert-butyl, n-pentyl, n-hexyl, n-octyl, n-nonyl, n-decyl, undecyl, dodecyl, tridecyl, tetradecyl, pentadecyl, heptadecyl, octadecyl, nonadecyl, and icosyl; C₃-C₂₀ cyclic saturated hydrocarbyl groups such as cyclopropyl, cyclopentyl, cyclohexyl, cyclopropylmethyl, 4-methylcyclohexyl, cyclohexylmethyl, norbornyl, and adamantyl; C₂-C₂₀ alkenyl groups such as vinyl, propenyl, butenyl and hexenyl; C₃-C₂₀ cyclic unsaturated aliphatic hydrocarbyl groups such as cyclohexenyl and norbornenyl; C₂-C₂₀ alkynyl groups such as ethynyl, propynyl and butynyl; C₆-C₂₀ aryl groups such as phenyl, methylphenyl, ethylphenyl, n-propylphenyl, isopropylphenyl, n-butylphenyl, isobutylphenyl, sec-butylphenyl, tert-butylphenyl, naphthyl, methylnaphthyl, ethylnaphthyl, n-propylnaphthyl, isopropylnaphthyl, n-butylnaphthyl, isobutylnaphthyl, sec-butylnaphthyl, and tert-butylnaphthyl; C₇-C₂₀ aralkyl groups such as benzyl and phenethyl; and combinations thereof. In the foregoing hydrocarbyl groups, some or all of the hydrogen atoms may be substituted by a moiety containing a heteroatom such as oxygen, sulfur, nitrogen or halogen, and some constituent -CH₂- may be replaced by a moiety containing a heteroatom such as oxygen, sulfur or nitrogen, so that the group may contain a hydroxy, fluorine, chlorine, bromine, iodine, cyano, nitro, carbonyl, ether bond, ester bond, sulfonic ester bond, carbonate bond, lactone ring, sultone ring, carboxylic anhydride (-C(=O)-O-C(=O)-) or haloalkyl moiety.

Also, R⁴ and R⁵ may bond together to form a ring with the sulfur atom to which they are attached. Examples of the ring are shown below.

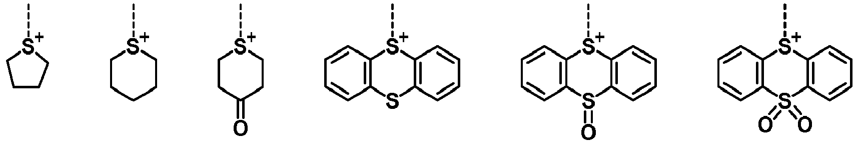

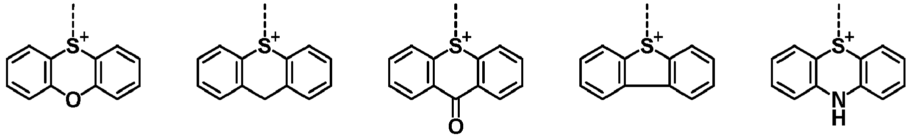

Examples of the cation in the sulfonium salt having formula (A1) are shown below, but not limited thereto.

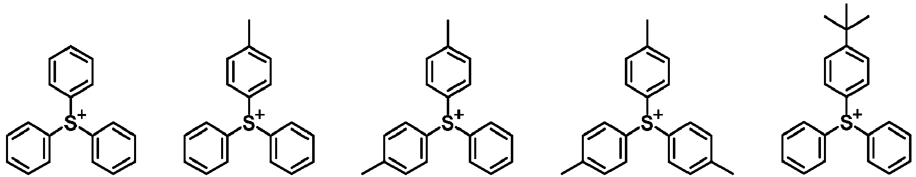

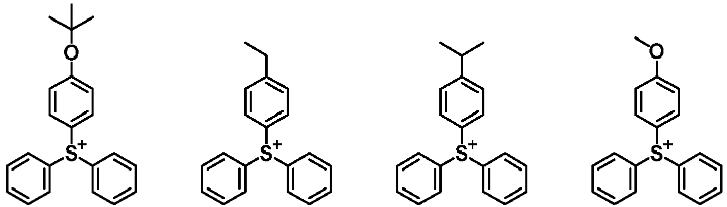

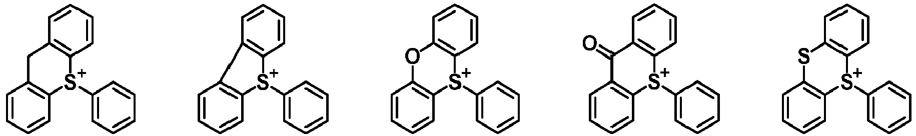

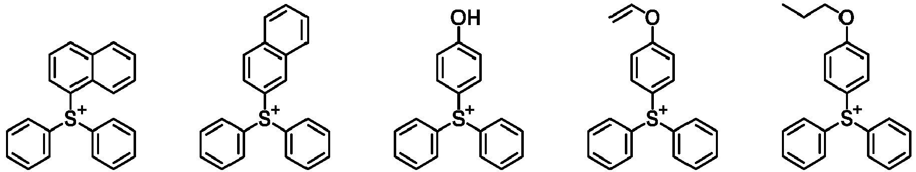

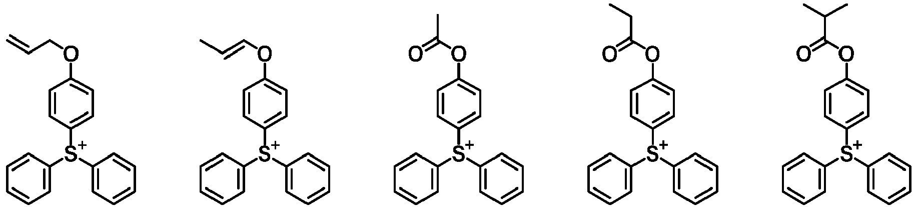

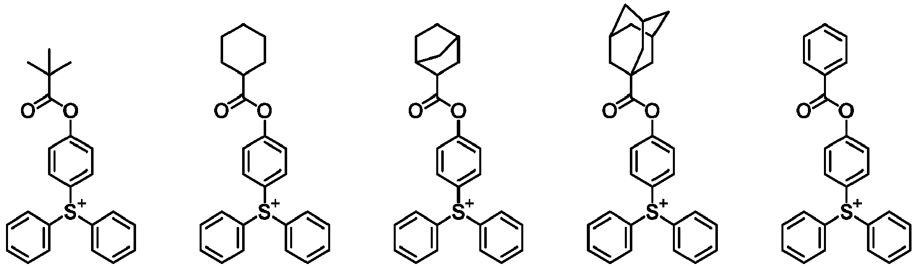

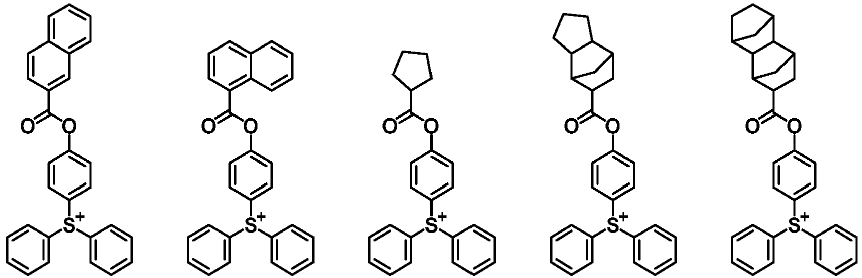

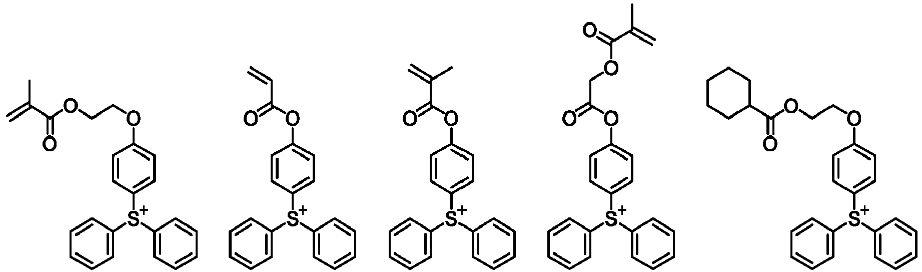

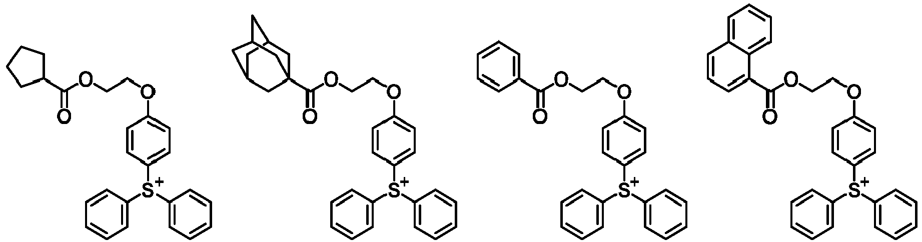

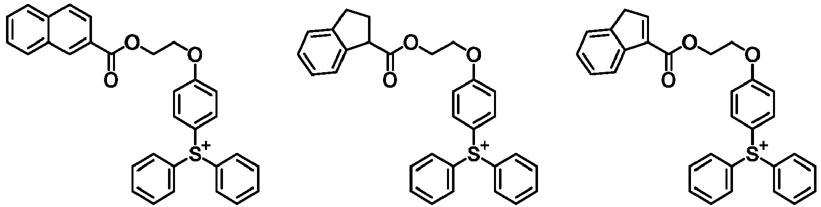

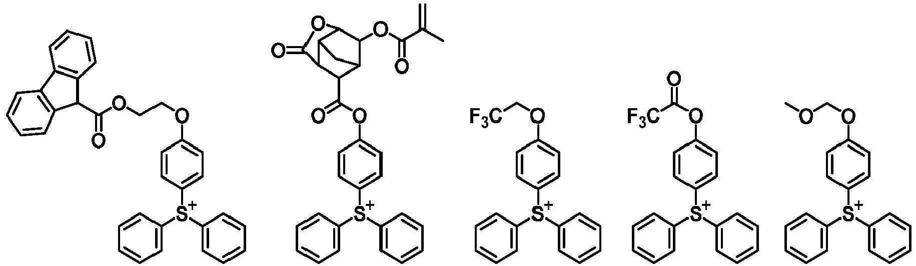

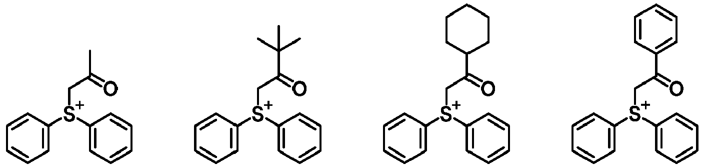

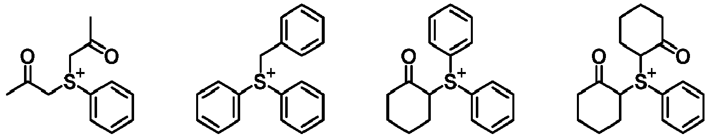

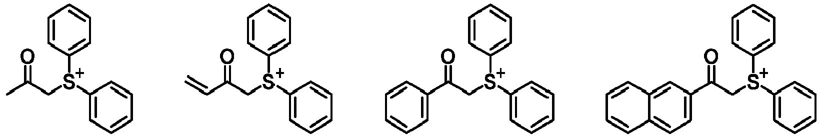

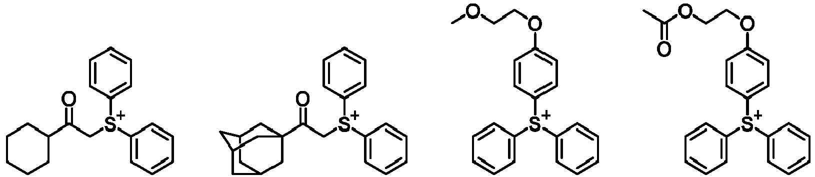

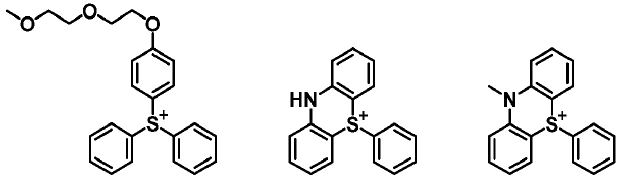

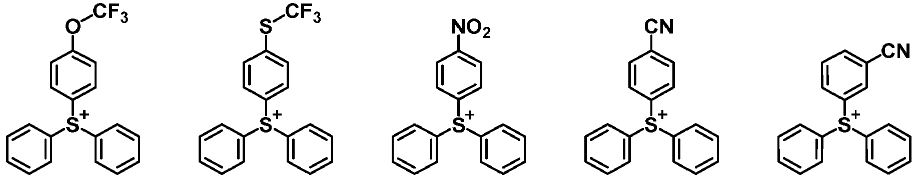

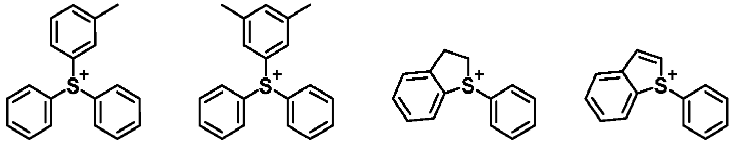

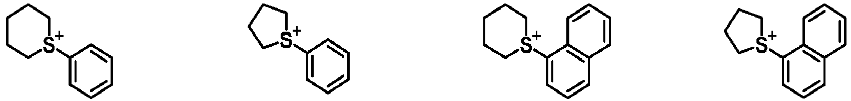

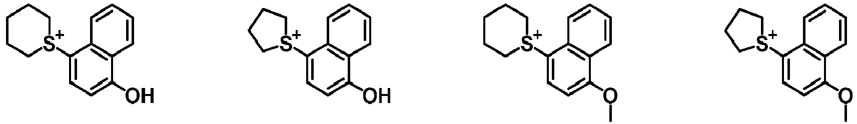

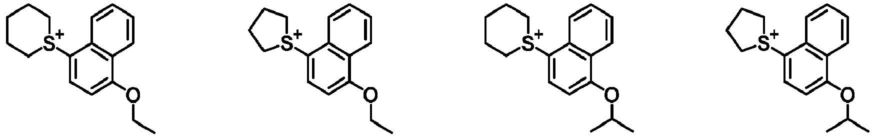

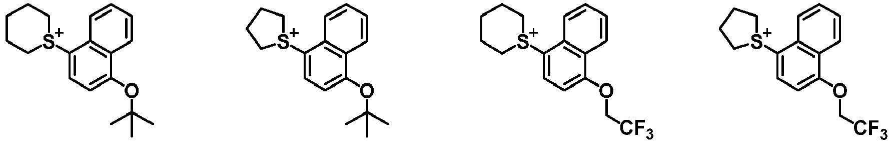

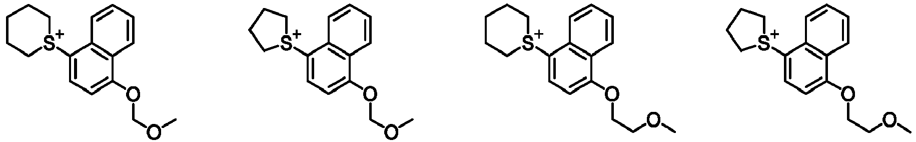

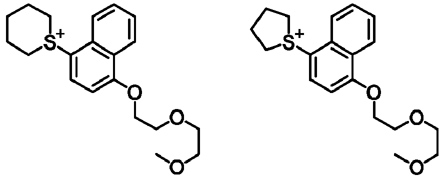

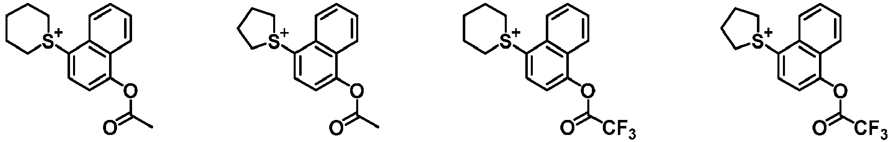

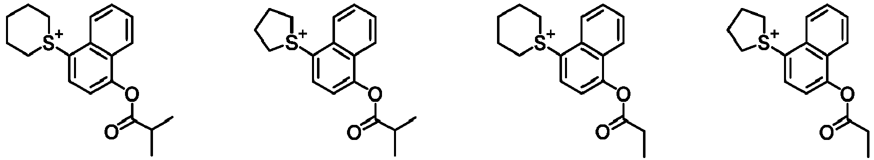

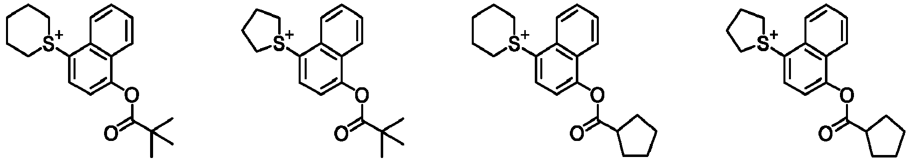

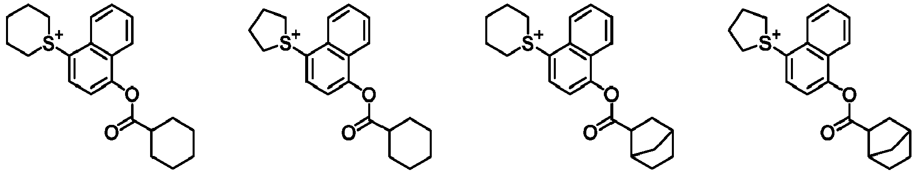

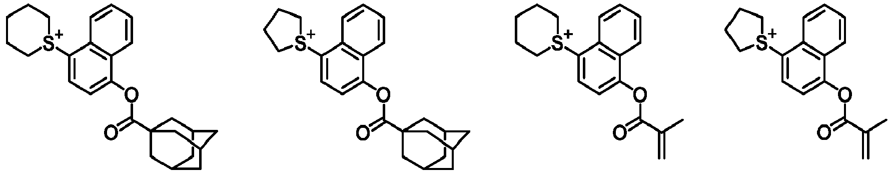

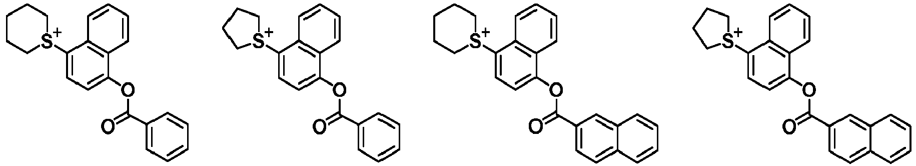

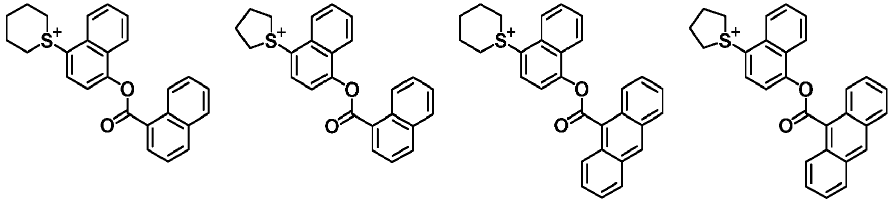

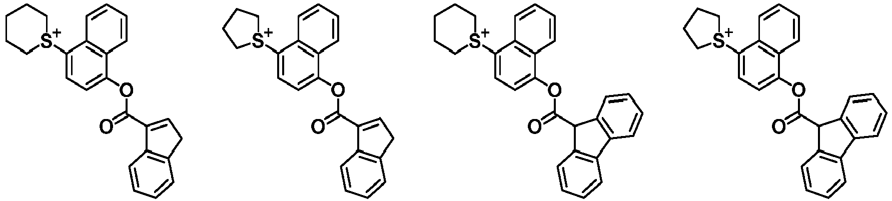

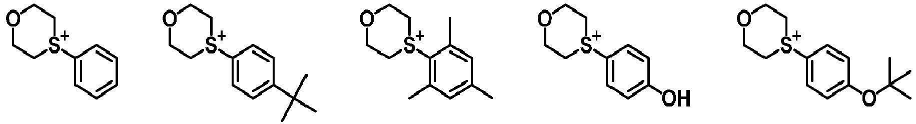

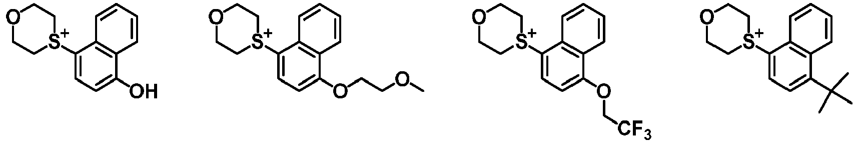

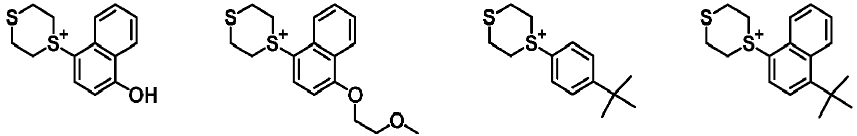

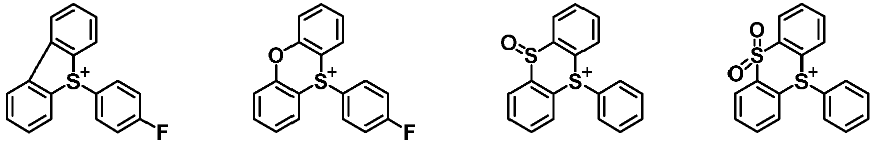

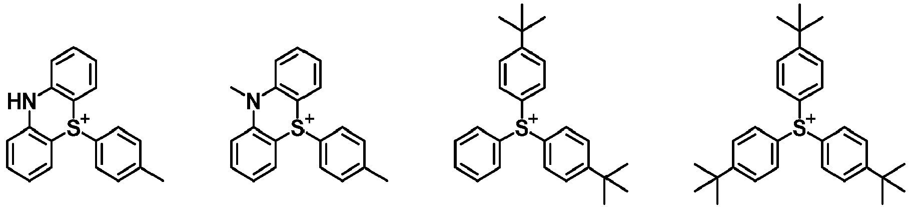

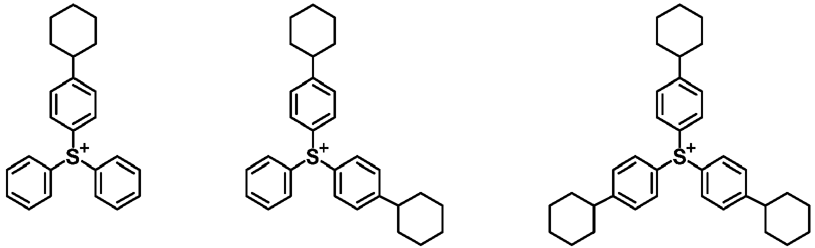

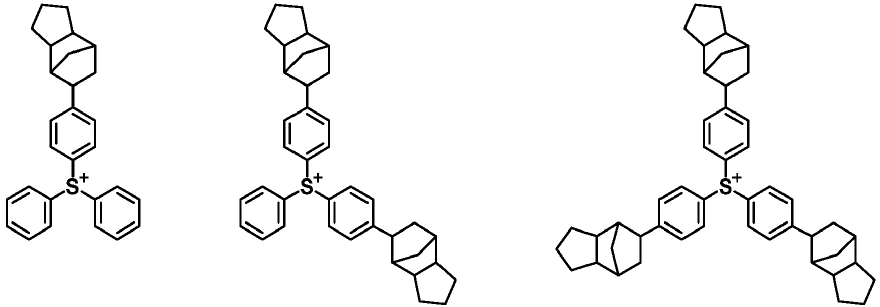

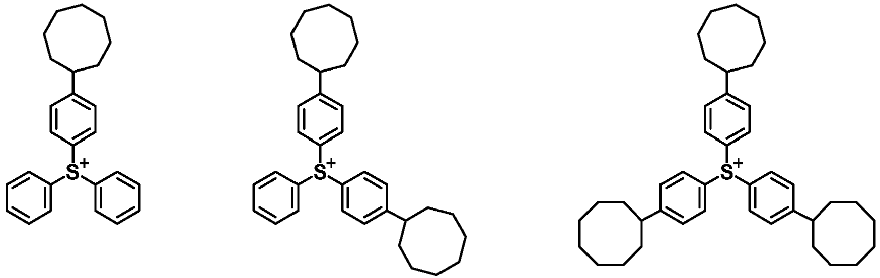

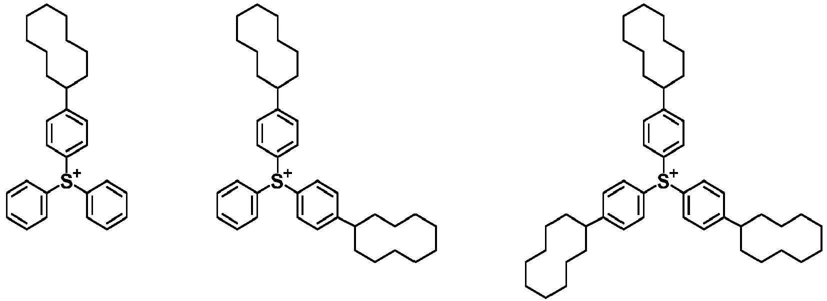

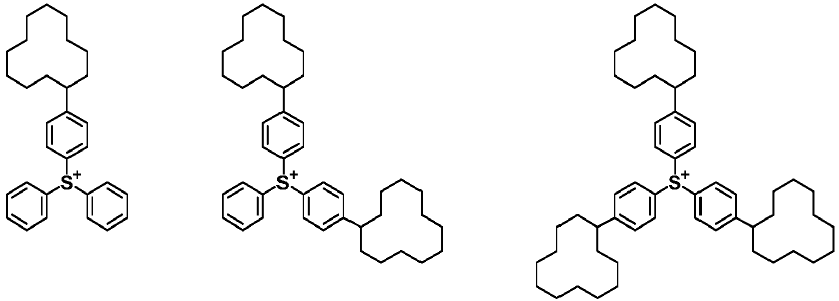

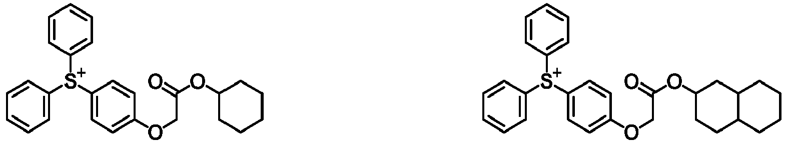

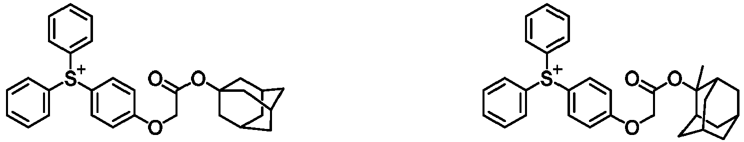

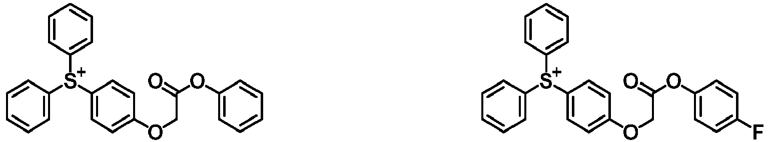

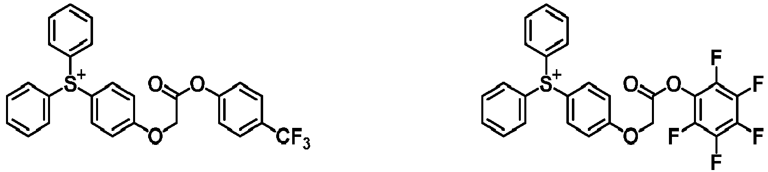

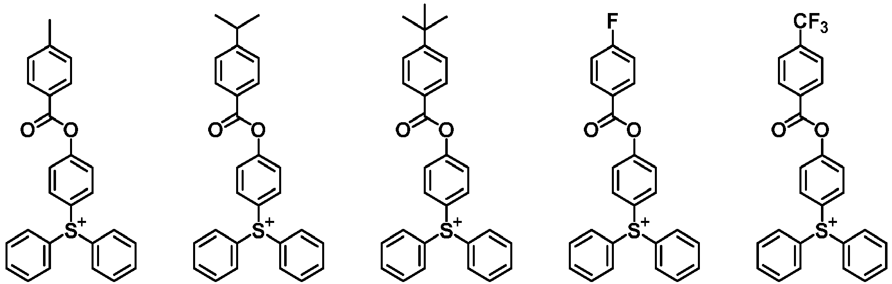

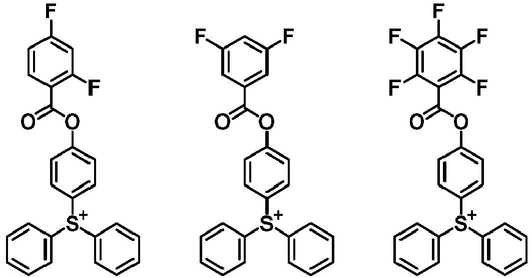

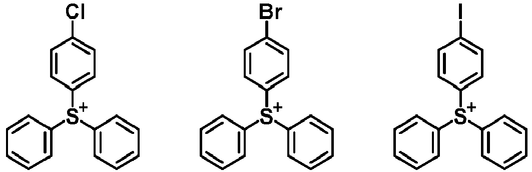

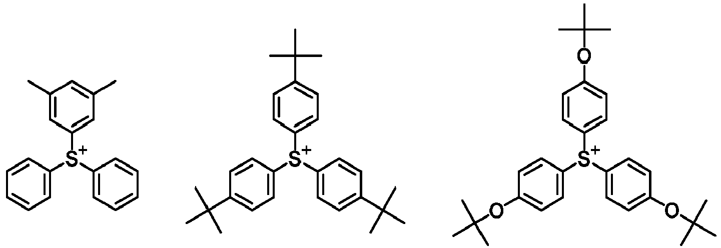

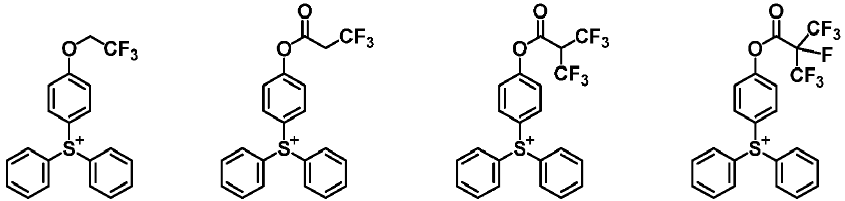

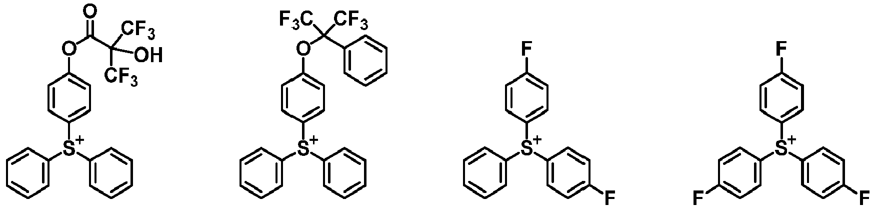

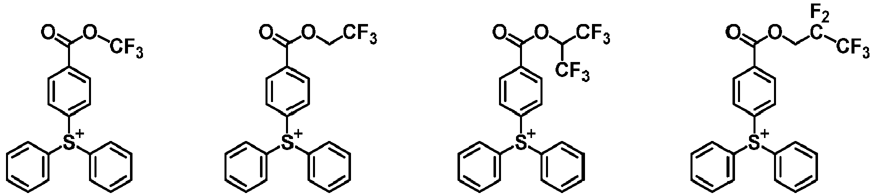

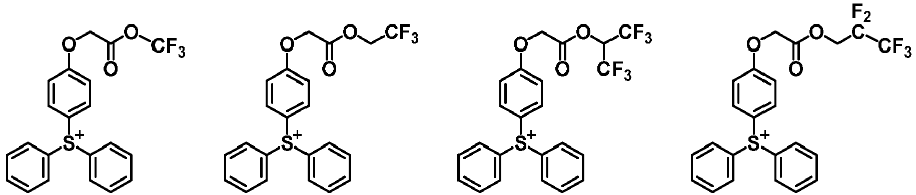

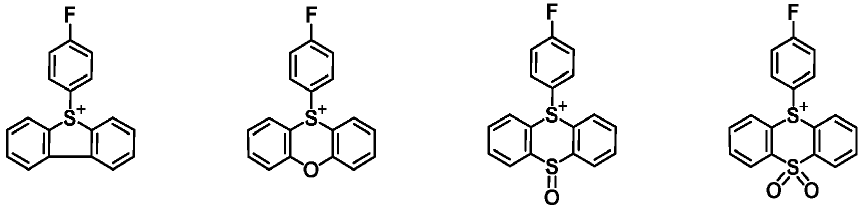

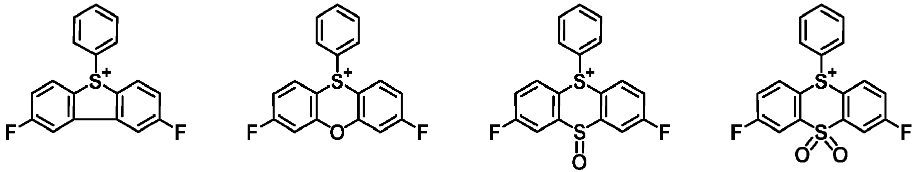

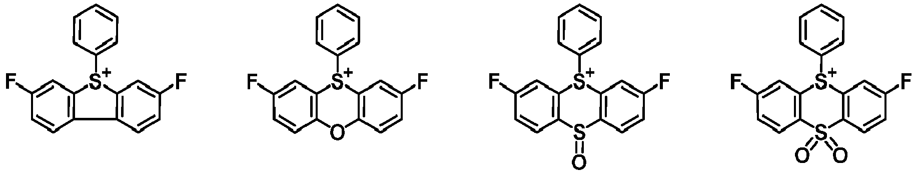

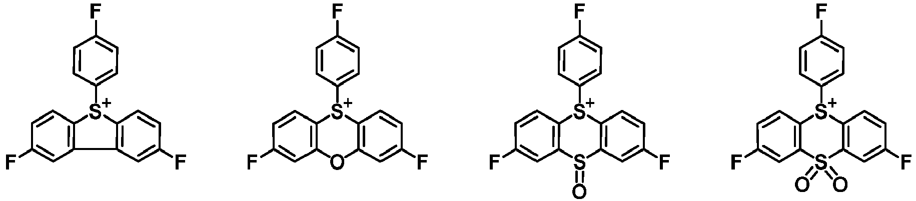

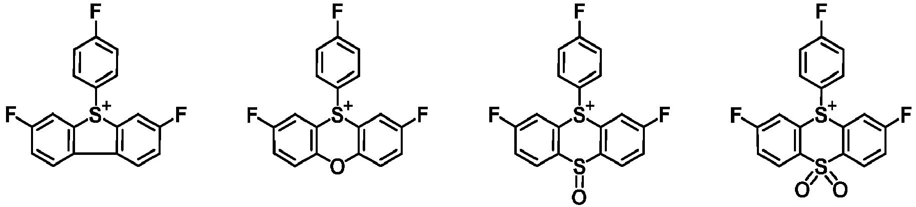

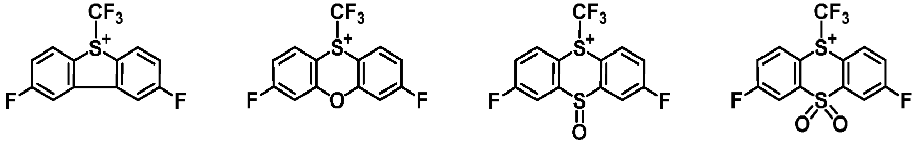

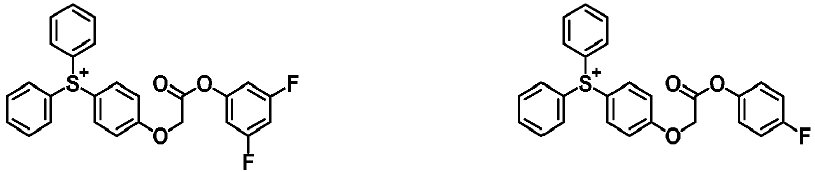

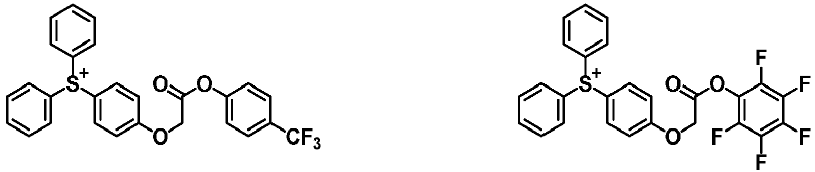

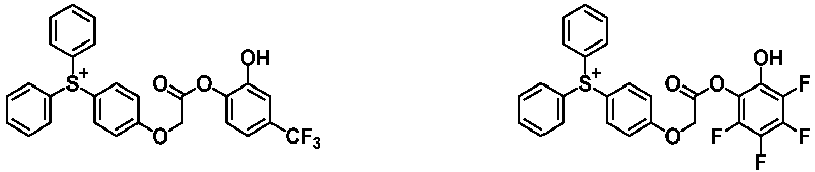

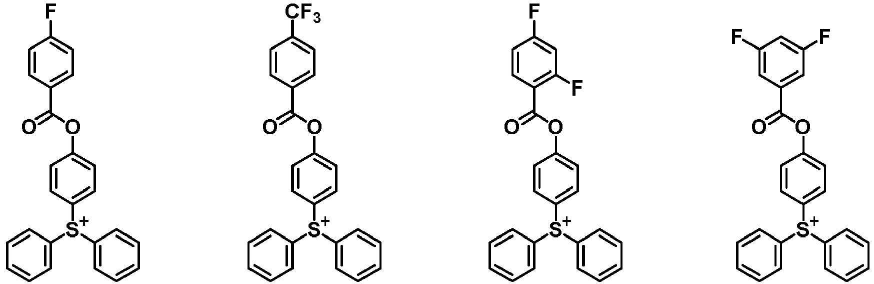

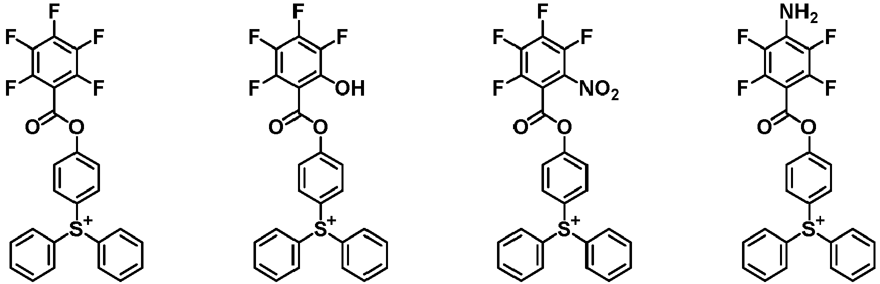

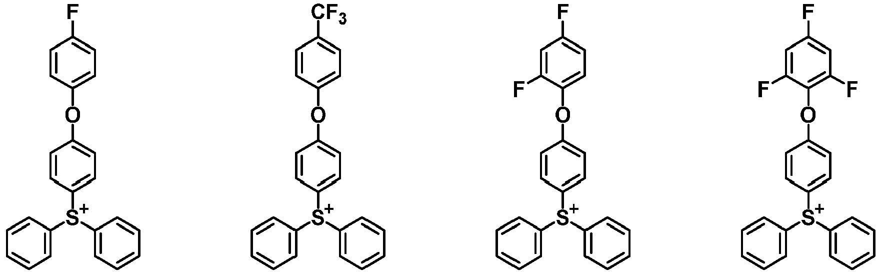

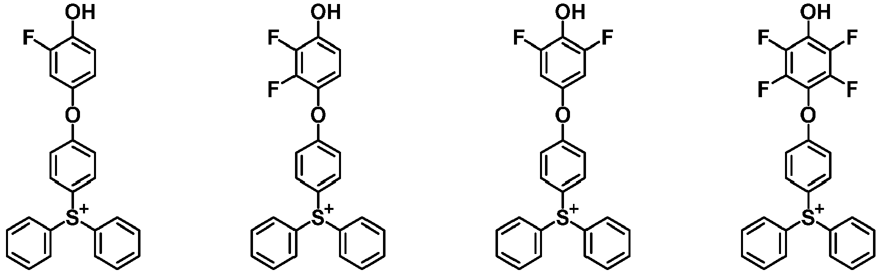

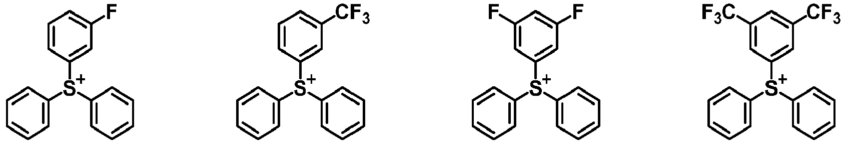

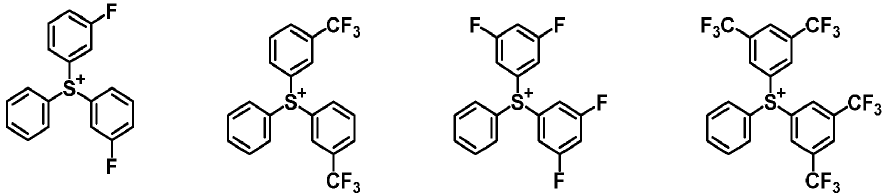

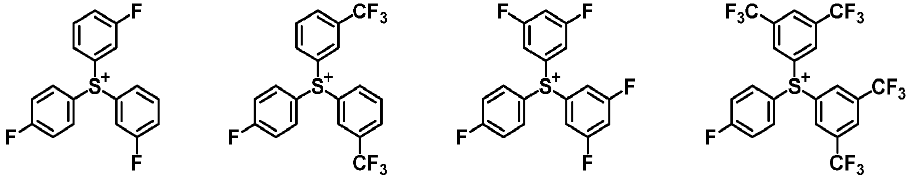

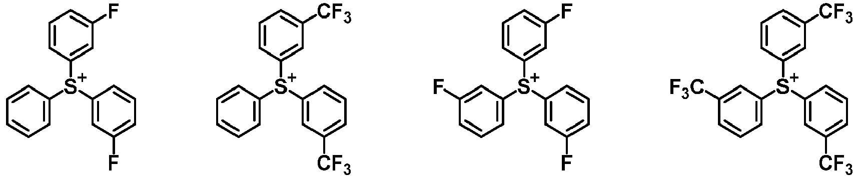

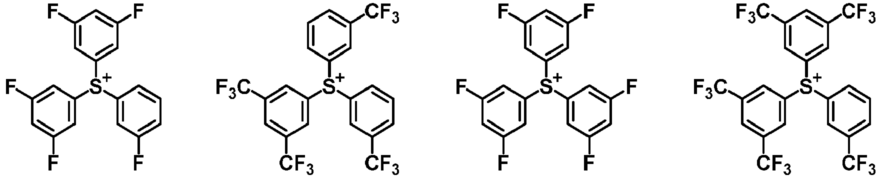

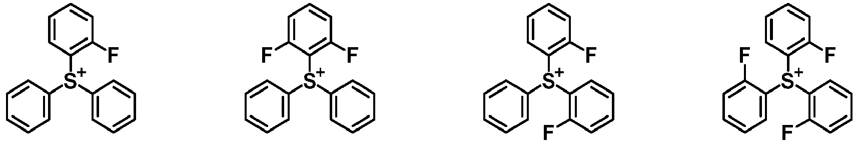

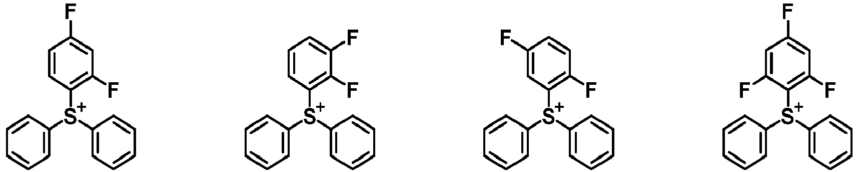

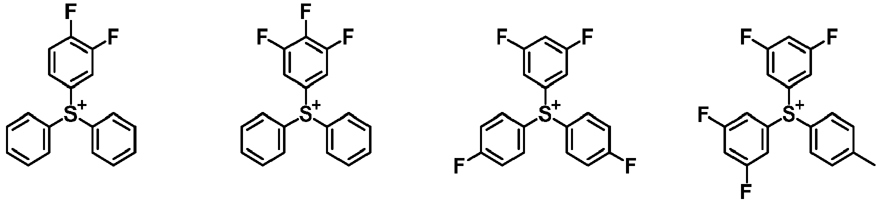

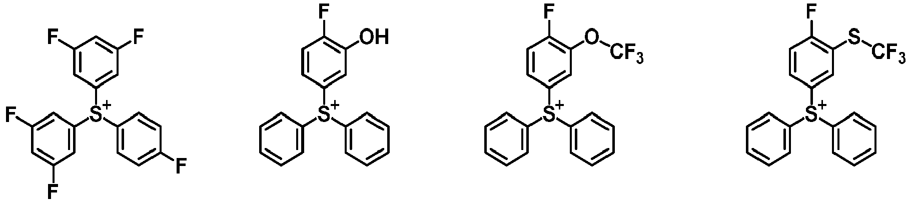

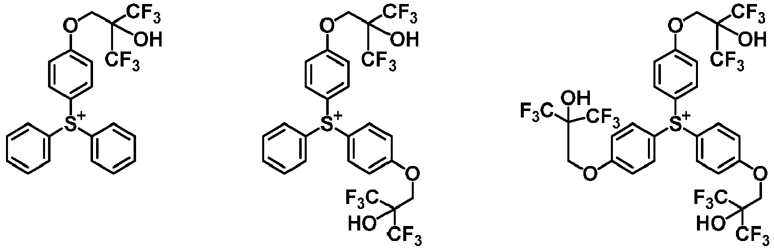

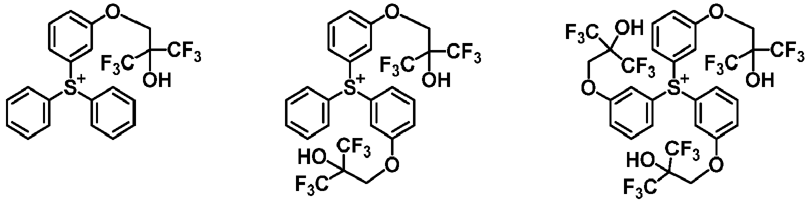

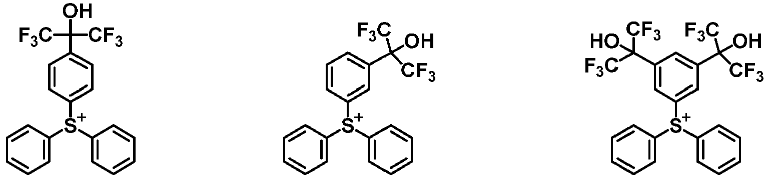

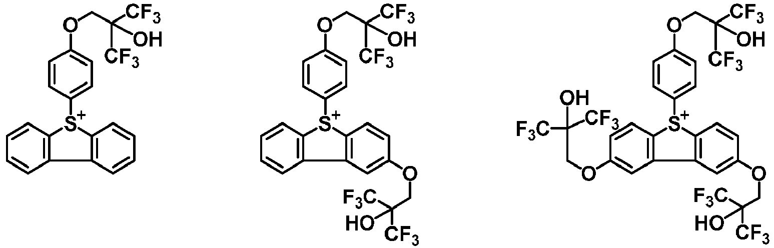

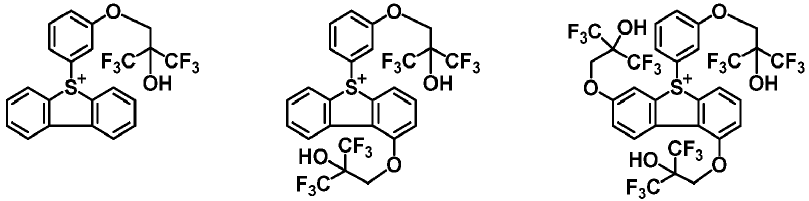

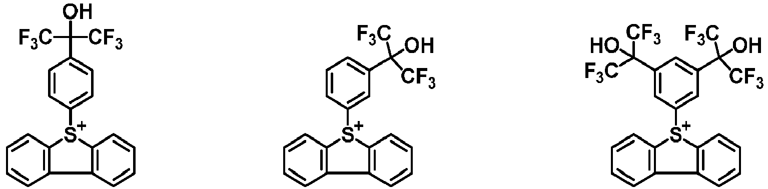

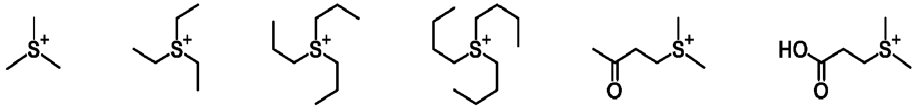

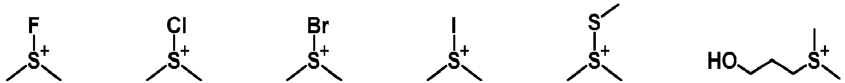

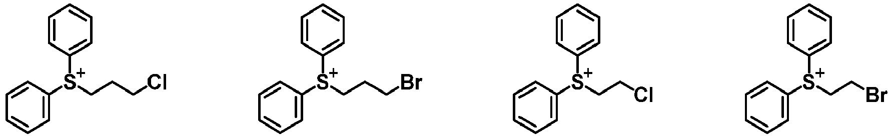

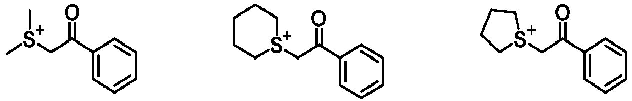

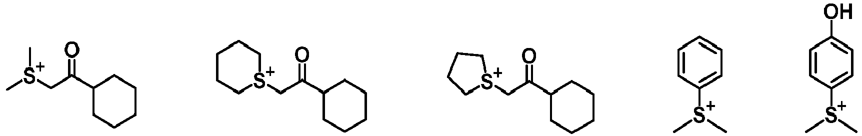

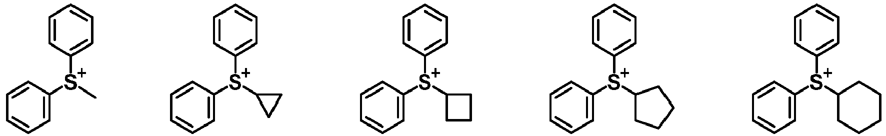

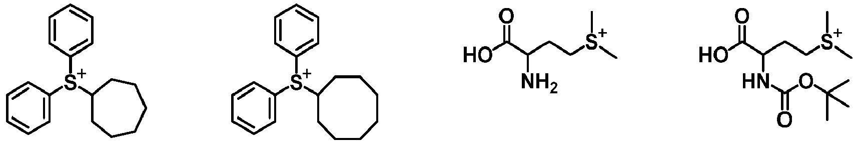

The sulfonium salt having formula (A1) may be synthesized, for example, by ion exchange of a carboxylic acid having the anion in formula (A1) with a sulfonium salt of weaker acid than the carboxylic acid. Typical of the weaker acid than the carboxylic acid is carbonic acid. Alternatively, the sulfonium salt may be synthesized by ion exchange of a sodium salt of a carboxylic acid having the anion in formula (A1) with a sulfonium chloride.

The sulfonium salt having formula (A1) effectively functions as the optimum quencher when applied to chemically amplified positive resist compositions.

In the chemically amplified positive resist composition, the sulfonium salt having formula (A1) is preferably present in an amount of 0.1 to 100 parts by weight, more preferably 1 to 50 parts by weight per 80 parts by weight of the base polymer (B) to be described later. An amount in the range allows the sulfonium salt having formula (A1) to function as the quencher, eliminating any performance losses such as a lowering of sensitivity and formation of foreign particles due to a shortage of solubility. The sulfonium salt having formula (A1) may be used alone or in admixture.

### (B) Base polymer

The base polymer as component (B) contains a polymer which is decomposed under the action of acid to increase its solubility in alkaline developer, the polymer comprising repeat units having the following formula (B1). Notably, the unit having formula (B1) is also referred to as unit B1.

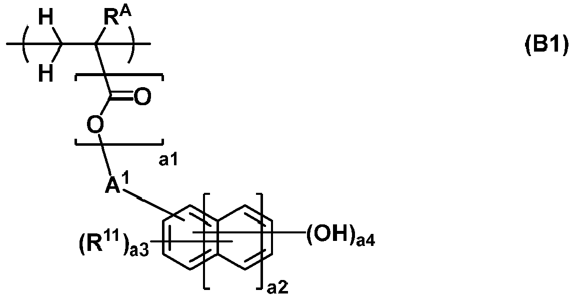

In formula (B1), a1 is 0 or 1. The subscript a2 is an integer of 0 to 2. The structure represents a benzene skeleton when a2=0, a naphthalene skeleton when a2=1, and an anthracene skeleton when a2=2. The subscript a3 is an integer satisfying 0 ≤ a3 ≤ 5+2a2-a4, and a4 is an integer of 1 to 3. In case of a2=0, preferably a3 is an integer of 0 to 3, and a4 is an integer of 1 to 3. In case of a2=1 or 2, preferably a3 is an integer of 0 to 4, and a4 is an integer of 1 to 3.

In formula (B1), R^{A} is hydrogen, fluorine, methyl or trifluoromethyl.

In formula (B1), R¹¹ is halogen, an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group. The saturated hydrocarbyl group and saturated hydrocarbyl moiety in the saturated hydrocarbyloxy group and saturated hydrocarbylcarbonyloxy group may be straight, branched or cyclic, and examples thereof include alkyl groups such as methyl, ethyl, propyl, isopropyl, butyl, pentyl, and hexyl, cycloalkyl groups such as cyclopropyl, cyclobutyl, cyclopentyl and cyclohexyl, and combinations thereof. A carbon count within the upper limit ensures good solubility in alkaline developer. A plurality of R¹¹ may be identical or different when a3 is 2 or more.

In formula (B1), A¹ is a single bond or C₁-C₁₀ saturated hydrocarbylene group in which any constituent -CH₂- may be replaced by -O-. The saturated hydrocarbylene group may be straight, branched or cyclic and examples thereof include alkanediyl groups such as methylene, ethane-1,2-diyl, propane-1,3-diyl, butane-1,4-diyl, pentane-1,5-diyl, hexane-1,6-diyl, and structural isomers thereof; cyclic saturated hydrocarbylene groups such as cyclopropanediyl, cyclobutanediyl, cyclopentanediyl, and cyclohexanediyl; and combinations thereof. For the saturated hydrocarbylene group containing an ether bond, in case a1=1 in formula (B1), the ether bond may be incorporated at any position excluding the position between the α-carbon and β-carbon relative to the ester oxygen. In case a1=0, the atom that bonds with the main chain becomes an ethereal oxygen, and a second ether bond may be incorporated at any position excluding the position between the α-carbon and β-carbon relative to that ethereal oxygen. Saturated hydrocarbylene groups having no more than 10 carbon atoms are desirable because of a sufficient solubility in alkaline developer.

Preferred examples of the repeat units B1 wherein a1=0 and A¹ is a single bond (meaning that the aromatic ring is directly bonded to the main chain of the polymer), that is, repeat units free of a linker: -C(=O)-O-A¹- include units derived from 3-hydroxystyrene, 4-hydroxystyrene, 5-hydroxy-2-vinylnaphthalene, and 6-hydroxy-2-vinylnaphthalene. Repeat units having the formula (B1-1) are especially preferred. 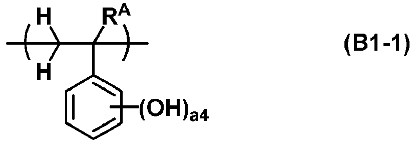 Herein R^{A} and a4 are as defined above.

Preferred examples of the repeat units B1 wherein a 1 = 1, that is, having a linker: -C(=O)-O-A¹- are shown below, but not limited thereto. 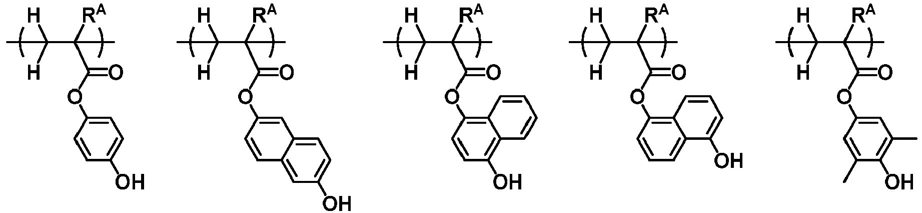 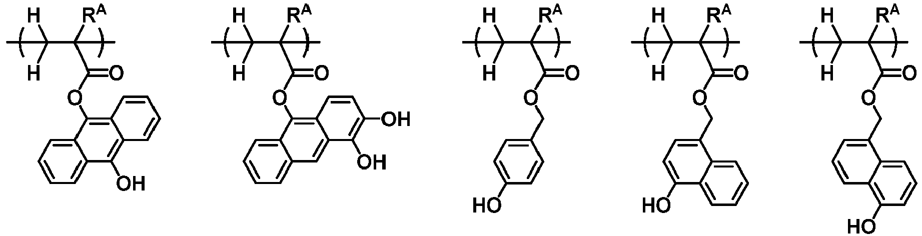 Herein R^{A} is as defined above.

The content of repeat units B1 is preferably 10 to 95 mol%, more preferably 40 to 90 mol% of the overall repeat units of the polymer. When the polymer further contains repeat units having formula (B3) and/or repeat units having formula (B4), which provide the polymer with higher etch resistance, the repeat units having a phenolic hydroxy group as a substituent, the total content of repeat units B1 and repeat units B3 and/or B4 is preferably in the range. The repeat units B 1 may be used alone or in admixture of two or more.

In a preferred embodiment, the polymer further contains a unit having an acidic functional group protected with an acid labile group (i.e., unit protected with an acid labile group and adapted to turn alkali soluble under the action of acid) in order that the positive resist composition in an exposed region turn soluble in alkaline aqueous solution. In this embodiment, since the acid labile group (protective group) in the repeat unit undergoes deprotection reaction under the action of acid, the polymer becomes more soluble in alkaline developer.

Typical of the above unit is a unit having the formula (B2-1), also referred to as repeat unit B2-1.

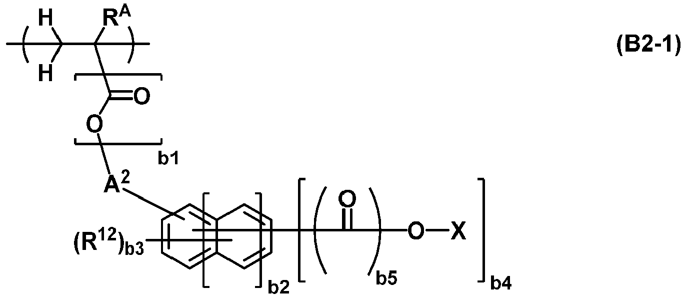

In formula (B2-1), R^{A} is as defined above. The subscript b1 is 0 or 1. The subscript b2 is an integer of 0 to 2. The structure represents a benzene skeleton when b2=0, a naphthalene skeleton when b2=1, and an anthracene skeleton when b2=2. The subscript b3 is an integer meeting 0 ≤ b3 ≤ 5+2b2-b4. The subscript b4 is an integer of 1 to 3, and b5 is 0 or 1. When b2=0, preferably b3 is an integer of 0 to 3, and b4 is an integer of 1 to 3. When b2=1 or 2, preferably b3 is an integer of 0 to 4, and b4 is an integer of 1 to 3.

In formula (B2-1), R^{A} is hydrogen, fluorine, methyl or trifluoromethyl.

In formula (B2-1), R¹² is halogen, an optionally halogenated C₁-C₆ saturated hydrocarbyl group, optionally halogenated C₁-C₆ saturated hydrocarbyloxy group or optionally halogenated C₂-C₈ saturated hydrocarbylcarbonyloxy group. The saturated hydrocarbyl group and saturated hydrocarbyl moiety in the saturated hydrocarbyloxy group and saturated hydrocarbylcarbonyloxy group may be straight, branched or cyclic, and examples thereof include alkyl groups such as methyl, ethyl, propyl, isopropyl, butyl, pentyl, and hexyl, cycloalkyl groups such as cyclopropyl, cyclobutyl, cyclopentyl and cyclohexyl, and combinations thereof. A carbon count within the upper limit ensures good solubility in alkaline developer. A plurality of R12 may be identical or different when b3 is 2 or more.

In formula (B2-1), A² is a single bond or a C₁-C₁₀ saturated hydrocarbylene group in which any constituent -CH₂- may be replaced by -O-. The saturated hydrocarbylene group may be straight, branched or cyclic and examples thereof include alkanediyl groups such as methylene, ethane-1,2-diyl, propane-1,3-diyl, butane-1,4-diyl, pentane-1,5-diyl, hexane-1,6-diyl, and structural isomers thereof; cyclic saturated hydrocarbylene groups such as cyclopropanediyl, cyclobutanediyl, cyclopentanediyl, and cyclohexanediyl; and combinations thereof. For the saturated hydrocarbylene group containing an ether bond, in case b 1 = 1 in formula (B2-1), the ether bond may be incorporated at any position excluding the position between the α-carbon and β-carbon relative to the ester oxygen. In case b1=0, the atom that bonds with the main chain becomes an ethereal oxygen, and a second ether bond may be incorporated at any position excluding the position between the α-carbon and β-carbon relative to that ethereal oxygen. Saturated hydrocarbylene groups having no more than 10 carbon atoms are desirable because of a sufficient solubility in alkaline developer.

In formula (B2-1), X is an acid labile group when b4=1, and hydrogen or an acid labile group, at least one X being an acid labile group, when b4=2 or 3. That is, repeat units B2-1 have phenolic hydroxy groups bonded to an aromatic ring, at least one of which is protected with an acid labile group, or repeat units B2-1 have a carboxy group bonded to an aromatic ring, which is protected with an acid labile group. The acid labile group used herein is not particularly limited as long as it is commonly used in a number of well-known chemically amplified resist compositions and eliminated under the action of acid to release an acidic group. Examples of the acid labile group are as exemplified above for the acid labile group represented by R¹ in formula (A1).

Another example of the repeat unit having an acidic functional group protected with an acid labile group is a repeat unit having the following formula (B2-2), referred to as repeat unit B2-2. The repeat unit having formula (B2-2), which is such that the dissolution rate in the exposed region increases, is a useful choice of the acid labile group-containing unit which affords satisfactory performance against line width variations during develop loading.

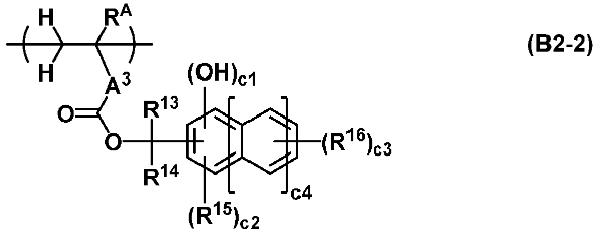

In formula (B2-2), c1 is an integer of 0 to 2, c2 is an integer of 0 to 2, c3 is an integer of 0 to 5, and c4 is an integer of 0 to 2. R^{A} is hydrogen, fluorine, methyl or trifluoromethyl. A³ is a single bond, phenylene group, naphthylene group, or ^{∗}-C(=O)-O-A³¹-. A³¹ is a C₁-C₂₀ aliphatic hydrocarbylene group which may contain hydroxy, ether bond, ester bond or lactone ring, or phenylene or naphthylene group. R¹³ and R¹⁴ are each independently a C₁-C₁₀ hydrocarbyl group which may contain a heteroatom, R¹³ and R¹⁴ may bond together to form a ring with the carbon atom to which they are attached. R¹⁵ is each independently fluorine, C₁-C₅ fluorinated alkyl group or C₁-C₅ fluorinated alkoxy group. R¹⁶ is each independently a C₁-C₁₀ hydrocarbyl group which may contain a heteroatom.

Preferred examples of the repeat unit B2-2 are shown below, but not limited thereto. Herein R^{A} is as defined above.

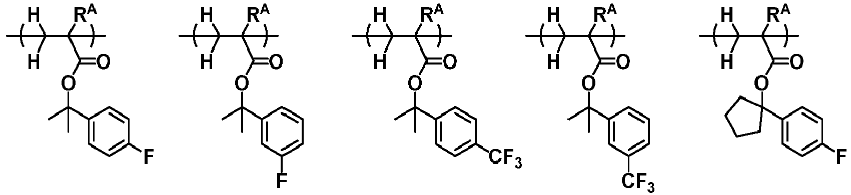

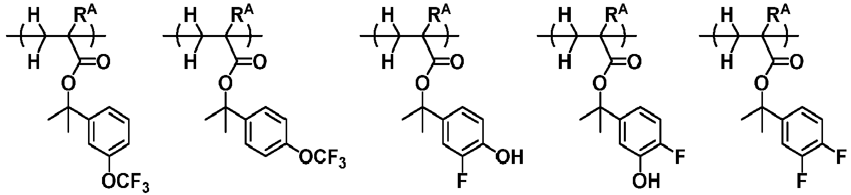

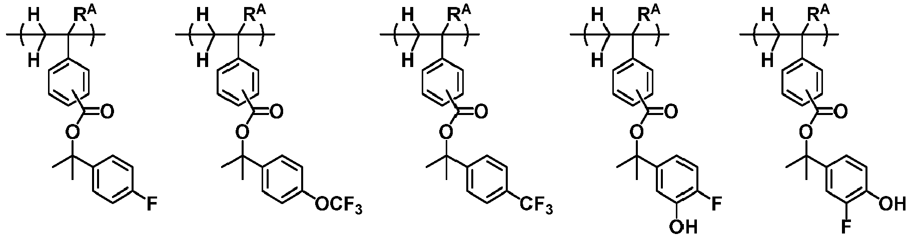

Another choice of acid labile group which can be used herein is a phenolic hydroxy group whose hydrogen is substituted by a tertiary saturated hydrocarbyl moiety: -CH₂COO-. Examples of the tertiary saturated hydrocarbyl moiety are as exemplified above for the tertiary saturated hydrocarbyl group used for the protection of phenolic hydroxy group.

The content of repeat units B2-1 and B2-2 is preferably 5 to 50 mol% based on the overall repeat units of the polymer. Each of repeat units B2-1 and B2-2 may be of one type or a mixture of two or more types.

In a preferred embodiment, the polymer further comprises repeat units of at least one type selected from units having the formulae (B3), (B4) and (B5). These repeat units are simply referred to as repeat units B3, B4 and B5, respectively.

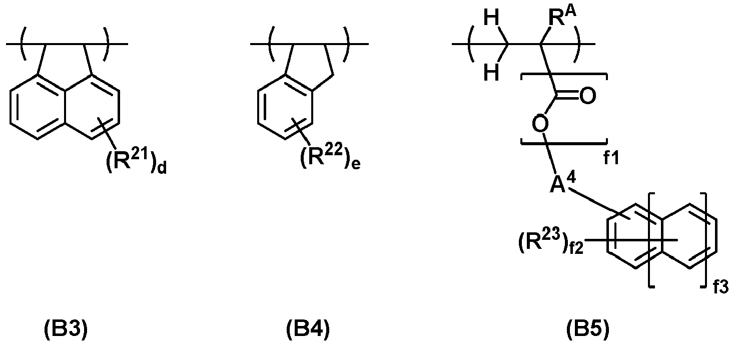

In formulae (B3) and (B4), d and e are each independently an integer of 0 to 4.

In formulae (B3) and (B4), R²¹ and R²² are each independently hydroxy, halogen, an optionally halogenated C₁-C₈ saturated hydrocarbyl group, optionally halogenated C₁-C₈ saturated hydrocarbyloxy group, or optionally halogenated C₂-C₈ saturated hydrocarbylcarbonyloxy group. The saturated hydrocarbyl group, saturated hydrocarbyloxy group and saturated hydrocarbylcarbonyloxy group may be straight, branched or cyclic. When d is 2 or more, a plurality of groups R²¹ may be identical or different. When e is 2 or more, a plurality of groups R²² may be identical or different.

In formula (B5), f1 is 0 or 1 and f2 is an integer of 0 to 5. The subscript f3 is an integer of 0 to 2, and the corresponding structure represents a benzene skeleton when f3=0, a naphthalene skeleton when f3=1, and an anthracene skeleton when f3=2. In case of f3=0, preferably f2 is an integer of 0 to 3. In case of f3=1 or 2, preferably f2 is an integer of 0 to 4.

In formula (B5), R^{A} is as defined above. R²³ is a C₁-C₂₀ saturated hydrocarbyl group, C₁-C₂₀ saturated hydrocarbyloxy group, C₂-C₂₀ saturated hydrocarbylcarbonyloxy group, C₂-C₂₀ saturated hydrocarbyloxyhydrocarbyl group, C₂-C₂₀ saturated hydrocarbylthiohydrocarbyl group, halogen atom, nitro group, cyano group, sulfinyl group or sulfonyl group. The saturated hydrocarbyl group, saturated hydrocarbyloxy group, saturated hydrocarbylcarbonyloxy group, saturated hydrocarbyloxyhydrocarbyl group, and saturated hydrocarbylthiohydrocarbyl group may be straight, branched or cyclic. When f2 is 2 or more, a plurality of groups R²³ may be identical or different.

R²³ is preferably selected from halogen atoms such as chlorine, bromine, and iodine, saturated hydrocarbyl groups such as methyl, ethyl, propyl, butyl, pentyl, hexyl, cyclopentyl, cyclohexyl, and structural isomers thereof, and saturated hydrocarbyloxy groups such as methoxy, ethoxy, propoxy, butoxy, pentyloxy, hexyloxy, cyclopentyloxy, cyclohexyloxy, and structural isomers of their hydrocarbon moiety. Inter alia, methoxy and ethoxy are useful.

Also, a saturated hydrocarbylcarbonyloxy group may be introduced into a polymer even at the end of polymerization by the chemical modification method and is thus advantageously used for fine adjustment of solubility of a base polymer in alkaline developer. Suitable saturated hydrocarbylcarbonyloxy groups include methylcarbonyloxy, ethylcarbonyloxy, propylcarbonyloxy, butylcarbonyloxy, pentylcarbonyloxy, hexylcarbonyloxy, cyclopentylcarbonyloxy, cyclohexylcarbonyloxy, benzoyloxy, and structural isomers of their hydrocarbon moiety. As long as the carbon count is not more than 20, the group is effective for appropriately controlling and adjusting (typically reducing) the solubility of a base polymer in alkaline developer and for preventing scum or development defects from forming.

Of the preferred substituent groups mentioned above, chlorine, bromine, iodine, methyl, ethyl, and methoxy are especially useful because corresponding monomers are readily furnished.

In formula (B5), A⁴ is a single bond or a C₁-C₁₀ saturated hydrocarbylene group in which any constituent -CH₂- may be replaced by -O-. The saturated hydrocarbylene group may be straight, branched or cyclic. Examples thereof include alkanediyl groups such as methylene, ethane-1,2-diyl, propane-1,3-diyl, butane-1,4-diyl, pentane-1,5-diyl, hexane-1,6-diyl, and structural isomers thereof, cyclic saturated hydrocarbylene groups such as cyclopropanediyl, cyclobutanediyl, cyclopentanediyl, and cyclohexanediyl, and combinations thereof. For the saturated hydrocarbylene group containing an ether bond, in case of f1 = 1 in formula (B5), the ether bond may be incorporated at any position excluding the position between the α- and β-carbons relative to the ester oxygen. In case of f1=0, the atom bonding to the backbone becomes an ether oxygen atom, and a second ether bond may be incorporated at any position excluding the position between the α- and β-carbons relative to the ether oxygen. Saturated hydrocarbylene groups having no more than 10 carbon atoms are desirable because of a sufficient solubility in alkaline developer.

Preferred examples of the repeat units B5 wherein f1=0 and A⁴ is a single bond (meaning that the aromatic ring is directly bonded to the main chain of the polymer), that is, repeat units free of a linker: -C(=O)-O-A⁴- include units derived from styrene, 4-chlorostyrene, 4-bromostyrene, 4-methylstyrene, 4-methoxystyrene, 4-acetoxystyrene, 2-hydroxypropylstyrene, 2-vinylnaphthalene, and 3-vinylnaphthalene.

Preferred examples of the repeat units B5 wherein f1=1, that is, having a linker: -C(=O)-O-A⁴- are shown below, but not limited thereto. Herein R^{A} is as defined above.

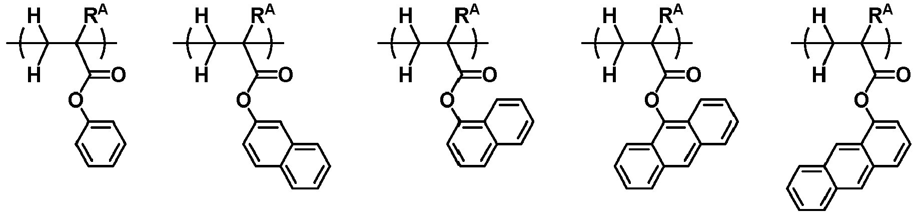

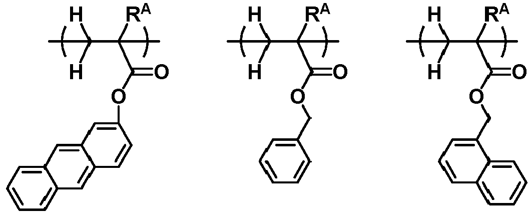

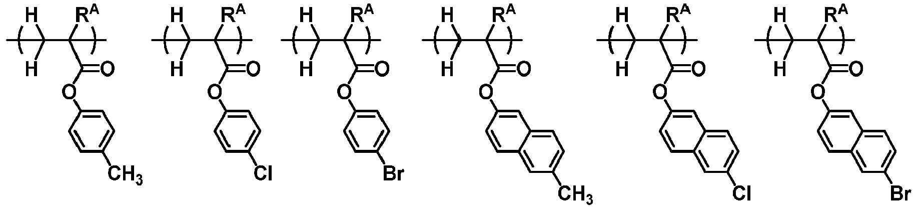

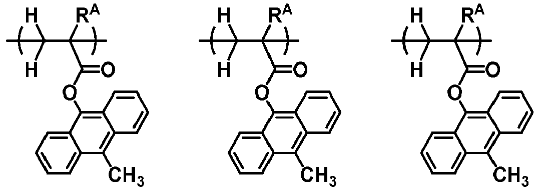

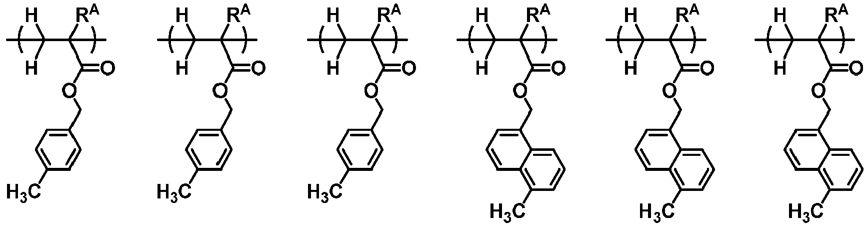

When repeat units of at least one type selected from repeat units B3 to B5 are incorporated, better performance is obtained because not only the aromatic ring possesses etch resistance, but the cyclic structure incorporated into the main chain also exerts the effect of improving etch resistance and resistance to EB irradiation during pattern inspection step.

The content of repeat units B3 to B5 is preferably at least 5 mol% based on the overall repeat units of the polymer for obtaining the effect of improving etch resistance. Also, the content of repeat units B3 to B5 is preferably up to 35 mol%, more preferably up to 30 mol% based on the overall repeat units of the polymer. When the relevant units are free of functional groups or have a functional group other than the aforementioned ones, their content of up to 35 mol% is preferred because the risk of forming development defects is eliminated. Each of the repeat units B3 to B5 may be of one type or a combination of plural types.

It is preferred that the polymer comprise repeat units B1, repeat units B2-1 and/or B2-2, and repeat units of at least one type selected from repeat units B3 to B5, because both etch resistance and high resolution are achievable. The total content of these repeat units is preferably at least 60 mol%, more preferably at least 70 mol%, even more preferably at least 80 mol% based on the overall repeat units of the polymer.

In another preferred embodiment, the polymer further comprises repeat units of at least one type selected from repeat units having the formula (B6), repeat units having the formula (B7), repeat units having the formula (B8), repeat units having the formula (B9), repeat units having the formula (B10), repeat units having the formula (B11), repeat units having the formula (B12), and repeat units having the formula (B13), shown below. Notably these repeat units are also referred to as repeat units B6 to B13. This embodiment achieves effective control of acid diffusion, and forms a pattern with an improved resolution and a reduced LER.

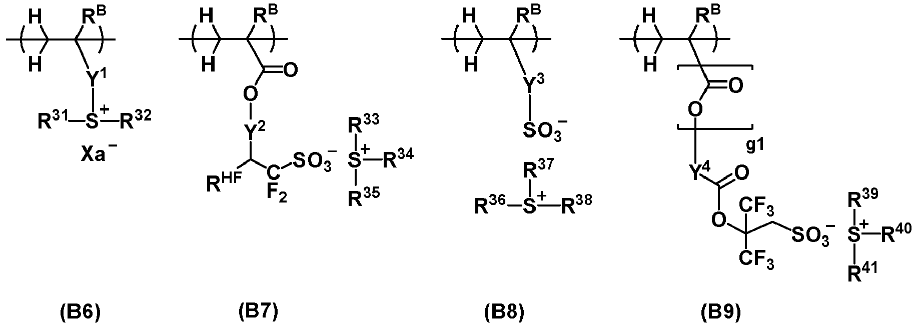

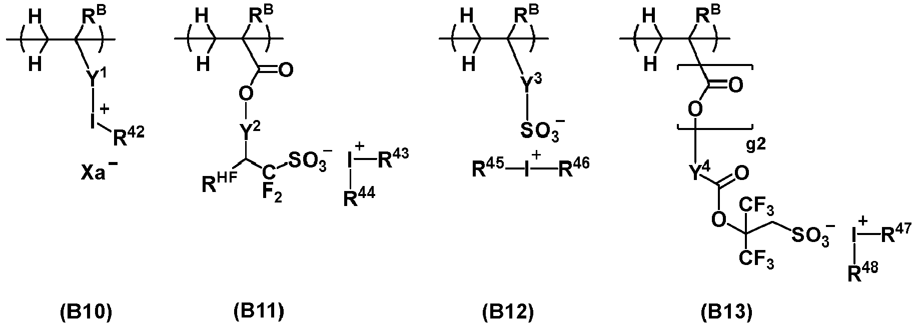

In formulae (B6) to (B13), R^{B} is each independently hydrogen or methyl. Y¹ is a single bond, a C₁-C₆ aliphatic hydrocarbylene group, phenylene group, naphthylene group or C₇-C₁₈ group obtained by combining the foregoing, -O-Y¹¹-, -C(=O)-O-Y¹¹-, or -C(=O)-NH-Y¹¹-, wherein Y¹¹ is a C₁-C₆ aliphatic hydrocarbylene group, phenylene group, naphthylene group or C₇-C₁₈ group obtained by combining the foregoing, which may contain a carbonyl moiety, ester bond, ether bond or hydroxy moiety. Y² is a single bond or -Y²¹-C(=O)-O-, wherein Y²¹ is a C₁-C₂₀ hydrocarbylene group which may contain a heteroatom. Y³ is a single bond, methylene, ethylene, phenylene, fluorinated phenylene, trifluoromethyl-substituted phenylene, -O-Y³¹-, -C(=O)-O-Y³¹-, or -C(=O)-NH-Y³¹-, wherein Y³¹ is a C₁-C₆ aliphatic hydrocarbylene group, phenylene group, fluorinated phenylene group, trifluoromethyl-substituted phenylene group, or C₇-C₂₀ group obtained by combining the foregoing, which may contain a carbonyl moiety, ester bond, ether bond or hydroxy moiety. Y⁴ is a single bond or C₁-C₃₀ hydrocarbylene group which may contain a heteroatom, g1 and g2 are each independently 0 or 1; g1 and g2 are 0 when Y⁴ is a single bond.

In formulae (B7) and (B11) wherein Y² is -Y²¹-C(=O)-O-, Y²¹ is a hydrocarbylene group which may contain a heteroatom. Illustrative, non-limiting examples of the hydrocarbylene group Y²¹ are given below.

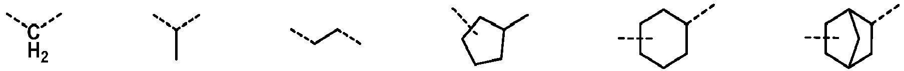

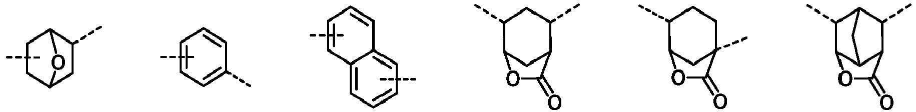

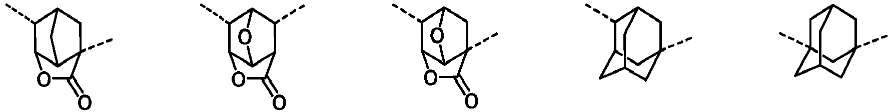

In formulae (B7) and (B11), R^{HF} is hydrogen or trifluoromethyl. Examples of the repeat units B7 and B11 wherein R^{HF} is hydrogen are as described in JP-A 2010-116550. Examples of the repeat units B7 and B11 wherein R^{HF} is trifluoromethyl are as described in JP-A 2010-077404. Examples of the repeat units B8 and B12 are as described in JP-A 2012-246265 and JP-A 2012-246426.

In formulae (B6) and (B10), Xa⁻ is a non-nucleophilic counter ion. Examples of the non-nucleophilic counter ion Xa⁻ are as described in JP-A 2010-113209 and JP-A 2007-145797.

Preferred examples of the anion in the monomer from which repeat units B9 and B 13 are derived are shown below, but not limited thereto.

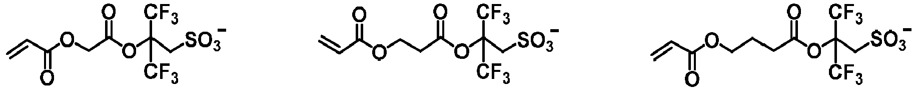

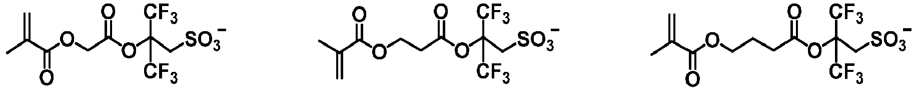

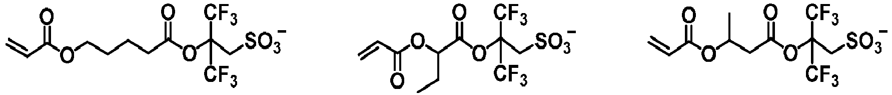

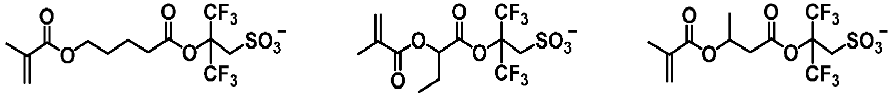

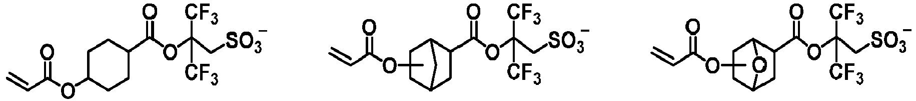

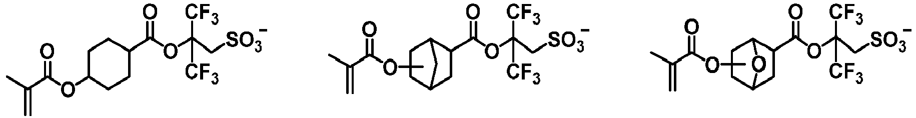

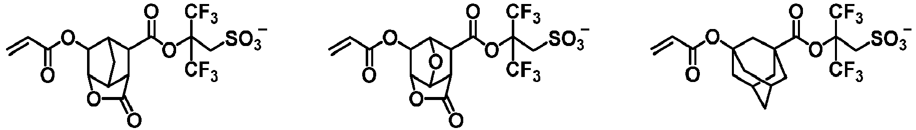

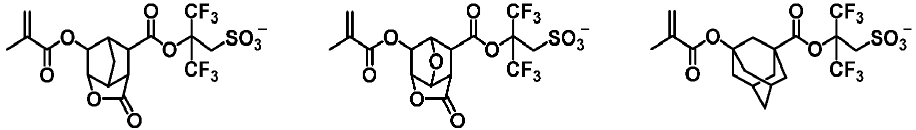

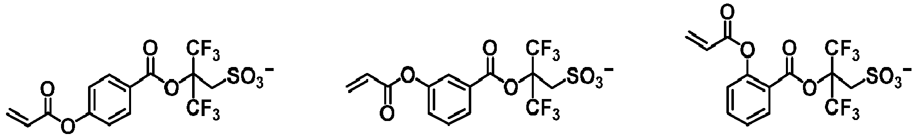

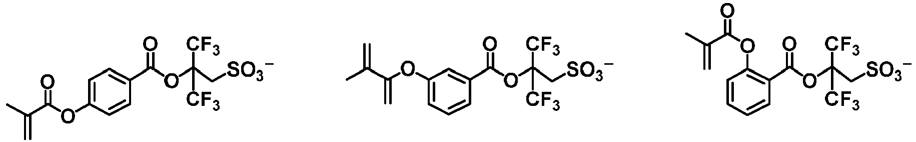

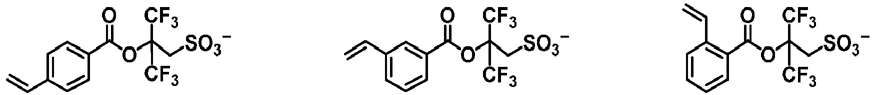

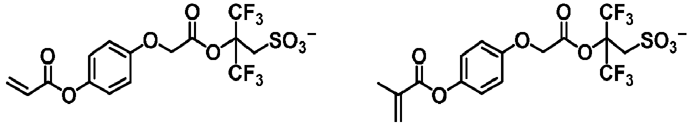

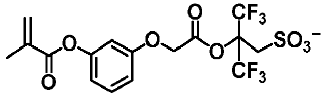

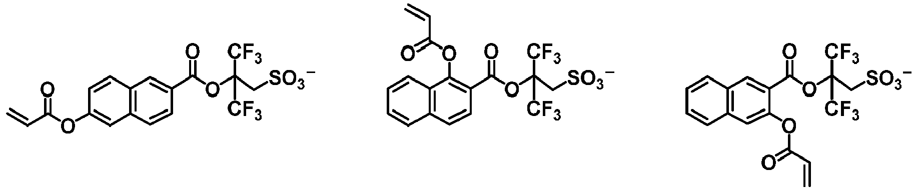

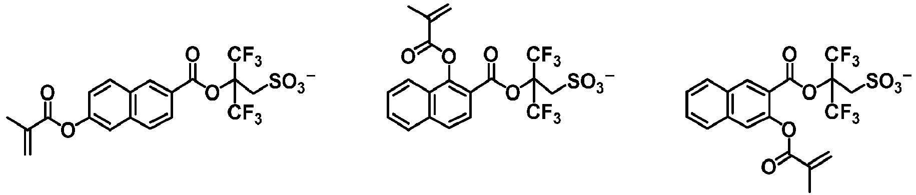

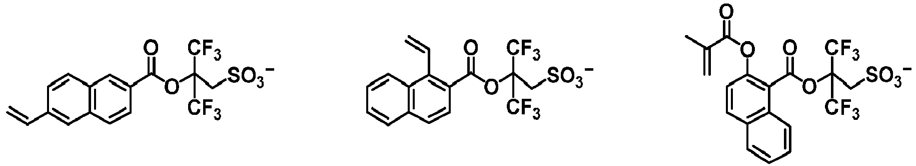

In formulae (B6) to (B13), R³¹ to R⁴⁸ are each independently a C₁-C₂₀ hydrocarbyl group which may contain a heteroatom. The hydrocarbyl group may be saturated or unsaturated and straight, branched or cyclic. Examples thereof are as exemplified above for the hydrocarbyl groups R³, R⁴ and R⁵ in formula (A1). In these hydrocarbyl groups, some or all of the hydrogen atoms may be substituted by a moiety containing a heteroatom such as oxygen, sulfur, nitrogen or halogen, and some constituent -CH₂- may be replaced by a moiety containing a heteroatom such as oxygen, sulfur or nitrogen, so that the group may contain a hydroxy, fluorine, chlorine, bromine, iodine, cyano, nitro, carbonyl, ether bond, ester bond, sulfonic ester bond, carbonate bond, lactone ring, sultone ring, carboxylic anhydride (-C(=O)-O-C(=O)-) or haloalkyl moiety.

A pair of R³¹ and R³² may bond together to form a ring with the sulfur atom to which they are attached. A pair of R³³ and R³⁴, R³⁶ and R³⁷, or R³⁹ and R⁴⁰ may bond together to form a ring with the sulfur atom to which they are attached. Examples of the ring are as exemplified above for the ring that R³ and R⁴ in formula (A1), taken together, form with the sulfur atom to which they are attached.

Exemplary structures of the sulfonium cation in repeat units B7 to B9 are as exemplified above for the cation in the sulfonium salt having formula (A1). Exemplary structures of the iodonium cation in repeat units B11 to B13 are shown below, but not limited thereto.

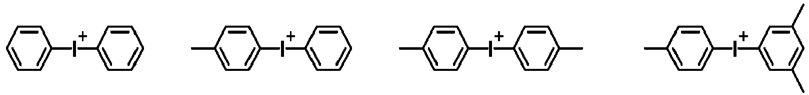

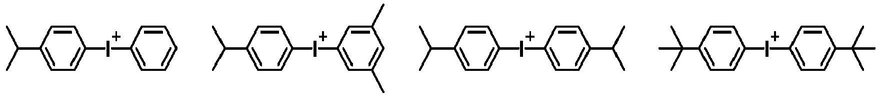

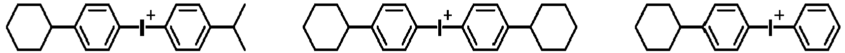

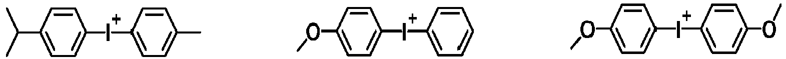

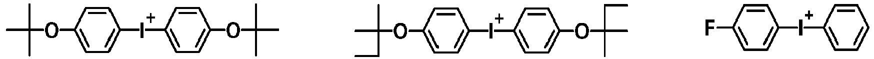

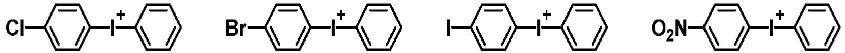

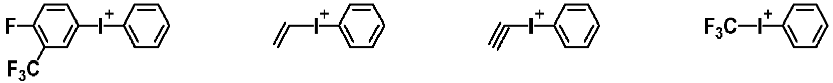

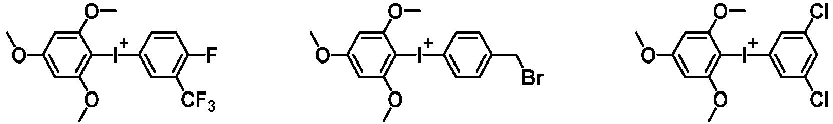

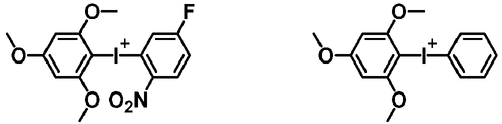

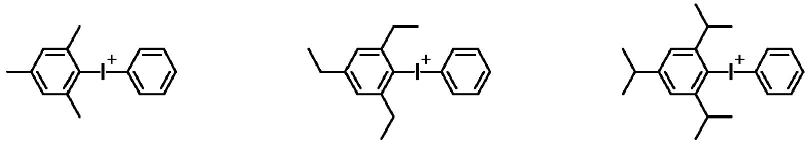

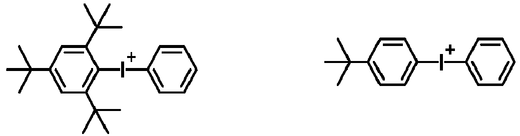

The repeat units B6 to B13 are capable of generating an acid upon receipt of high-energy radiation. With the relevant units bound to a polymer, an appropriate control of acid diffusion becomes possible, and a pattern with reduced LER and improved CDU can be formed. Since the acid-generating unit is bound to a polymer, the chemical flare phenomenon that acid volatilizes from the exposed region and re-deposits on the unexposed region during bake in vacuum is suppressed. This is effective for improving LER and CDU and for suppressing unwanted deprotection reaction in the unexposed region for thereby reducing defects. When the repeat units B6 to B13 are included, their content is preferably 0.5 to 30 mol% based on the overall repeat units of the polymer. Each of the repeat units B6 to B13 may be of one type or a combination of plural types.

The base polymer (B) may be a mixture of a first polymer comprising repeat units B1 and at least one of repeat units B6 to B13 and a second polymer comprising repeat units B1, but not repeat units B6 to B13. In the mixture, the amount of the second polymer not containing repeat units B6 to B13 is preferably 2 to 5,000 parts by weight, more preferably 10 to 1,000 parts by weight per 100 parts by weight of the first polymer containing repeat units B6 to B13.

The polymer may further comprise (meth)acrylate units protected with an acid labile group or (meth)acrylate units having an adhesive group such as lactone structure or hydroxy group other than phenolic hydroxy as commonly used in the art. These repeat units are effective for fine adjustment of properties of a resist film, but not essential.

Examples of the (meth)acrylate unit having an adhesive group include repeat units having the following formulae (B14) to (B16), which are also referred to as repeat units B14 to B16. While these units do not exhibit acidity, they may be used as auxiliary units for providing adhesion to substrates or adjusting solubility.

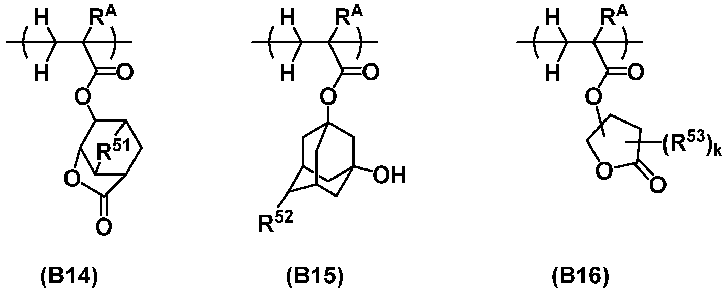

In formulae (B14) to (B16), R^{A} is as defined above. R⁵¹ is -O- or methylene. R⁵² is hydrogen or hydroxy. R⁵³ is a C₁-C₄ saturated hydrocarbyl group, and k is an integer of 0 to 3.

When the repeat units B14 to B16 are included, their content is preferably 0 to 30 mol%, more preferably 0 to 20 mol% based on the overall repeat units of the polymer. Each of the repeat units B14 to B16 may be of one type or a combination of plural types.

The polymer may be synthesized by combining suitable monomers optionally protected with a protective group, copolymerizing them in the standard way, and effecting deprotection reaction if necessary. The copolymerization reaction is preferably radical polymerization or anionic polymerization though not limited thereto. For the polymerization reaction, reference may be made to JP-A 2004-115630, for example.

The polymer should preferably have a Mw of 1,000 to 50,000, and more preferably 2,000 to 20,000. A Mw of at least 1,000 eliminates the risk that pattern features are rounded at their top, inviting degradations of resolution, LER and CDU. A Mw of up to 50,000 eliminates the risk that LER and CDU are degraded when a pattern with a line width of up to 100 nm is formed. As used herein, Mw is measured by GPC versus polystyrene standards using tetrahydrofuran (THF) or dimethylformamide (DMF) solvent.

The polymer preferably has a narrow molecular weight distribution or dispersity (Mw/Mn) of 1.0 to 2.0, more preferably 1.0 to 1.8. A polymer with such a narrow dispersity eliminates the risk that foreign particles are left on the pattern after development and the pattern profile is aggravated.

### (C) Photoacid generator

The positive resist composition may further comprise a photoacid generator (PAG) as component (C). The PAG used herein may be any compound capable of generating an acid upon exposure to high-energy radiation. Suitable PAGs include sulfonium salts, iodonium salts, sulfonyldiazomethane, N-sulfonyloxyimide, and oxime-O-sulfonate acid generators.

Suitable PAGs include nonafluorobutane sulfonate, partially fluorinated sulfonates described in JP-A 2012-189977, paragraphs [0247]-[0251], partially fluorinated sulfonates described in JP-A 2013-101271, paragraphs [0261]-[0265], and those described in JP-A 2008-111103, paragraphs [0122]-[0142] and JP-A 2010-215608, paragraphs [0080]-[0081]. Among others, arylsulfonate and alkanesulfonate type PAGs are preferred because they generate acids having an appropriate strength to deprotect the acid labile group in the repeat units having formula (B2-1) or (B2-2).

In order that the effect of improving LER is exerted by combining the PAG with the quencher (A), the PAG preferably generates an acid having a pKa value of -3.0 or larger, more preferably in the range of -3.0 to 2.0, even more preferably in the range of -2.0 to 1.5. A compound having an anion of the structure shown below is preferred as such PAG. Examples of the pairing cation include the above-illustrated examples of the sulfonium cation in formulae (A1) and (B7) to (B9) and the above-illustrated examples of the iodonium cation in formulae (B11) to (B13).

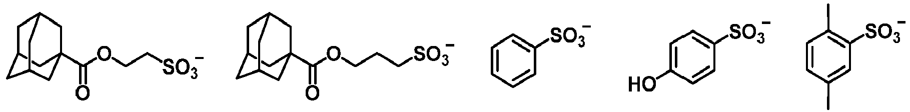

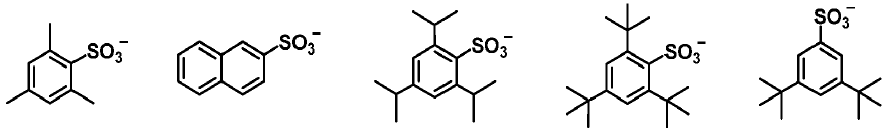

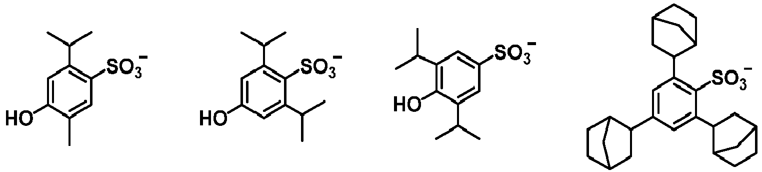

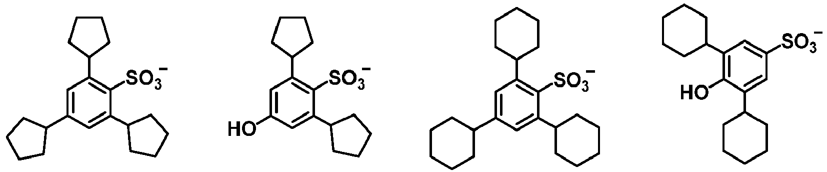

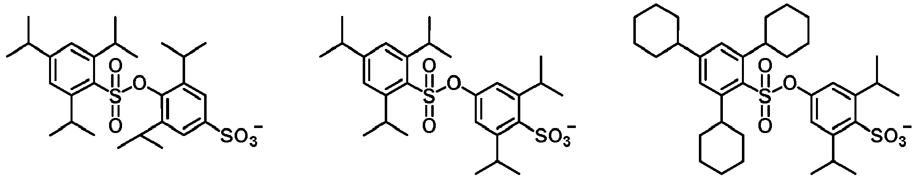

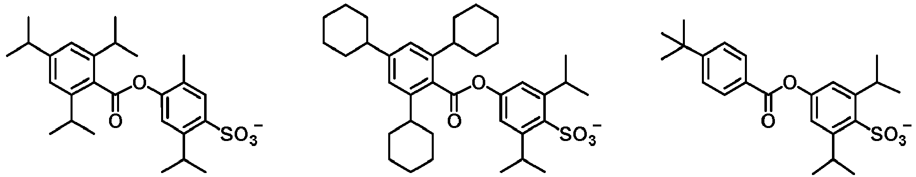

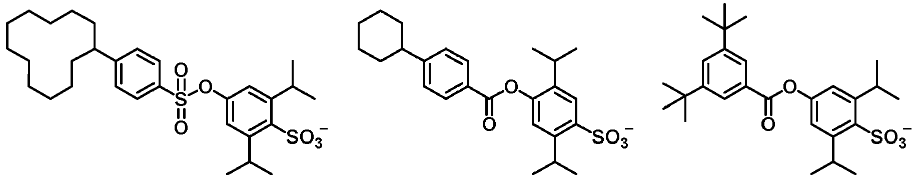

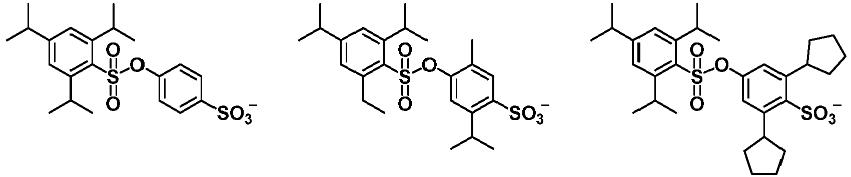

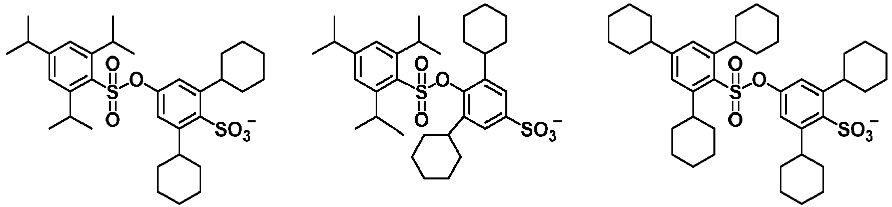

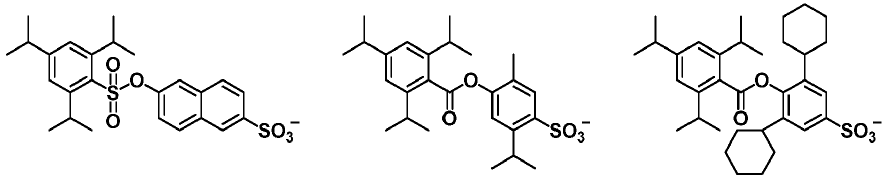

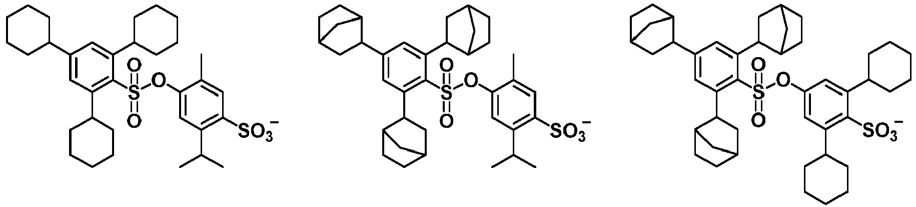

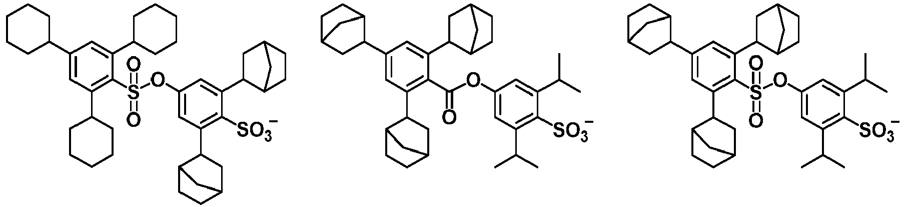

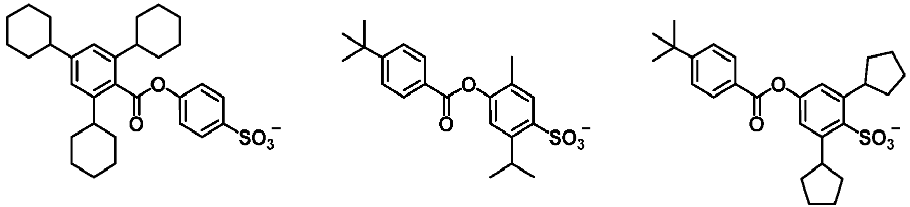

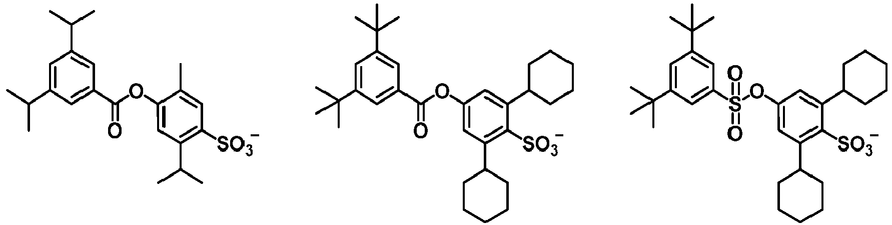

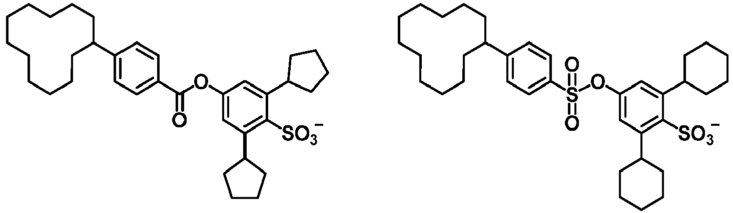

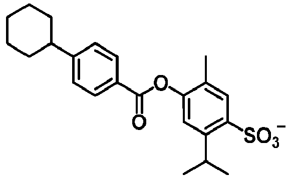

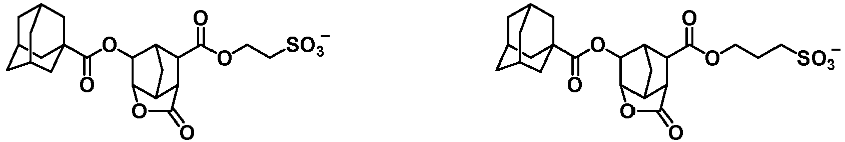

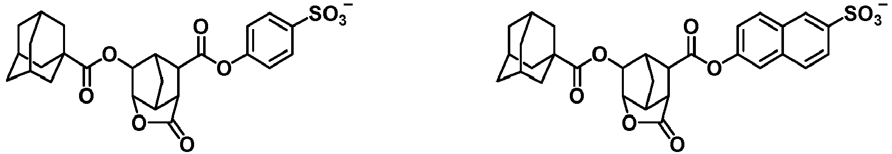

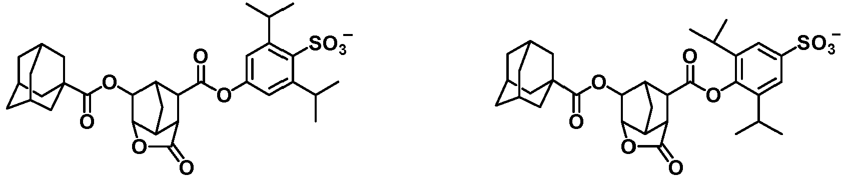

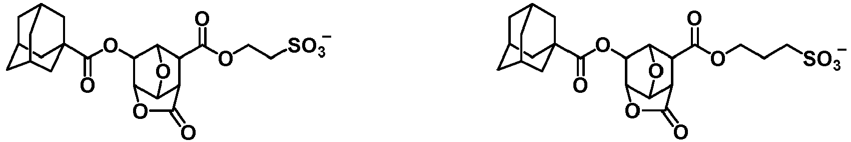

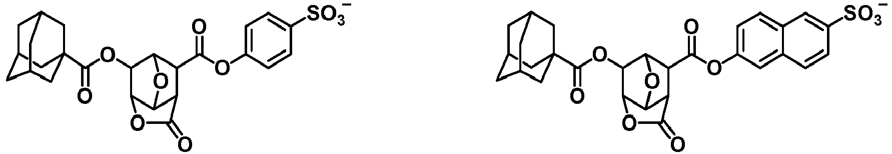

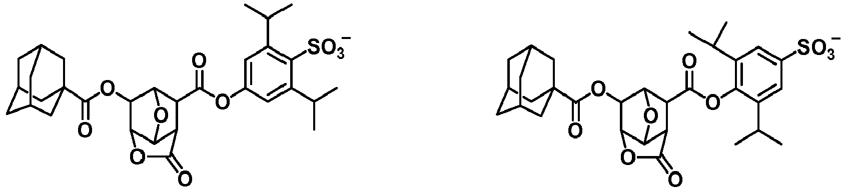

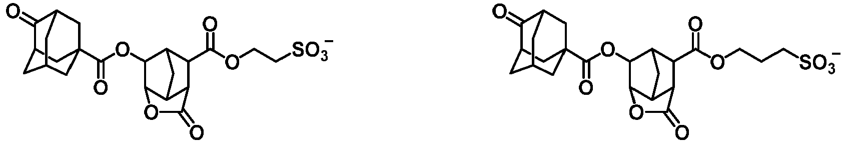

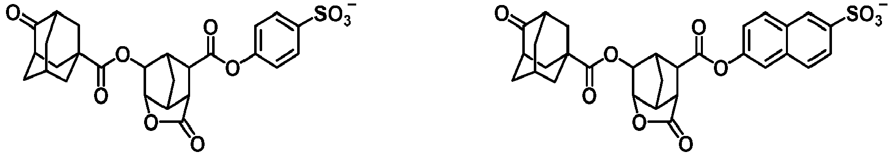

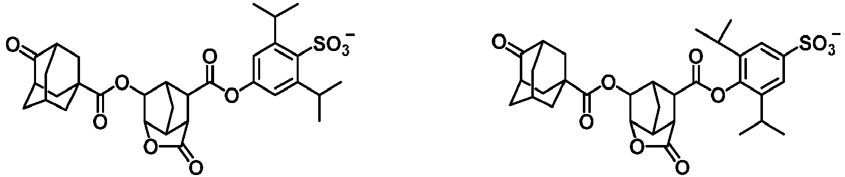

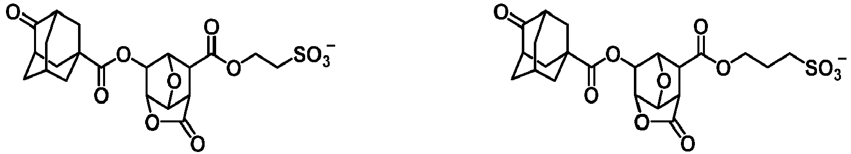

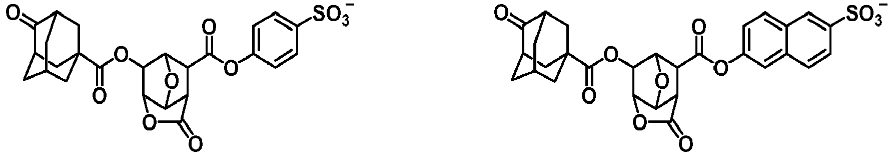

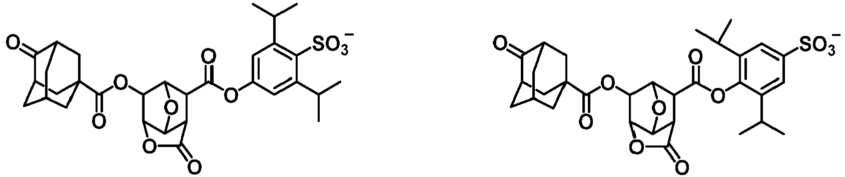

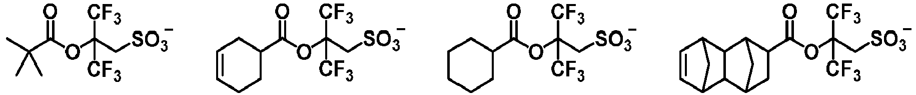

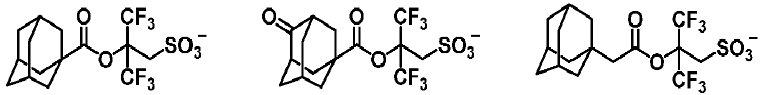

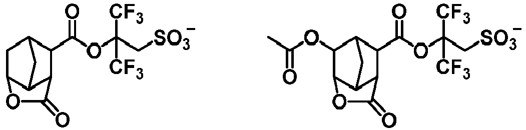

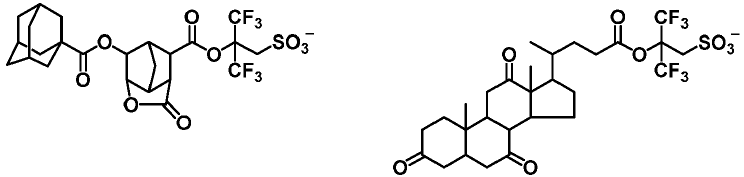

When the resist composition contains the PAG (C), an appropriate amount of the PAG used is 1 to 30 parts, more preferably 2 to 20 parts by weight per 80 parts by weight of the base polymer. In the embodiment wherein the base polymer contains repeat units B6 to B13, that is, in the case of polymer-bound acid generator, the addition of PAG (C) may be omitted. The PAG may be used alone or in admixture.

In the embodiment wherein the chemically amplified positive resist composition contains the quencher (A) and the PAG (C), the PAG (C) and the quencher (A) are preferably present in a weight ratio (C/A) of less than 6/1, more preferably less than 5/1, even more preferably less than 4/1. As long as the ratio of PAG (C) to quencher (A) is in the range, it is possible to fully suppress acid diffusion, leading to improved resolution and dimensional uniformity.

### (D) Fluorinated polymer

The positive resist composition may further comprise a fluorinated polymer which contains repeat units of at least one type selected from repeat units having the formula (D1), repeat units having the formula (D2), repeat units having the formula (D3), and repeat units having the formula (D4), and which may contain repeat units of at least one type selected from repeat units having the formula (D5) and repeat units having the formula (D6), for the purposes of enhancing contrast, preventing chemical flare of acid upon exposure to high-energy radiation, preventing mixing of acid from an anti-charging film in the step of coating an anti-charging film-forming material on a resist film, and suppressing unexpected unnecessary pattern degradation. It is noted that repeat units having formulae (D1), (D2), (D3), (D4), (D5), and (D6) are also referred to as repeat units D1, D2, D3, D4, D5, and D6, respectively, hereinafter. Since the fluorinated polymer also has a surface active function, it can prevent insoluble residues from re-depositing onto the substrate during the development step and is thus effective for preventing development defects.

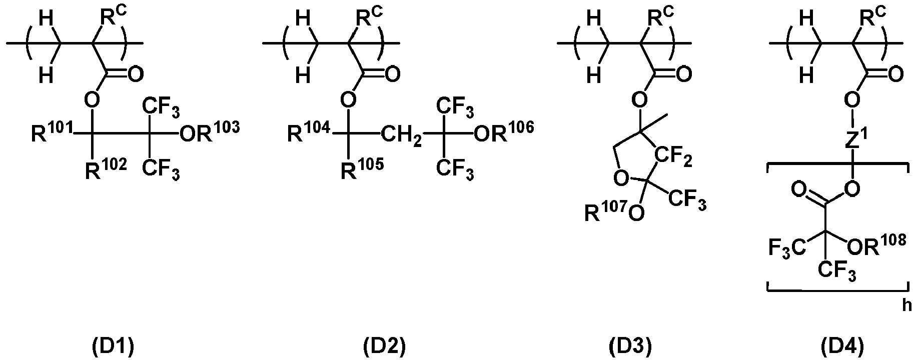

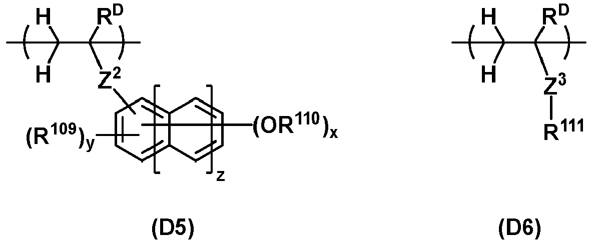

In formulae (D1) to (D6), R^{C} is each independently hydrogen, fluorine, methyl or trifluoromethyl. R^{D} is each independently hydrogen or methyl. R¹⁰¹, R¹⁰², R¹⁰⁴ and R¹⁰⁵ are each independently hydrogen or a C₁-C₁₀ saturated hydrocarbyl group. R¹⁰³, R¹⁰⁶, R¹⁰⁷ and R¹⁰⁸ are each independently hydrogen, a C₁-C₁₅ hydrocarbyl group or fluorinated hydrocarbyl group, or an acid labile group, with the proviso that an ether bond or carbonyl moiety may intervene in a carbon-carbon bond in the hydrocarbyl groups or fluorinated hydrocarbyl groups represented by R¹⁰³, R¹⁰⁶, R¹⁰⁷ and R¹⁰⁸. R¹⁰⁹ is hydrogen or a C₁-C₅ straight or branched hydrocarbyl group in which a heteroatom-containing moiety may intervene in a carbon-carbon bond. R¹¹⁰ is a C₁-C₅ straight or branched hydrocarbyl group in which a heteroatom-containing moiety may intervene in a carbon-carbon bond. R¹¹¹ is a C₁-C₂₀ saturated hydrocarbyl group in which at least one hydrogen is substituted by fluorine and some constituent -CH₂- may be replaced by an ester bond or ether bond. The subscript x is an integer of 1 to 3, y is an integer satisfying: 0 ≤ y ≤ 5+2z-x, z is 0 or 1, and h is an integer of 1 to 3. Z¹ is a C₁-C₂₀ (h+1)-valent hydrocarbon group or C₁-C₂₀ (h+1)-valent fluorinated hydrocarbon group. Z² is a single bond, *-C(=O)-O- or *-C(=O)-NH- wherein the asterisk (*) designates a point of attachment to the carbon atom in the backbone. Z³ is a single bond, -O-, ^{∗}-C(=O)-O-Z³¹-Z³²- or ^{∗}-C(=O)-NH-Z³¹-Z³²-, wherein Z³¹ is a single bond or a C₁-C₁₀ saturated hydrocarbylene group, Z³² is a single bond, ester bond, ether bond or sulfonamide bond, and the asterisk (*) designates a point of attachment to the carbon atom in the backbone.

In formulae (D1) and (D2), examples of the C₁-C₁₀ saturated hydrocarbyl group represented by R¹⁰¹, R¹⁰², R¹⁰⁴ and R¹⁰⁵ include C₁-C₁₀ alkyl groups such as methyl, ethyl, n-propyl, isopropyl, n-butyl, isobutyl, sec-butyl, tert-butyl, n-pentyl, n-hexyl, n-heptyl, n-octyl, n-nonyl, and n-decyl, and C₃-C₁₀ cyclic saturated hydrocarbyl groups such as cyclopropyl, cyclobutyl, cyclopentyl, cyclohexyl, adamantyl, and norbornyl. Inter alia, C₁-C₆ saturated hydrocarbyl groups are preferred.

In formulae (D1) to (D4), examples of the C₁-C₁₅ hydrocarbyl group represented by R¹⁰³, R¹⁰⁶, R¹⁰⁷ and R¹⁰⁸ include C₁-C₁₅ alkyl, C₂-C₁₅ alkenyl and C₂-C₁₅ alkynyl groups, with the alkyl groups being preferred. Suitable alkyl groups include methyl, ethyl, n-propyl, isopropyl, n-butyl, isobutyl, sec-butyl, n-pentyl, n-hexyl, n-heptyl, n-octyl, n-nonyl, n-decyl, n-undecyl, n-dodecyl, n-tridecyl, n-tetradecyl and n-pentadecyl. The fluorinated hydrocarbyl groups correspond to the foregoing hydrocarbyl groups in which some or all carbon-bonded hydrogen atoms are substituted by fluorine atoms.

In formula (D4), examples of the C₁-C₂₀ (h+1)-valent hydrocarbon group Z¹ include the foregoing C₁-C₂₀ alkyl groups and C₃-C₂₀ cyclic saturated hydrocarbyl groups, with h number of hydrogen atoms being eliminated. Examples of the C₁-C₂₀ (h+1)-valent fluorinated hydrocarbon group Z¹ include the foregoing (h+1)-valent hydrocarbon groups in which at least one hydrogen atom is substituted by fluorine.

Examples of the repeat units D1 to D4 are given below, but not limited thereto. Herein R^{C} is as defined above.

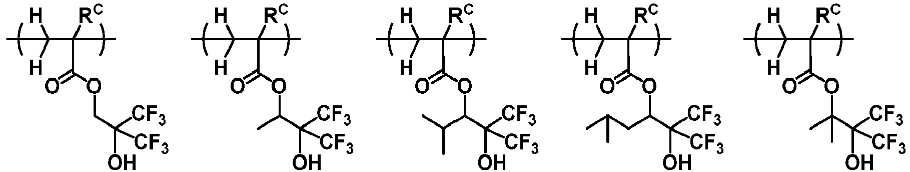

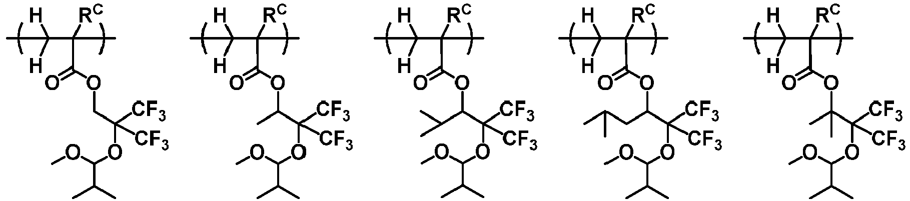

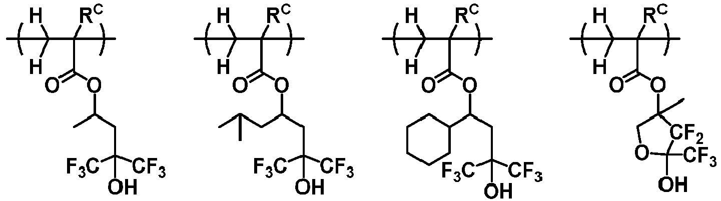

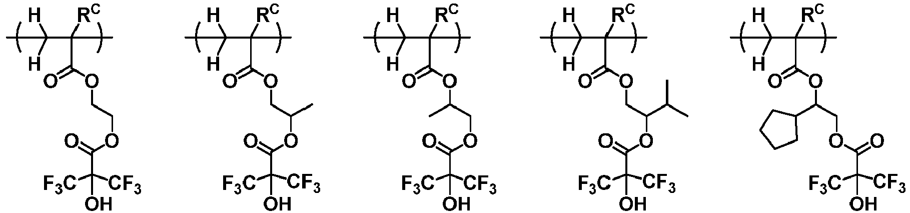

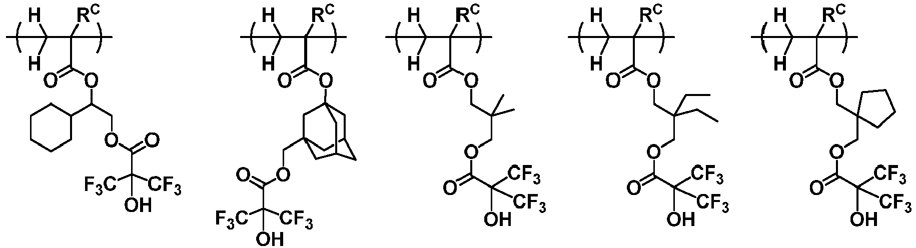

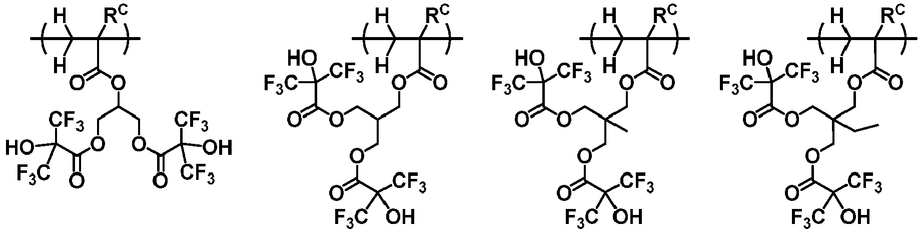

In formula (D5), examples of the C₁-C₅ hydrocarbyl groups R¹⁰⁹ and R¹¹⁰ include alkyl, alkenyl and alkynyl groups, with the alkyl groups being preferred. Suitable alkyl groups include methyl, ethyl, n-propyl, isopropyl, n-butyl, isobutyl, sec-butyl, and n-pentyl. In the hydrocarbyl groups, a moiety containing a heteroatom such as oxygen, sulfur or nitrogen may intervene in a carbon-carbon bond.

In formula (D5), -OR¹⁰⁹ is preferably a hydrophilic group. In this case, R¹⁰⁹ is preferably hydrogen or a C₁-C₅ alkyl group in which oxygen intervenes in a carbon-carbon bond.

In formula (D5), Z² is preferably *-C(=O)-O- or *-C(=O)-NH-. Also preferably R^{D} is methyl. The inclusion of carbonyl in Z² enhances the ability to trap the acid originating from the anti-charging film. A polymer wherein R^{D} is methyl is a robust polymer having a high Tg which is effective for suppressing acid diffusion. As a result, the resist film is improved in stability with time, and neither resolution nor pattern profile is degraded.

Examples of the repeat unit D5 are given below, but not limited thereto. Herein R^{D} is as defined above.

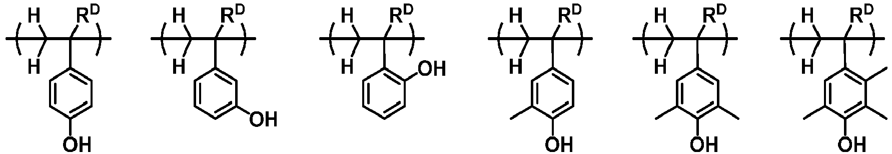

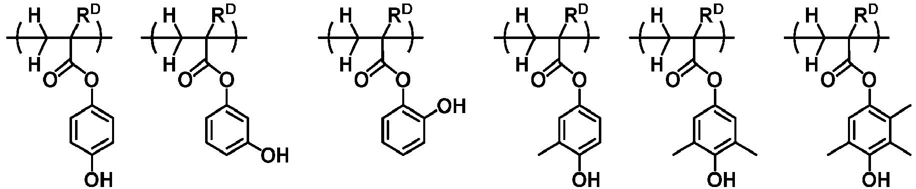

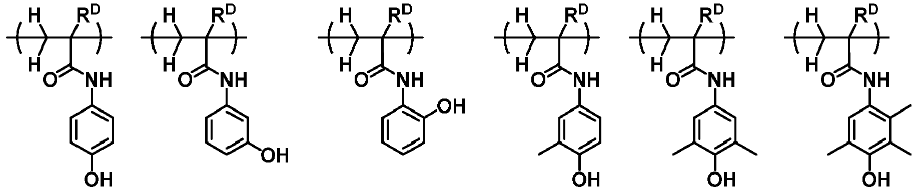

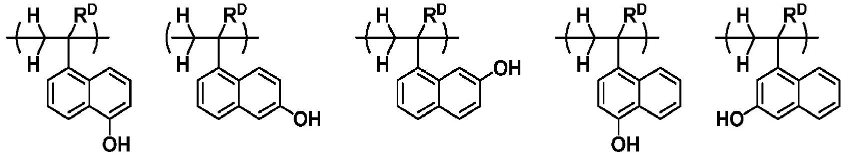

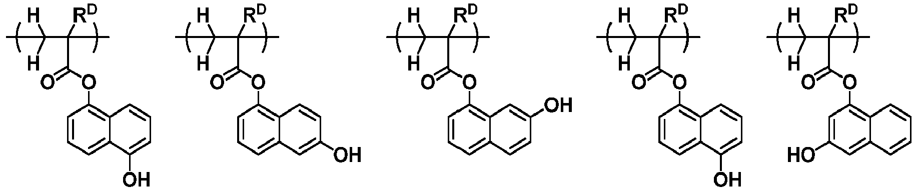

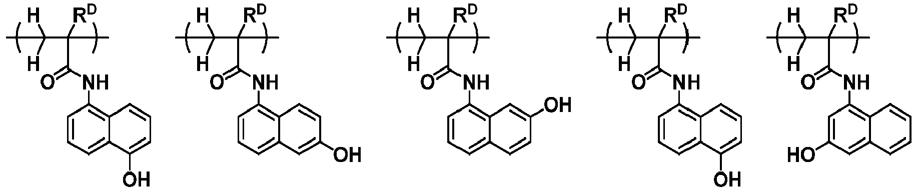

In formula (D6), the C₁-C₁₀ saturated hydrocarbylene group Z³ may be straight, branched or cyclic and examples thereof include methanediyl, ethane-1,1-diyl, ethane-1,2-diyl, propane-1,1-diyl, propane-1,2-diyl, propane-1,3-diyl, propane-2,2-diyl, butane-1,1-diyl, butane-1,2-diyl, butane-1,3-diyl, butane-2,3-diyl, butane-1,4-diyl, and 1,1-dimethylethane-1,2-diyl.

The C₁-C₂₀ saturated hydrocarbyl group having at least one hydrogen substituted by fluorine, represented by R¹¹¹, may be straight, branched or cyclic and examples thereof include C₁-C₂₀ alkyl groups and C₃-C₂₀ cyclic saturated hydrocarbyl groups in which at least one hydrogen is substituted by fluorine.

Examples of the repeat unit D6 are given below, but not limited thereto. Herein R^{D} is as defined above.

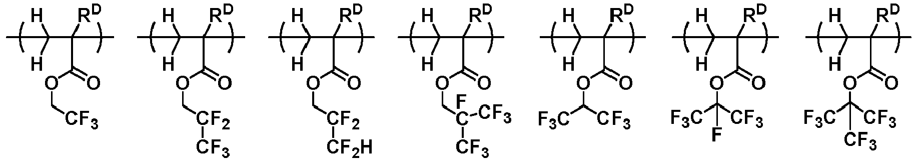

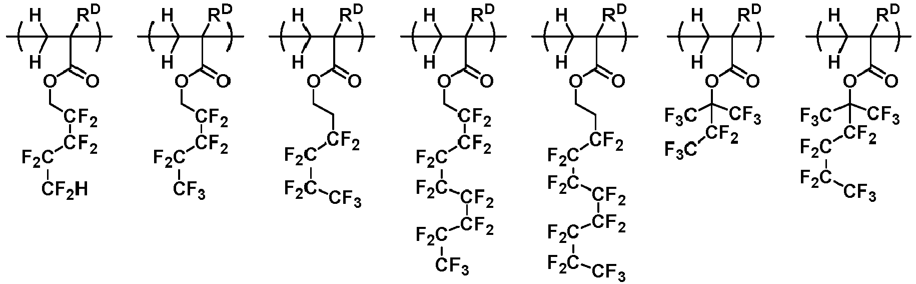

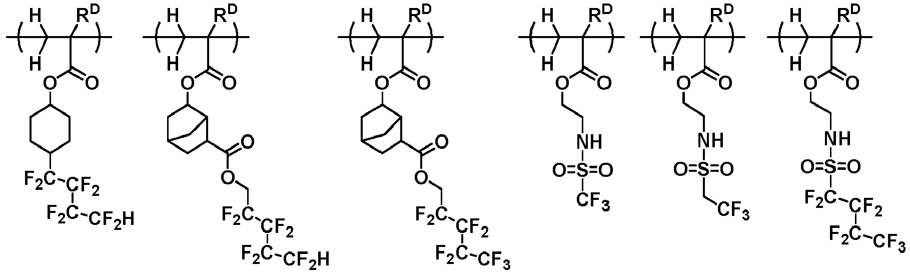

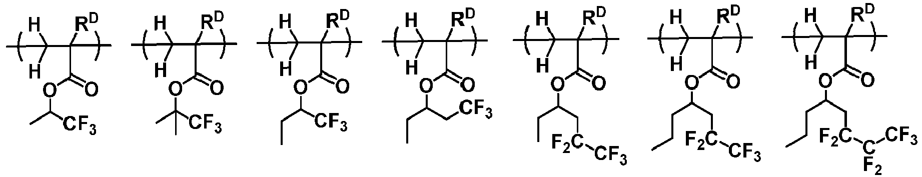

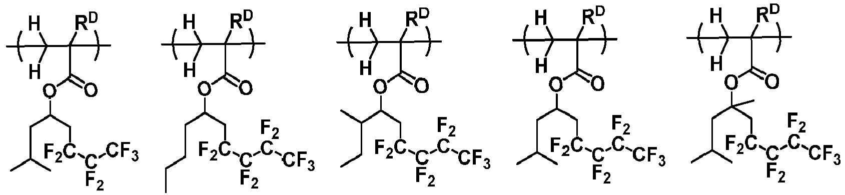

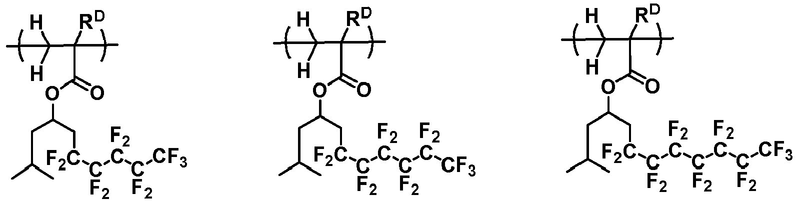

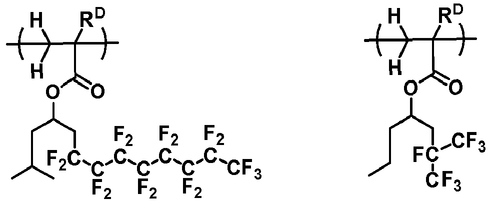

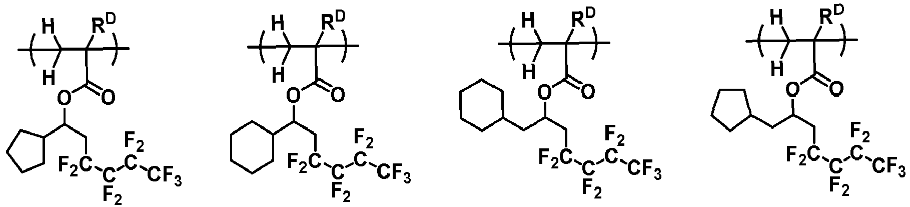

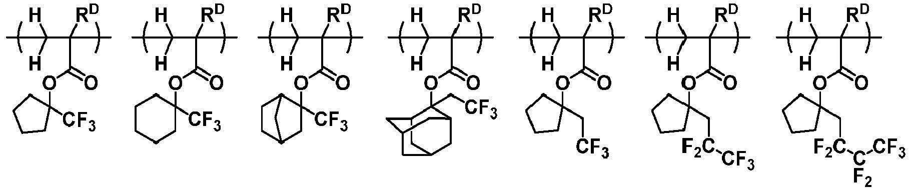

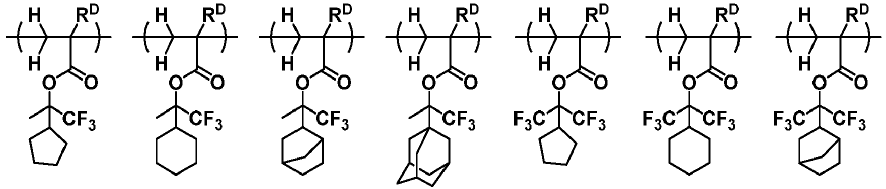

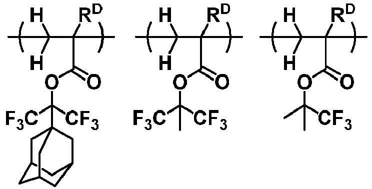

The repeat units D1 to D4 are preferably incorporated in an amount of 15 to 95 mol%, more preferably 20 to 85 mol% based on the overall repeat units of the fluorinated polymer. The repeat unit D5 and/or D6 is preferably incorporated in an amount of 5 to 85 mol%, more preferably 15 to 80 mol% based on the overall repeat units of the fluorinated polymer. Each of repeat units D1 to D6 may be used alone or in admixture.

The fluorinated polymer may comprise additional repeat units as well as the repeat units D1 to D6. Suitable additional repeat units include those described in USP 9,091,918 (JP-A 2014-177407, paragraphs [0046]-[0078]). When the fluorinated polymer comprises additional repeat units, their content is preferably up to 50 mol% based on the overall repeat units.

The fluorinated polymer may be synthesized by combining suitable monomers optionally protected with a protective group, copolymerizing them in the standard way, and effecting deprotection reaction if necessary. The copolymerization reaction is preferably radical or anionic polymerization though not limited thereto. For the polymerization reaction, reference may be made to JP-A 2004-115630.

The fluorinated polymer should preferably have a Mw of 2,000 to 50,000, and more preferably 3,000 to 20,000. A fluorinated polymer with a Mw of less than 2,000 helps acid diffusion, degrading resolution and detracting from age stability. A polymer with too high Mw has a reduced solubility in solvent, with a risk of leaving coating defects. The fluorinated polymer preferably has a dispersity (Mw/Mn) of 1.0 to 2.2, more preferably 1.0 to 1.7.

When the fluorinated polymer (D) is added to the positive resist composition, it is preferably used in an amount of 0.01 to 30 parts, more preferably 0.1 to 20 parts, even more preferably 0.5 to 10 parts by weight per 80 parts by weight of the base polymer (B).

### (E) Organic solvent

The chemically amplified positive resist composition may further comprise an organic solvent as component (E). The organic solvent used herein is not particularly limited as long as the components are soluble therein. Examples of the organic solvent are described in JP-A 2008-111103, paragraphs [0144] to [0145] (USP 7,537,880). Specifically, exemplary solvents include ketones such as cyclohexanone, cyclopentanone, methyl-2-n-pentyl ketone and 2-heptanone; alcohols such as 3-methoxybutanol, 3-methyl-3-methoxybutanol, 1-methoxy-2-propanol, 1-ethoxy-2-propanol, and diacetone alcohol; ethers such as propylene glycol monomethyl ether (PGME), ethylene glycol monomethyl ether, propylene glycol monoethyl ether, ethylene glycol monoethyl ether, propylene glycol dimethyl ether, and diethylene glycol dimethyl ether; esters such as propylene glycol monomethyl ether acetate (PGMEA), propylene glycol monoethyl ether acetate, ethyl lactate (EL), ethyl pyruvate, butyl acetate, methyl 3-methoxypropionate, ethyl 3-ethoxypropionate, t-butyl acetate, t-butyl propionate, and propylene glycol mono-t-butyl ether acetate; and lactones such as γ-butyrolactone (GBL), and mixtures thereof. Where an acid labile group of acetal form is used, a high boiling alcohol solvent such as diethylene glycol, propylene glycol, glycerol, 1,4-butanediol or 1,3-butanediol may be added to accelerate deprotection reaction of acetal.

Of the above organic solvents, it is recommended to use 1-ethoxy-2-propanol, PGMEA, PGME, cyclohexanone, EL, GBL, and mixtures thereof.

In the positive resist composition, the organic solvent (E) is preferably used in an amount of 200 to 10,000 parts, more preferably 400 to 5,000 parts by weight per 80 parts by weight of the base polymer (B). The organic solvent may be used alone or in admixture.

### (F) Basic compound

In the positive resist composition, (F) a basic compound may be added as the quencher other than component (A) for the purpose of correcting a pattern profile or the like. The basic compound is effective for controlling acid diffusion. Even when the resist film is applied to a substrate having an outermost surface layer made of a material containing chromium, tantalum or silicon, the basic compound is effective for minimizing the influence of the acid generated in the resist film on the substrate.

Numerous basic compounds are known useful including primary, secondary, and tertiary aliphatic amines, mixed amines, aromatic amines, heterocyclic amines, nitrogen-containing compounds with carboxy group, nitrogen-containing compounds with sulfonyl group, nitrogen-containing compounds with hydroxy group, nitrogen-containing compounds with hydroxyphenyl group, alcoholic nitrogen-containing compounds, amide derivatives, imide derivatives, carbamate derivatives, and ammonium salts. Examples are described in Patent Document 9, for example, and any such compounds are useful. Of the foregoing basic compounds, preferred are tris[2-(methoxymethoxy)ethyl]amine, tris[2-(methoxymethoxy)ethyl]amine-N-oxide, dibutylaminobenzoic acid, morpholine derivatives and imidazole derivatives.

In the positive resist composition, the basic compound (F) is preferably added in an amount of 0 to 10 parts, and more preferably 0 to 5 parts by weight per 80 parts by weight of the base polymer (B). The basic compounds may be used alone or in admixture.

### (G) Surfactant

The positive resist composition may contain any conventional surfactants for facilitating to coat the composition to the substrate. A number of surfactants are known in the art as described in JP-A 2004-115630, and any suitable one may be chosen therefrom. The amount of the surfactant (F) added is preferably 0 to 5 parts by weight per 80 parts by weight of the base polymer (B). The surfactant may be used alone or in admixture.

### Process

Another embodiment of the invention is a resist pattern forming process comprising the steps of applying the chemically amplified positive resist composition defined above onto a substrate to form a resist film thereon, exposing the resist film patternwise to high-energy radiation, and developing the exposed resist film in an alkaline developer to form a resist pattern.

The substrate used herein may be selected from, for example, substrates for IC fabrication, e.g., Si, SiO, SiO₂, SiN, SiON, TiN, WSi, BPSG, SOG, and organic antireflective coating, and substrates for mask circuit fabrication, e.g., Cr, CrO, CrON, MoSi₂, Si, SiO, SiO₂, SiON, SiONC, CoTa, NiTa, TaBN, and SnO₂.

First the resist composition is applied onto a substrate by a suitable coating technique such as spin coating. The coating is prebaked on a hotplate preferably at a temperature of 60 to 150°C for 1 to 20 minutes, more preferably at 80 to 140°C for 1 to 10 minutes to form a resist film of 0.03 to 2 µm thick.

Then the resist film is exposed patternwise to high-energy radiation such as UV, deep-UV, excimer laser (KrF, ArF), EUV, x-ray, γ-ray, synchrotron radiation or EB. The resist composition of the invention is especially effective in the EUV or EB lithography.

On use of UV, deep-UV, EUV, excimer laser, x-ray, γ-ray or synchrotron radiation as the high-energy radiation, the resist film is exposed through a mask having a desired pattern, preferably in a dose of 1 to 500 mJ/cm², more preferably 10 to 400 mJ/cm². On use of EB, a pattern may be written directly in a dose of preferably 1 to 500 µC/cm², more preferably 10 to 400 µC/cm².

The exposure may be performed by conventional lithography whereas the immersion lithography of holding a liquid, typically water between the mask and the resist film may be employed if desired. In the immersion lithography, a protective film which is insoluble in water may be used.

The resist film is then baked (PEB) on a hotplate preferably at 60 to 150°C for 1 to 20 minutes, more preferably at 80 to 140°C for 1 to 10 minutes.

Thereafter, the resist film is developed with a developer in the form of an aqueous base solution, for example, 0.1 to 5 wt%, preferably 2 to 3 wt% aqueous solution of tetramethylammonium hydroxide (TMAH) preferably for 0.1 to 3 minutes, more preferably 0.5 to 2 minutes by conventional techniques such as dip, puddle and spray techniques. In this way, a desired resist pattern is formed on the substrate.

From the positive resist composition, a pattern with a high resolution and reduced LER can be formed. The resist composition is effectively applicable to a substrate, specifically a substrate having a surface layer of material to which a resist film is less adherent and which is likely to invite pattern stripping or pattern collapse, and particularly a substrate having sputter deposited on its outermost surface metallic chromium or a chromium compound containing at least one light element selected from oxygen, nitrogen and carbon or a substrate having an outermost surface layer of SiO, SiOₓ, or a tantalum compound, molybdenum compound, cobalt compound, nickel compound, tungsten compound or tin compound. The substrate to which the positive resist composition is applied is most typically a photomask blank which may be either of transmission or reflection type.

The mask blank of transmission type is typically a photomask blank having a light-shielding film of chromium-based material. It may be either a photomask blank for binary masks or a photomask blank for phase shift masks. In the case of the binary mask-forming photomask blank, the light-shielding film may include an antireflection layer of chromium-based material and a light-shielding layer. In one example, the antireflection layer on the surface layer side is entirely composed of a chromium-based material. In an alternative example, only a surface side portion of the antireflection layer on the surface layer side is composed of a chromium-based material and the remaining portion is composed of a silicon compound-based material which may contain a transition metal. In the case of the phase shift mask-forming photomask blank, it may include a phase shift film and a chromium-based light-shielding film thereon.

Photomask blanks having an outermost layer of chromium base material are well known as described in JP-A 2008-026500 and JP-A 2007-302873 and the references cited therein. Although the detail description is omitted herein, the following layer construction may be employed when a light-shielding film including an antireflective layer and a light-shielding layer is composed of chromium base materials.

In the example where a light-shielding film including an antireflective layer and a light-shielding layer is composed of chromium base materials, layers may be stacked in the order of an antireflective layer and a light-shielding layer from the outer surface side, or layers may be stacked in the order of an antireflective layer, a light-shielding layer, and an antireflective layer from the outer surface side. Each of the antireflective layer and the light-shielding layer may be composed of multiple sub-layers. When the sub-layers have different compositions, the composition may be graded discontinuously or continuously from sub-layer to sub-layer. The chromium base material used herein may be metallic chromium or a material consisting of metallic chromium and a light element such as oxygen, nitrogen or carbon. Examples used herein include metallic chromium, chromium oxide, chromium nitride, chromium carbide, chromium oxynitride, chromium oxycarbide, chromium nitride carbide, and chromium oxide nitride carbide.

The mask blank of reflection type includes a substrate, a multilayer reflective film formed on one major surface (front surface) of the substrate, for example, a multilayer reflective film of reflecting exposure radiation such as EUV radiation, and an absorber film formed on the multilayer reflective film, for example, an absorber film of absorbing exposure radiation such as EUV radiation to reduce reflectivity. From the reflection type mask blank (reflection type mask blank for EUV lithography), a reflection type mask (reflection type mask for EUV lithography) having an absorber pattern (patterned absorber film) formed by patterning the absorber film is produced. The EUV radiation used in the EUV lithography has a wavelength of 13 to 14 nm, typically about 13.5 nm.

The multilayer reflective film is preferably formed contiguous to one major surface of a substrate. An underlay film may be disposed between the substrate and the multilayer reflective film as long as the benefits of the invention are not lost. The absorber film may be formed contiguous to the multilayer reflective film while a protective film (protective film for the multilayer reflective film) may be disposed between the multilayer reflective film and the absorber film, preferably contiguous to the multilayer reflective film, more preferably contiguous to the multilayer reflective film and the absorber film. The protective film is used for protecting the multilayer reflective film in a cleaning, tailoring or otherwise processing step. Also preferably, the protective film has an additional function of protecting the multilayer reflective film or preventing the multilayer reflective film from oxidation during the step of patterning the absorber film by etching. Besides, an electroconductive film, which is used for electrostatic chucking of the reflection type mask to an exposure tool, may be disposed below the other major surface (back side surface) which is opposed to the one major surface of the substrate, preferably contiguous to the other major surface. It is provided herein that a substrate has one major surface which is a front or upper side surface and another major surface which is a back or lower side surface. The terms "front and back" sides or "upper and lower" sides are used for the sake of convenience. One or another major surface may be either of the two major surfaces (film-bearing surfaces) of a substrate, and in this sense, front and back or upper and lower are exchangeable. Specifically, the multilayer reflective film may be formed by any of the methods of JP-A 2021-139970 and the references cited therein.

Even on a substrate (typically mask blank) whose outermost surface is made of a material tending to affect resist pattern profile such as a chromium or silicon-containing material, the resist pattern forming process is successful in forming patterns having a high resolution, reduced LER, fidelity and improved dose margin because the resist composition is effective for controlling acid diffusion at the substrate interface.

### EXAMPLES

Examples of the invention are given below by way of illustration and not by way of limitation. The abbreviation "pbw" is parts by weight. For copolymers, the compositional ratio is a molar ratio and Mw is determined by GPC versus polystyrene standards.

Chemically amplified positive resist compositions were prepared using a quencher or comparative quencher, acid generator, polymer, and fluorinated polymer.

Quenchers Q-1 to Q-8 have the following structure.

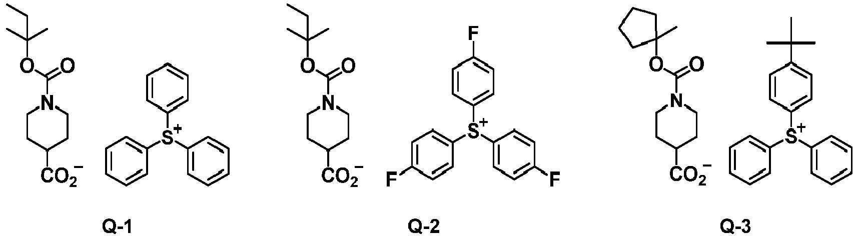

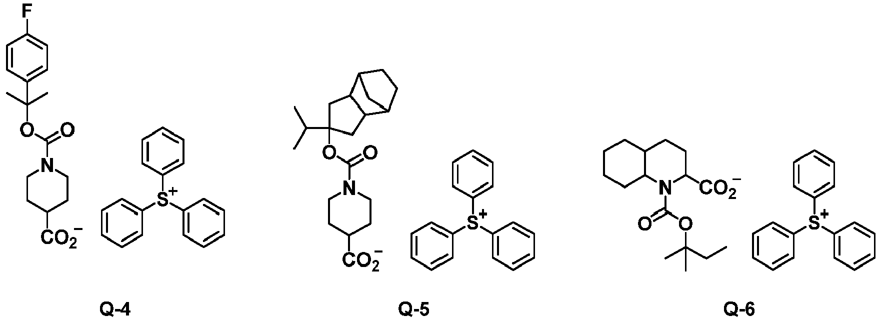

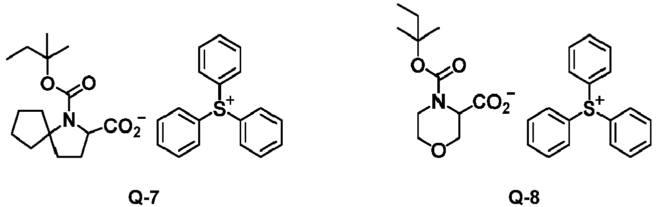

Comparative quenchers cQ-1 to cQ-3 have the following structure.

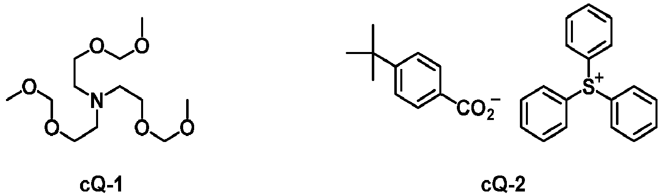

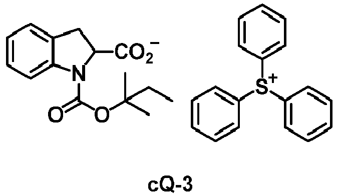

Polymers A-1 to A-14 and Polymers P-1 to P-5 have the following structure.

| | |
|---|---|
| A-1 (a=0.76, b=0.12, c=0.12, Mw=5500) | A-2 (a=0.76, b=0.11, c=0.13, Mw=6800) |
| 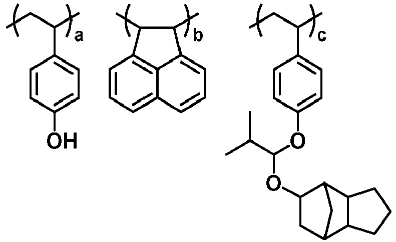 | 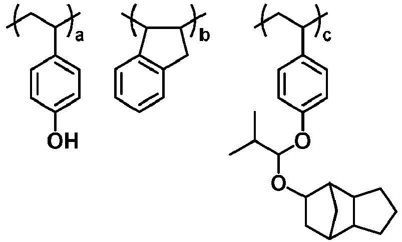 |
| A-3 (a=0.78, b=0.11, c=0.11, Mw=5500) | A-4 (a=0.69, b=0.10, c=0.21, Mw=4000) |
| 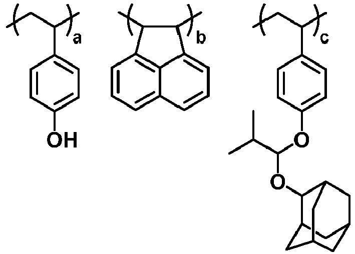 | 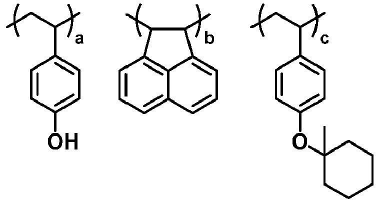 |
| A-5 (a=0.73, b=0.12, c=0.15, Mw=5700) | A-6 (a=0.73, b=0.13, c=0.14, Mw=5400) |
| 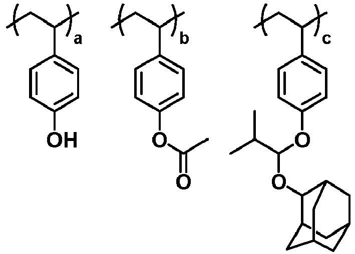 | 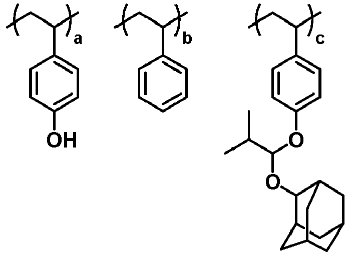 |
| A-7 (a=0.73, b=0.13, c=0.14, Mw=5400) | A-8 (a=0.65, b=0.10, c=0.25, Mw=5600) |
| 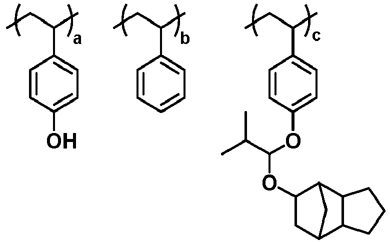 | 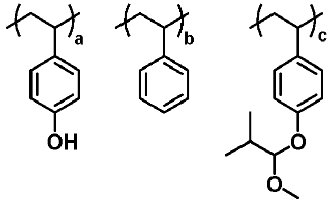 |
| A-9 (a=0.65, b=0.10, c=0.25, Mw=5500) | A-10 (a=0.60, b=0.10, c=0.30, Mw=5200) |
| 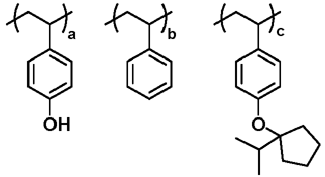 | 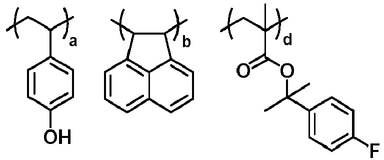 |
| A-11 (a=0.65, b=0.10, c=0.25, Mw=5100) | A-12 (a=0.65, b=0.10, c=0.10, d=0.15, Mw=5200) |
| 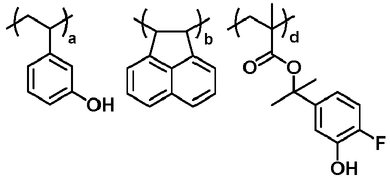 | 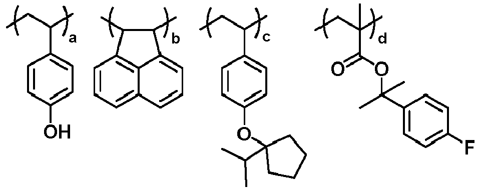 |
| A-13 (a=0.70, b=0.15, c=0.15, Mw=4700) | A-14 (a=0.75, b=0.25, Mw=4500) |
| 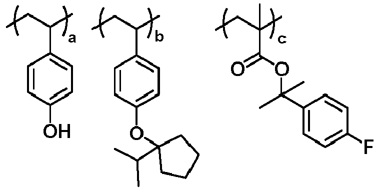 | 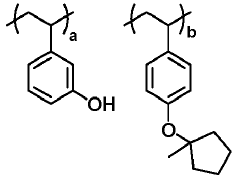 |
| P-1 (a=0.15, b=0.20, c=0.05, d=0.60, Mw=14500) | |
| 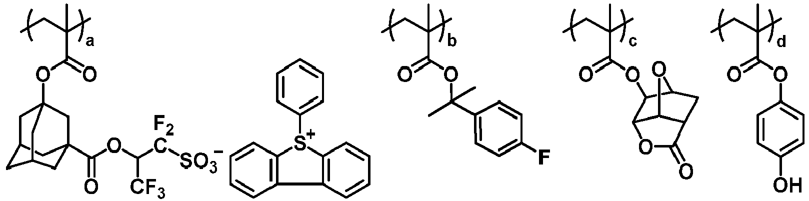 | |
| P-2 (a=0.55, b=0.10, c=0.25, d=0.10, Mw=17200) | |
| 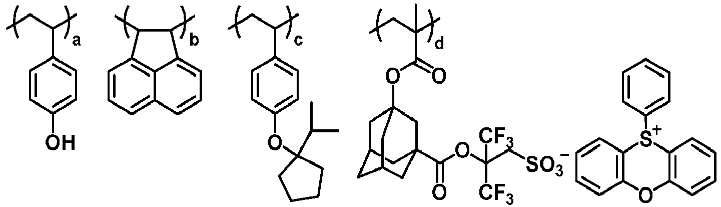 | |
| P-3 (a=0.60, b=0.10, c=0.25, d=0.05, Mw=16700) | |
| 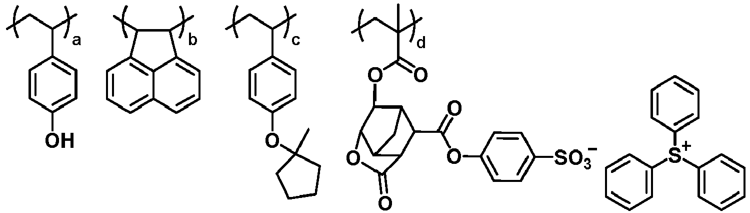 | |
| P-4 (a=0.65, b=0.30, c=0.05, Mw=18500) | |
| 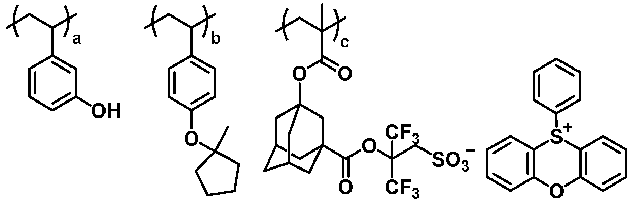 | |
| P-5 (a=0.65, b=0.30, c=0.05, Mw=19500) | |
| 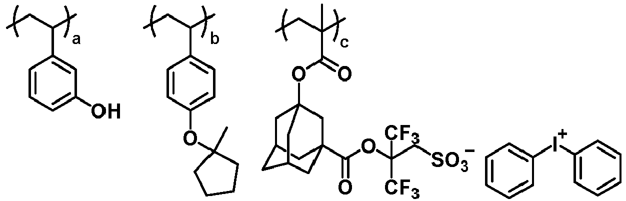 | |

Acid generators PAG-A to PAG-D have the following structure.

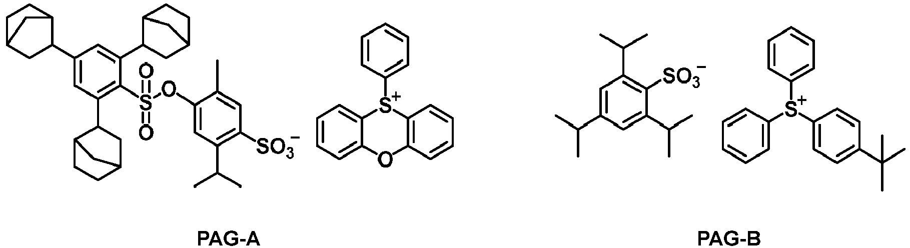

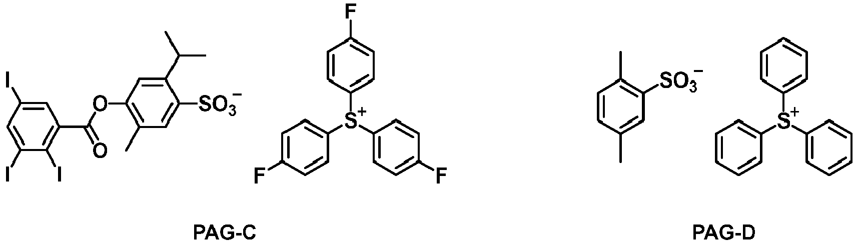

Fluorinated Polymers B-1 to B-5 have the following structure.

| | | |
|---|---|---|
| B-1 (a=0.80, b=0.20, Mw=6000) | B-2 (a=0.80, b=0.20, Mw=6400) | B-3 (a=0.80, b=0.20, Mw=6500) |
| 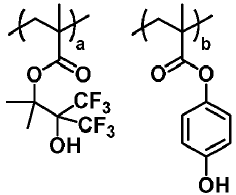 | 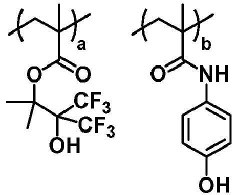 | 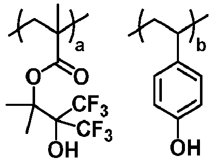 |
| B-4 (a=0.80, b=0.20, Mw=8200) | B-5 (a=1.0, Mw=8600) | |
| 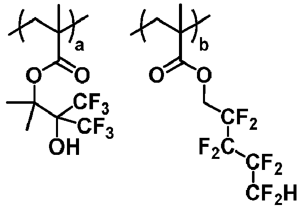 | 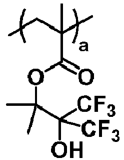 | |

### [1] Preparation of chemically amplified positive resist compositions

### Examples 1-1 to 1-40 and Comparative Examples 1-1 to 1-4

Chemically amplified positive resist compositions (R-1 to R-40, CR-1 to CR-4) were prepared by dissolving selected components in an organic solvent in accordance with the formulation shown in Tables 1 to 3, and filtering the solution through a UPE filter or nylon filter with a pore size of 10 nm, 5 nm, 3 nm or 1 nm. The organic solvent was a mixture of 900 pbw of PGMEA, 1,800 pbw of EL, and 1,800 pbw of PGME.

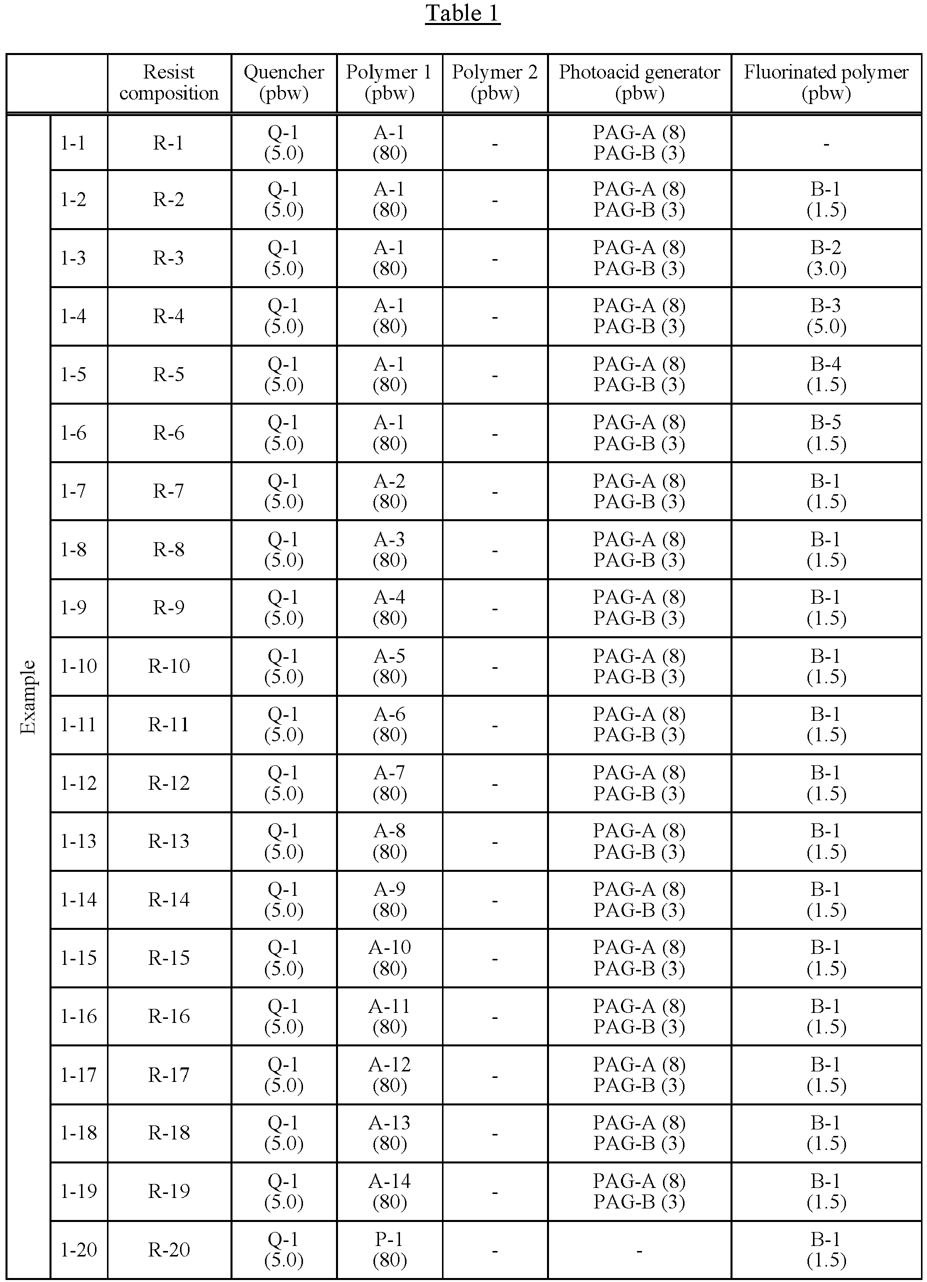

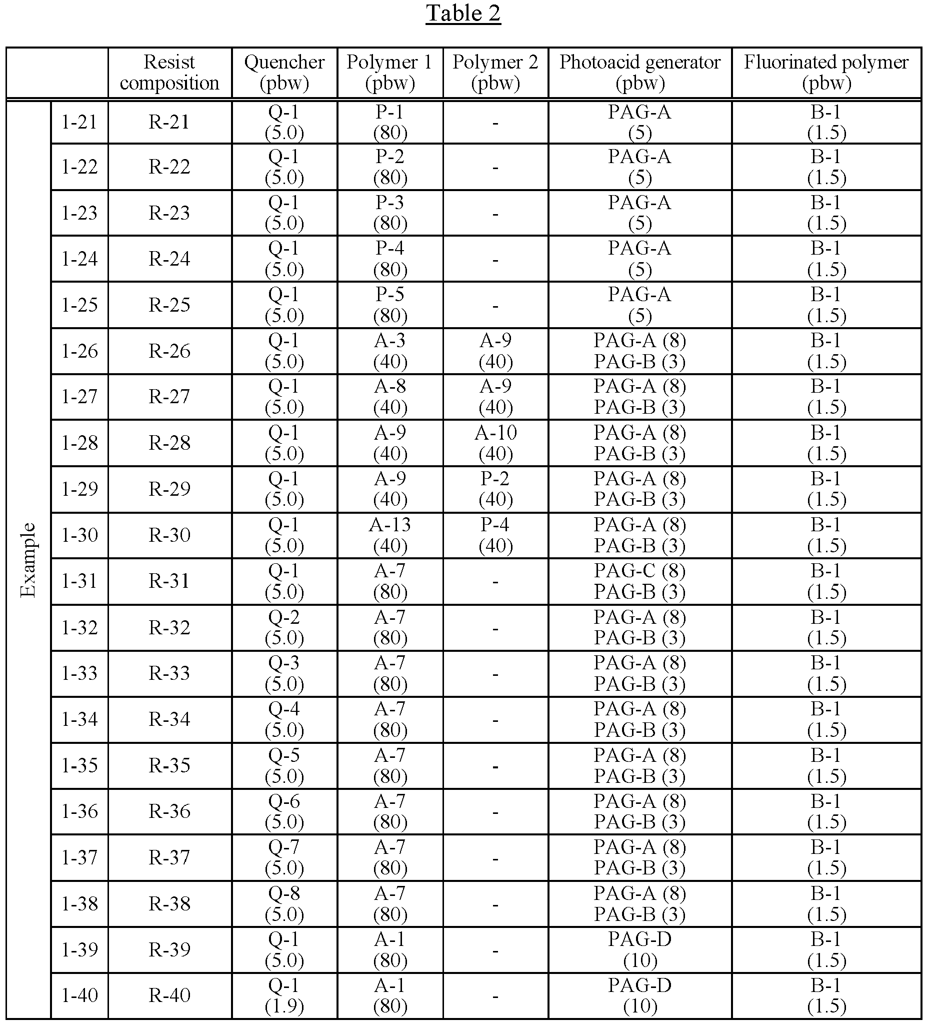

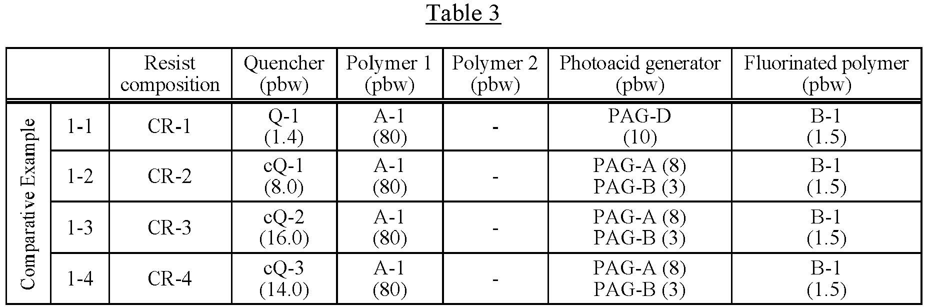

### [2] EB lithography test

### Examples 2-1 to 2-40 and Comparative Examples 2-1 to 2-4

Using a coater/developer system ACT-M (Tokyo Electron Ltd.), each of the positive resist compositions (R-1 to R-40 and CR-1 to CR-4) was spin coated onto a mask blank of 152 mm squares having the outermost surface in the form of a silicon oxide film, which had been vapor primed with hexamethyldisilazane (HMDS), and prebaked on a hotplate at 110°C for 600 seconds to form a resist film of 80 nm thick. The thickness of the resist film was measured by an optical film thickness measurement system Nanospec (Nanometrics Inc.). Measurement was made at 81 points in the plane of the blank substrate excluding a peripheral band extending 10 mm inward from the blank periphery, and an average film thickness and a film thickness range were computed therefrom.

The resist film was exposed to EB using an EB writer system EBM-5000Plus (NuFlare Technology Inc., accelerating voltage 50 kV), then baked (PEB) at 120°C for 600 seconds, and developed in a 2.38 wt% TMAH aqueous solution, thereby yielding a positive pattern.

The resist pattern was evaluated as follows. The patterned mask blank was observed under a top-down scanning electron microscope (TDSEM). The optimum dose (Eop) was defined as the exposure dose (µC/cm²) which provided a 1:1 resolution at the top and bottom of a 200-nm 1:1 line-and-space (LS) pattern. The resolution (or maximum resolution) was defined as the minimum line width of a LS pattern that could be resolved at the optimum dose. The 200-nm LS pattern printed by exposure at the optimum dose (Eop) was observed under SEM. For each of the edges of 32 lines of the LS pattern, edge detection was carried out at 80 points, from which a 3-fold value (3σ) of the standard deviation (σ) or variation was determined and reported as LER (nm). A change of CD per µC relative to the exposure dose providing 1:1 resolution was determined from the dose curve. The results are shown in Tables 4 to 6.

**Table 4**

| | | Resist composition | Eop (µC/cm²) | Maximum resolution (nm) | LER (nm) | CD change (nm) |
|---|---|---|---|---|---|---|
| Example | 2-1 | R-1 | 220 | 40 | 4.7 | 0.2 |
| | 2-2 | R-2 | 210 | 40 | 4.6 | 0.2 |
| | 2-3 | R-3 | 210 | 40 | 4.4 | 0.2 |
| | 2-4 | R-4 | 210 | 40 | 4.3 | 0.2 |
| | 2-5 | R-5 | 210 | 40 | 4.4 | 0.2 |
| | 2-6 | R-6 | 210 | 40 | 4.4 | 0.2 |
| | 2-7 | R-7 | 210 | 40 | 4.5 | 0.2 |
| | 2-8 | R-8 | 210 | 40 | 4.3 | 0.2 |
| | 2-9 | R-9 | 220 | 40 | 4.3 | 0.2 |
| | 2-10 | R-10 | 220 | 40 | 4.5 | 0.2 |
| | 2-11 | R-11 | 220 | 40 | 4.4 | 0.2 |
| | 2-12 | R-12 | 220 | 40 | 4.5 | 0.2 |
| | 2-13 | R-13 | 220 | 40 | 4.6 | 0.2 |
| | 2-14 | R-14 | 220 | 40 | 4.7 | 0.2 |
| | 2-15 | R-15 | 220 | 40 | 4.5 | 0.2 |
| | 2-16 | R-16 | 220 | 40 | 4.4 | 0.2 |
| | 2-17 | R-17 | 220 | 40 | 4.5 | 0.2 |
| | 2-18 | R-18 | 220 | 45 | 4.6 | 0.2 |
| | 2-19 | R-19 | 220 | 45 | 4.7 | 0.2 |
| | 2-20 | R-20 | 310 | 40 | 4.3 | 0.2 |

**Table 5**

| | | Resist composition | Eop (µC/cm²) | Maximum resolution (nm) | LER (nm) | CD change (nm) |
|---|---|---|---|---|---|---|
| Example | 2-21 | R-21 | 220 | 40 | 4.4 | 0.2 |
| | 2-22 | R-22 | 230 | 40 | 4.5 | 0.2 |
| | 2-23 | R-23 | 240 | 40 | 4.6 | 0.2 |
| | 2-24 | R-24 | 230 | 40 | 4.5 | 0.2 |
| | 2-25 | R-25 | 230 | 40 | 4.4 | 0.2 |
| | 2-26 | R-26 | 220 | 40 | 4.5 | 0.2 |
| | 2-27 | R-27 | 220 | 40 | 4.4 | 0.2 |
| | 2-28 | R-28 | 220 | 40 | 4.6 | 0.2 |
| | 2-29 | R-29 | 200 | 40 | 4.6 | 0.2 |
| | 2-30 | R-30 | 200 | 40 | 4.7 | 0.2 |
| | 2-31 | R-31 | 180 | 40 | 4.5 | 0.2 |
| | 2-32 | R-32 | 210 | 40 | 4.5 | 0.2 |
| | 2-33 | R-33 | 230 | 40 | 4.7 | 0.2 |
| | 2-34 | R-34 | 220 | 40 | 4.6 | 0.2 |
| | 2-35 | R-35 | 230 | 40 | 4.5 | 0.2 |
| | 2-36 | R-36 | 220 | 40 | 4.5 | 0.2 |
| | 2-37 | R-37 | 220 | 40 | 4.4 | 0.2 |
| | 2-38 | R-38 | 220 | 40 | 4.5 | 0.2 |
| | 2-39 | R-39 | 140 | 40 | 4.7 | 0.3 |
| | 2-40 | R-40 | 59 | 40 | 4.8 | 0.3 |

**Table 6**

| | | Resist composition | Eop (µC/cm²) | Maximum resolution (nm) | LER (nm) | CD change (nm) |
|---|---|---|---|---|---|---|
| Comparative Example | 2-1 | CR-1 | 41 | 50 | 5.1 | 0.5 |
| | 2-2 | CR-2 | 190 | 60 | 5.7 | 0.7 |
| | 2-3 | CR-3 | 210 | 50 | 5.5 | 0.6 |
| | 2-4 | CR-4 | 210 | 50 | 5.4 | 0.6 |

All the chemically amplified positive resist compositions (R-1 to R-40) within the scope of the invention show satisfactory resolution and acceptable values of LER and dose margin because the sulfonium salt having formula (A1) exerts an acid diffusion-suppressing effect. A comparison of R-39 and R-40 with CR-1 reveals that better results are obtained when the optimum dose is 50 µC or more.

Because of a high quenching ability, the sulfonium salt having formula (A1) is effective for adjusting the resist sensitivity even when used in a small amount, highly compatible with the solvent, and uniformly dispersed in the resist film. These contribute to acceptable values of LER.

Using the positive resist composition within the scope of the invention, a resist pattern having a very high resolution, reduced LER and improved dose margin can be formed. The resist pattern forming process using the positive resist composition is useful in photolithography for the fabrication of semiconductor devices and the processing of photomask blanks of transmission or reflection type.

## Claims

1. A chemically amplified positive resist composition comprising (A) a quencher containing a sulfonium salt having the formula (A1) and (B) a base polymer containing a polymer which is decomposed under the action of acid to increase its solubility in alkaline developer, the polymer comprising repeat units having the formula (B1), 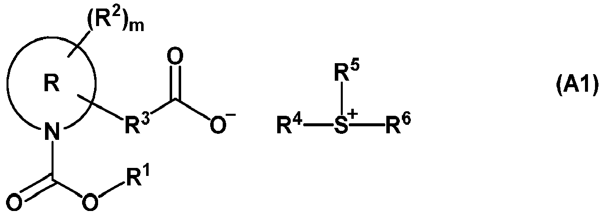 wherein m is an integer of 0 to 2,
the circle R is a C₂-C₁₂ saturated heterocycle including the nitrogen atom in the formula which may contain an ether bond, ester bond, thioether bond or sulfonyl moiety,
R¹ is an acid labile group,
R² is halogen or a C₁-C₆ saturated hydrocarbyl group which may contain halogen,
R³ is a single bond or a C₁-C₁₀ saturated hydrocarbylene group which may contain an ether bond, ester bond or thioether bond,
R⁴, R⁵ and R⁶ are each independently halogen or a C₁-C₂₀ hydrocarbyl group which may contain a heteroatom, R⁴ and R⁵ may bond together to form a ring with the sulfur atom to which they are attached, 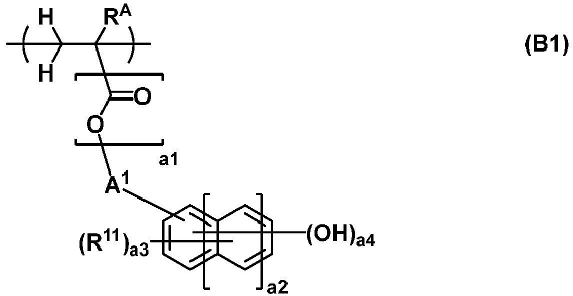 wherein a1 is 0 or 1, a2 is an integer of 0 to 2, a3 is an integer satisfying 0 ≤ a3 ≤ 5+2a2-a4, a4 is an integer of 1 to 3,
R^{A} is hydrogen, fluorine, methyl or trifluoromethyl,
R¹¹ is halogen, an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group, and
A¹ is a single bond or C₁-C₁₀ saturated hydrocarbylene group in which any constituent -CH₂- may be replaced by -O-.

2. The positive resist composition of claim 1 wherein the polymer further comprises repeat units having the formula (B2-1): 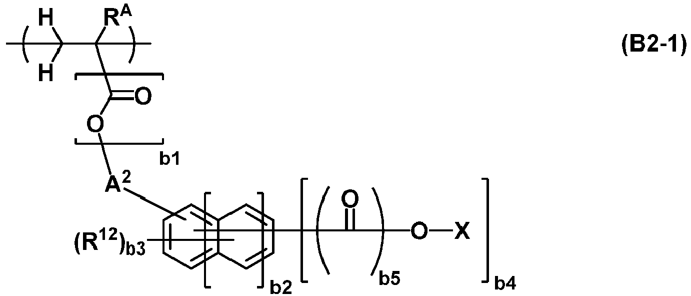 wherein R^{A} is hydrogen, fluorine, methyl or trifluoromethyl,
b1 is 0 or 1, b2 is an integer of 0 to 2, b3 is an integer satisfying 0 ≤ b3 ≤ 5+2b2-b4, b4 is an integer of 1 to 3, b5 is 0 or 1,
R¹² is halogen, an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group,
A² is a single bond or C₁-C₁₀ saturated hydrocarbylene group in which any constituent -CH₂- may be replaced by -O-,
X is an acid labile group when b4 is 1, and X is hydrogen or an acid labile group, at least one being an acid labile group, when b4 is 2 or 3.

3. The positive resist composition of claim 1 or 2 wherein the polymer further comprises repeat units having the formula (B2-2): 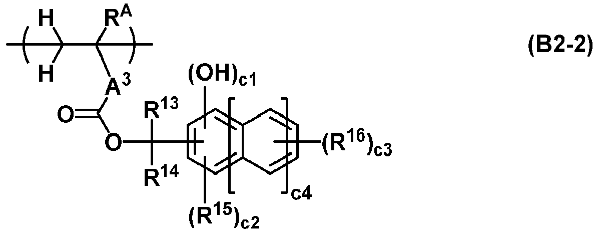 wherein c1 is an integer of 0 to 2, c2 is an integer of 0 to 2, c3 is an integer of 0 to 5, c4 is an integer of 0 to 2,
R^{A} is hydrogen, fluorine, methyl or trifluoromethyl,
A³ is a single bond, phenylene group, naphthylene group, or ^{∗}-C(=O)-O-A³¹-, A³¹ is a C₁-C₂₀ aliphatic hydrocarbylene group which may contain hydroxy, ether bond, ester bond or lactone ring, or phenylene or naphthylene group,
R¹³ and R¹⁴ are each independently a C₁-C₁₀ hydrocarbyl group which may contain a heteroatom, R¹³ and R¹⁴ may bond together to form a ring with the carbon atom to which they are attached,
R¹⁵ is each independently fluorine, C₁-C₅ fluorinated alkyl group or C₁-C₅ fluorinated alkoxy group, and
R¹⁶ is each independently a C₁-C₁₀ hydrocarbyl group which may contain a heteroatom.

4. The positive resist composition of any one of claims 1 to 3 wherein the polymer further comprises repeat units of at least one type selected from repeat units having the formula (B3), repeat units having the formula (B4), and repeat units having the formula (B5): 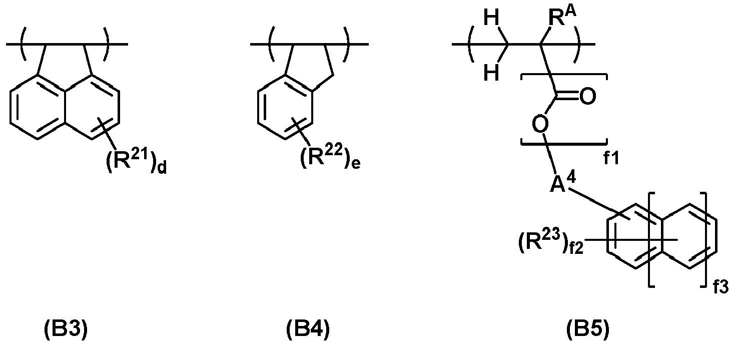 wherein d and e are each independently an integer of 0 to 4, f1 is 0 or 1, f2 is an integer of 0 to 5, and f3 is an integer of 0 to 2,
R^{A} is hydrogen, fluorine, methyl or trifluoromethyl,
R²¹ and R²² are each independently hydroxy, halogen, an optionally halogenated C₁-C₈ saturated hydrocarbyl group, optionally halogenated C₁-C₈ saturated hydrocarbyloxy group, or optionally halogenated C₂-C₈ saturated hydrocarbylcarbonyloxy group,
R²³ is a C₁-C₂₀ saturated hydrocarbyl group, C₁-C₂₀ saturated hydrocarbyloxy group, C₂-C₂₀ saturated hydrocarbylcarbonyloxy group, C₂-C₂₀ saturated hydrocarbyloxyhydrocarbyl group, C₂-C₂₀ saturated hydrocarbylthiohydrocarbyl group, halogen, nitro group, cyano group, sulfinyl group, or sulfonyl group, and
A⁴ is a single bond or C₁-C₁₀ saturated hydrocarbylene group in which any constituent -CH₂- may be replaced by -O-.

5. The positive resist composition of any one of claims 1 to 4 wherein the polymer further comprises repeat units of at least one type selected from repeat units having the formulae (B6) to (B13): 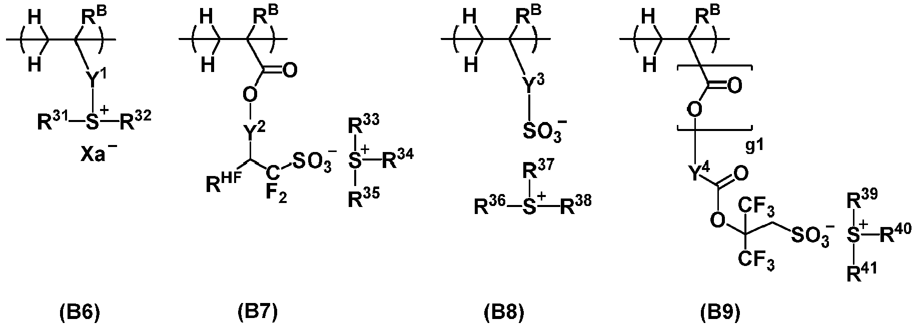 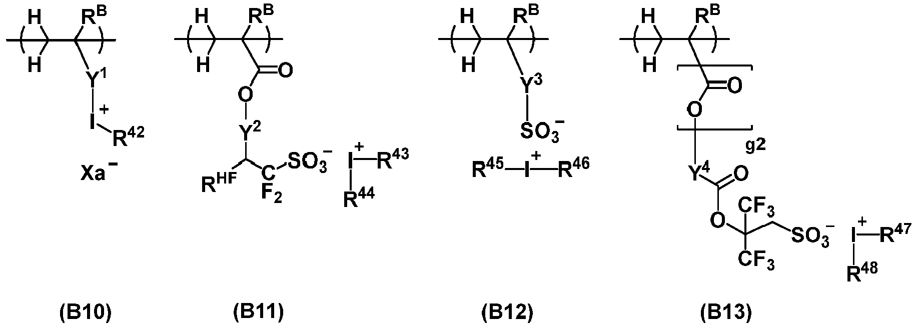 wherein R^{B} is each independently hydrogen or methyl,
Y¹ is a single bond, a C₁-C₆ aliphatic hydrocarbylene group, phenylene group, naphthylene group or C₇-C₁₈ group obtained by combining the
foregoing, -O-Y¹¹-, -C(=O)-O-Y¹¹-, or -C(=O)-NH-Y¹¹-, Y¹¹ is a C₁-C₆ aliphatic hydrocarbylene group, phenylene group, naphthylene group or C₇-C₁₈ group obtained by combining the foregoing, which may contain a carbonyl moiety, ester bond, ether bond or hydroxy moiety,
Y² is a single bond or -Y²¹-C(=O)-O-, Y²¹ is a C₁-C₂₀ hydrocarbylene group which may contain a heteroatom,
Y³ is a single bond, methylene, ethylene, phenylene, fluorinated phenylene, trifluoromethyl-substituted phenylene, -O-Y³¹-, -C(=O)-O-Y³¹-, or -C(=O)-NH-Y³¹-, Y³¹ is a C₁-C₆ aliphatic hydrocarbylene group, phenylene group, fluorinated phenylene group, trifluoromethyl-substituted phenylene group, or C₇-C₂₀ group obtained by combining the foregoing, which may contain a carbonyl moiety, ester bond, ether bond or hydroxy moiety,
Y⁴ is a single bond or C₁-C₃₀ hydrocarbylene group which may contain a heteroatom, g1 and g2 are each independently 0 or 1, g1 and g2 are 0 when Y⁴ is a single bond,
R³¹ to R⁴⁸ are each independently a C₁-C₂₀ hydrocarbyl group which may contain a heteroatom, R³¹ and R³² may bond together to form a ring with the sulfur atom to which they are attached, R³³ and R³⁴, R³⁶ and R³⁷, or R³⁹ and R⁴⁰ may bond together to form a ring with the sulfur atom to which they are attached,
R^{HF} is hydrogen or trifluoromethyl, and
Xa⁻ is a non-nucleophilic counter ion.

6. The positive resist composition of any one of claims 1 to 5 wherein repeat units having an aromatic ring structure account for at least 60 mol% of the overall repeat units of the polymer in the base polymer.

7. The positive resist composition of any one of claims 1 to 6, further comprising (C) a photoacid generator.

8. The positive resist composition of claim 7 wherein the photoacid generator has an anion having an acid strength (pKa) of -3.0 or larger.

9. The positive resist composition of claim 7 or 8 wherein the photoacid generator (C) and the quencher (A) are present in a weight ratio of less than 6/1.

10. The positive resist composition of any one of claims 1 to 9, further comprising (D) a fluorinated polymer comprising repeat units of at least one type selected from repeat units having the formula (D1), repeat units having the formula (D2), repeat units having the formula (D3) and repeat units having the formula (D5) and optionally repeat units of at least one type selected from repeat units having the formula (D5) and repeat units having the formula (D6): 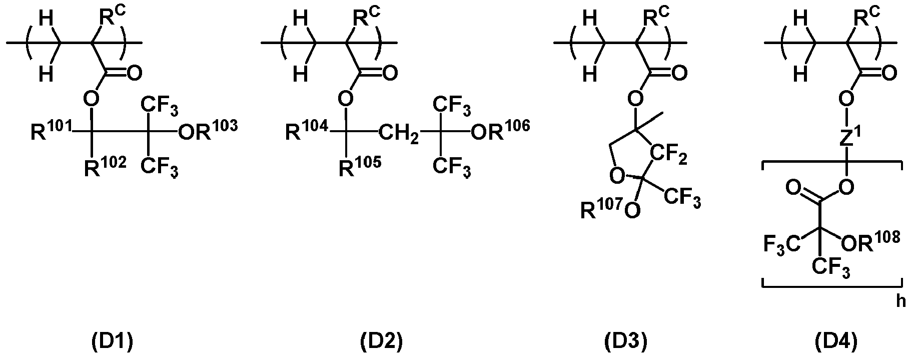 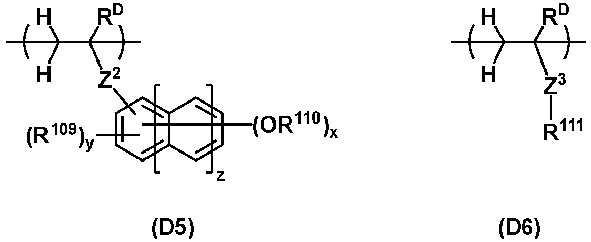 wherein R^{C} is each independently hydrogen, fluorine, methyl or trifluoromethyl,
R^{D} is each independently hydrogen or methyl,
R¹⁰¹, R¹⁰², R¹⁰⁴ and R¹⁰⁵ are each independently hydrogen or a C₁-C₁₀ saturated hydrocarbyl group,
R¹⁰³, R¹⁰⁶, R¹⁰⁷ and R¹⁰⁸ are each independently hydrogen, a C₁-C₁₅ hydrocarbyl group, C₁-C₁₅ fluorinated hydrocarbyl group, or acid labile group, and when R¹⁰³, R¹⁰⁶, R¹⁰⁷ and R¹⁰⁸ each are a hydrocarbyl or fluorinated hydrocarbyl group, an ether bond or carbonyl moiety may intervene in a carbon-carbon bond,
R¹⁰⁹ is hydrogen or a C₁-C₅ straight or branched hydrocarbyl group in which a heteroatom-containing moiety may intervene in a carbon-carbon bond,
R¹¹⁰ is a C₁-C₅ straight or branched hydrocarbyl group in which a heteroatom-containing moiety may intervene in a carbon-carbon bond,
R¹¹¹ is a C₁-C₂₀ saturated hydrocarbyl group in which at least one hydrogen is substituted by fluorine, and in which some constituent -CH₂- may be replaced by an ester bond or ether bond,
x is an integer of 1 to 3, y is an integer satisfying 0 ≤ y ≤ 5+2z-x, z is 0 or 1, h is an integer of 1 to 3,
Z¹ is a C₁-C₂₀ (h+1)-valent hydrocarbon group or C₁-C₂₀ (h+1)-valent fluorinated hydrocarbon group,
Z² is a single bond, *-C(=O)-O- or *-C(=O)-NH-, * designates a point of attachment to the carbon atom in the backbone,
Z³ is a single bond, -O-, ^{∗}-C(=O)=O-Z³¹-Z^{32_} or ^{∗}-C(=O)-NH-Z³¹-Z³²-, Z³¹ is a single bond or C₁-C₁₀ saturated hydrocarbylene group, Z³² is a single bond, ester bond, ether bond, or sulfonamide bond, and * designates a point of attachment to the carbon atom in the backbone.

11. The positive resist composition of any one of claims 1 to 10, further comprising (E) an organic solvent.

12. A resist pattern forming process comprising the steps of:
applying the chemically amplified positive resist composition of any one of claims 1 to 11 onto a substrate to form a resist film thereon,
exposing the resist film patternwise to high-energy radiation, and
developing the exposed resist film in an alkaline developer.

13. The process of claim 12 wherein the high-energy radiation is EUV or EB.

14. The process of claim 12 or 13 wherein the substrate has the outermost surface of a material containing at least one element selected from chromium, silicon, tantalum, molybdenum, cobalt, nickel, tungsten, and tin.

15. The process of any one of claims 12 to 14 wherein the substrate is a mask blank of transmission or reflection type.

16. A mask blank of transmission or reflection type which is coated with the chemically amplified positive resist composition of any one of claims 1 to 11.
